# EUROPEAN PATENT APPLICATION

(11) **EP 4 831 981 A1**
(43) Date of publication of application: **28.10.2026**
(21) Application number: 25214475.3
(22) Date of filing: 07.11.2025
(51) Int. Cl.: G09G 3/3266

(54) **DISPLAY PANEL AND DISPLAY DEVICE**

(30) Priority: 23.04.2025 CN 202510520743; 23.04.2025 CN 202510518017; 23.04.2025 CN 202510518041; 23.04.2025 CN 202510520819
(71) Applicant: Guangzhou China Star Optoelectronics Semiconductor Display Technology Co., Ltd., Guangzhou, Guangdong 510700 (CN)
(72) Inventor: LI, Shan, Guangzhou, 510700 (CN); HSU, Yuanjun, Guangzhou, 510700 (CN); CAO, Weiran, Guangzhou, 510700 (CN); ZHAO, Jun, Guangzhou, 510700 (CN); HE, Kai, Guangzhou, 510700 (CN); GE, Shimin, Guangzhou, 510700 (CN)
(74) Representative: Zhu, Puxing

(57) **Abstract**

Embodiments of the present application provide a display panel and a display device. By providing a first source and drain layer and a second source and drain layer, at least one of a first clock signal line, a second clock signal line, a third clock signal line, a first high potential signal line, a second high potential signal line, a first low potential signal line, a second low potential signal line, a third low potential signal line, a first reset control line, a second reset control line, and a low frequency signal line is provided in the second source and drain layer, thereby reducing a number of traces in the first source and drain layer, reducing a horizontal space occupied by the first source and drain layer, reducing a space occupied by a gate driving circuit, and narrowing a frame of the display panel.

## Description

### TECHNICAL FIELD

The present application relates to the field of display technologies, and in particular, to a display panel and a display device.

### BACKGROUND

Organic light-emitting diode (OLED) display devices are widely used in various fields because of their lightweight, wide viewing angle, low power consumption, fast response speed, low temperature resistance, high luminous efficiency, and the ability to prepare curved flexible display screens. In order to reduce a number of drive chips, narrow a frame, and lower the costs, gate driving circuits are adopted instead of the gate drive chips to drive pixel driving circuits. Specifically, the gate driving circuits include a thin film transistor region and a signal trace region. Thin film transistors are arranged in the thin film transistor region, and the signal traces are arranged in the signal trace region. The signal traces are connected to the thin film transistors through connection lines. However, during actual use, it is found that an occupied space of the gate driving circuits is relatively large. As the resolution of OLED display devices increases, the number of stages of the gate driving circuits also increases, leading to a reduction in a vertical space occupied by the gate driving circuits and an increase in a horizontal space occupied by the gate driving circuits, which results in a wider frame of the display panel.

Therefore, the current display device has a technical problem that a horizontal space occupied by a thin film transistor region and a signal trace region of the gate driving circuits is relatively large, resulting in a wider frame of the display device.

### SUMMARY

Embodiments of the present application provide a display panel and a display device, which are configured to solve the technical problem that a thin film transistor region and a signal trace region in a gate driving circuit of a current display device occupy a large horizontal space, resulting in a relatively wide frame of the display device.

In order to achieve the above object, according to a first aspect of the present application, a display panel is provided, and the display panel includes:
a plurality of rows of pixels, the pixels including light-emitting devices and pixel driving circuits; and
multistage gate driving circuits electrically connected to corresponding ones of the pixel driving circuits, respectively. Each stage of gate driving circuit includes a first type gate driving circuit, a second type gate driving circuit, and a third type gate driving circuit disposed along a first direction; the first type gate driving circuit is electrically connected to at least a first clock signal line, a second clock signal line, a first high potential signal line, a first low potential signal line, a second low potential signal line, a first reset control line, and a low frequency signal line; the second type gate driving circuit is electrically connected to at least the first high potential signal line, the second low potential signal line, a third clock signal line of the display panel, and a second reset control line of the display panel; the third type gate driving circuit is electrically connected to at least the first high potential signal line, a second high potential signal line, the second low potential signal line, and a third low potential signal line.

The display panel further includes a substrate, an active layer, a first gate layer, a first source and drain layer, and a second source and drain layer arranged sequentially; and at least one of the first clock signal line, the second clock signal line, the third clock signal line, the first high potential signal line, the second high potential signal line, the first low potential signal line, the second low potential signal line, the third low potential signal line, the first reset control line, the second reset control line, and the low frequency signal line is arranged in the second source and drain layer.

According to a second aspect of the present application, a display device is provided. The display device includes the display panel as described in any of the above embodiments.

Embodiments of the present application provide a display panel and a display device. By providing a first source and drain layer and a second source and drain layer, at least one of a first clock signal line, a second clock signal line, a third clock signal line, a first high potential signal line, a second high potential signal line, a first low potential signal line, a second low potential signal line, a third low potential signal line, a first reset control line, a second reset control line, and a low frequency signal line is arranged in the second source and drain layer, thereby reducing a number of traces in the first source and drain layer, reducing a horizontal space occupied by the first source and drain layer, reducing a space occupied by a gate driving circuit, and narrowing a frame of the display panel.

### BRIEF DESCRIPTION OF THE DRAWINGS

FIG. 1 is a schematic diagram of a comparative display device.
FIG. 2 is a schematic plan view of a display panel provided by embodiments of the present application.
FIG. 3 is a schematic cross-sectional view of a display panel provided by embodiments of the present application.
FIG. 4 is a circuit diagram of a pixel driving circuit provided by embodiments of the present application.
FIG. 5 is a circuit diagram of a first type gate driving circuit provided by embodiments of the present application.
FIG. 6 is a circuit diagram of a second type gate driving circuit provided by embodiments of the present application.
FIG. 7 is a circuit diagram of a third type gate driving circuit provided by embodiments of the present application.
FIG. 8 is a stacked diagram of a light-shielding layer, an active layer, a first gate layer, a first source and drain layer, and a second source and drain layer of a display panel provided by embodiments of the present application.
FIG. 9 is a decomposition diagram of the light-shielding layer of the display panel in FIG. 8.
FIG. 10 is a decomposition diagram of the active layer of the display panel in FIG. 8.
FIG. 11 is a decomposition diagram of the first gate layer of the display panel in FIG. 8.
FIG. 12 is a decomposition diagram of the first source and drain layer of the display panel in FIG. 8.
FIG. 13 is a decomposition diagram of the second source and drain layer of the display panel in FIG. 8.
FIG. 14 is a stacked diagram of the light-shielding layer and the active layer of the display panel in FIG. 8.
FIG. 15 is a stacked diagram of the light-shielding layer, the active layer, and the first gate layer of the display panel in FIG. 8.
FIG. 16 is a stacked diagram of the light-shielding layer, the active layer, the first gate layer, and the first source and drain layer of the display panel in FIG. 8.
FIG. 17 is a stacked diagram of the light-shielding layer and a first via hole of the display panel in FIG. 8.
FIG. 18 is a stacked diagram of the light-shielding layer and the first source and drain layer in FIG. 8.
FIG. 19 is a stacked diagram of the first gate layer and a second via hole in FIG. 8.
FIG. 20 is a stacked diagram of a first gate layer and the first source and drain layer in FIG. 8.
FIG. 21 is a stacked diagram of the first source and drain layer and a third via hole in FIG. 8.
FIG. 22 is a stacked diagram of the first source and drain layer, a third via hole, and a fourth via hole in FIG. 8.
FIG. 23 is a stacked diagram of the first source and drain layer and the second source and drain layer in FIG. 8.
FIG. 24 is a local enlarged view of a region corresponding to a first type gate driving circuit of the display panel in FIG. 8.
FIG. 25 is a decomposition diagram of the light-shielding layer of the display panel in FIG. 24.
FIG. 26 is a decomposition diagram of the active layer of the display panel in FIG. 24.
FIG. 27 is a decomposition diagram of the first gate layer of the display panel in FIG. 24.
FIG. 28 is a decomposition diagram of the first source and drain layer of the display panel in FIG. 24.
FIG. 29 is a decomposition diagram of the second source and drain layer of the display panel in FIG. 24.
FIG. 30 is a local enlarged view of a region corresponding to a second type gate driving circuit of the display panel in FIG. 8.
FIG. 31 is a decomposition diagram of the light-shielding layer of the display panel in FIG. 30.
FIG. 32 is a decomposition diagram of the active layer of the display panel in FIG. 30.
FIG. 33 is a decomposition diagram of the first gate layer of the display panel in FIG. 30.
FIG. 34 is a decomposition diagram of the first source and drain layer of the display panel in FIG. 30.
FIG. 35 is a decomposition diagram of the second source and drain layer of the display panel in FIG. 30.
FIG. 36 is a local enlarged view of a region corresponding to a third type gate driving circuit of the display panel in FIG. 8.
FIG. 37 is a decomposition diagram of the light-shielding layer of the display panel in FIG. 36.
FIG. 38 is a decomposition diagram of the active layer of the display panel in FIG. 36.
FIG. 39 is a decomposition diagram of the first gate layer of the display panel in FIG. 36.
FIG. 40 is a decomposition diagram of the first source and drain layer of the display panel in FIG. 36.
FIG. 41 is a decomposition diagram of the second source and drain layer of the display panel in FIG. 36.

### DETAILED DESCRIPTION

The technical proposals in the embodiments of the present application will be clearly and completely described with reference to the accompanying drawings in the embodiments of the present application. Apparently, the described embodiments are merely some embodiments of the present application instead of all embodiments. According to the embodiments in the present application, all other embodiments obtained by those skilled in the art without making any creative effort shall fall within the protection scope of the present application.

In the description of the present application, it is to be noted that, unless expressly stated and defined otherwise, the terms "install", "communicate", "connect", and "electrically connect" are to be understood in a broad sense, for example, as a fixed connection, as a detachable connection, as an integrated connection, as an mechanical connection, as an electrical connection, as an communication with each other, as an direct connection, as an indirect connection by means of an intermediate medium, as an internal communication of two elements, or as an interaction of two elements. The specific meaning of the above terms in the present application may be understood by one of ordinary skill in the art depending on the specific circumstances.

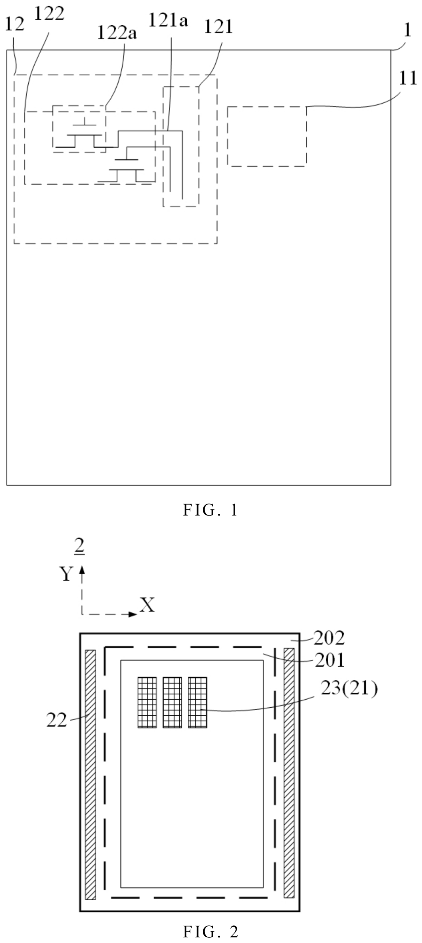

In order to explain the principle of generating the technical problems of the embodiments of the present application, some comparative display devices are provided, and it is understood that these comparative display devices cannot be regarded as prior arts in the embodiments of the present application. As shown in FIG. 1, a comparative display device 1 includes a pixel driving circuit 11 and a gate driving circuit 12. The gate driving circuit 12 is configured with a trace region 121 and a transistor region 122, respectively. Signal traces 121a are arranged in the trace region 121, thin film transistors 122a are arranged in the transistor region 122, and the signal traces 121a extend from the trace region 121 to the transistor region 122 and are connected to corresponding transistors 122a, thereby realizing normal operation of the gate driving circuit 12. However, since the signal traces 121a are arranged in the same layer with sources and drains of the transistors, in order to avoid a short circuit between unconnected signal traces and the sources and the drains of the transistors, the signal traces need to be arranged at an interval from the sources and the drains of the transistors, resulting in the separate arrangement of the trace region 121 and the transistor region 122. The trace region 121 needs to occupy a relatively large space, and when the signal traces 121a extend into the transistor region 122, each transistor needs to occupy more space in order to avoid the unconnected signal traces 121a, resulting in a relatively large space occupied by the gate driving circuit 12. Therefore, the current display device has a technical problem that a horizontal space occupied by a thin film transistor region and a signal trace region of the gate driving circuits is relatively large, resulting in a wider frame of the display device.

Embodiments of the present application provide a display panel and a display device, which are configured to alleviate the above technical problems.

In the embodiment of the present application, based on the problem that the trace region and the transistor region need to be separately arranged in the display device, resulting in the relatively large space occupied by both the trace region and the transistor region, setting positions of signal lines, setting film layers of the signal lines, layout modes of the signal lines, and the like, and/or setting positions of transistors, layout modes of the transistors, structure designs of the transistors, and the like are adjusted to reduce the occupied space of the gate driving circuits 22 and narrow the frame of the display panel 2.

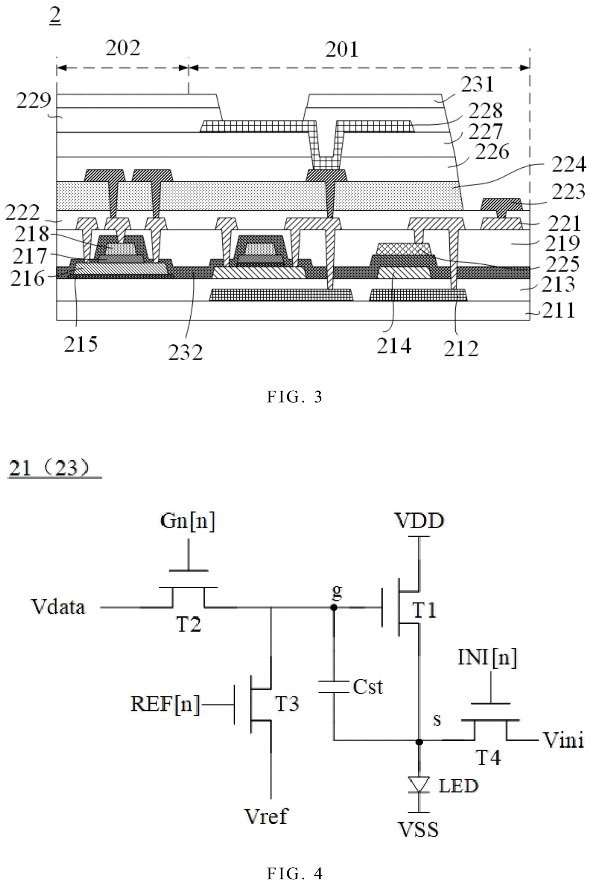

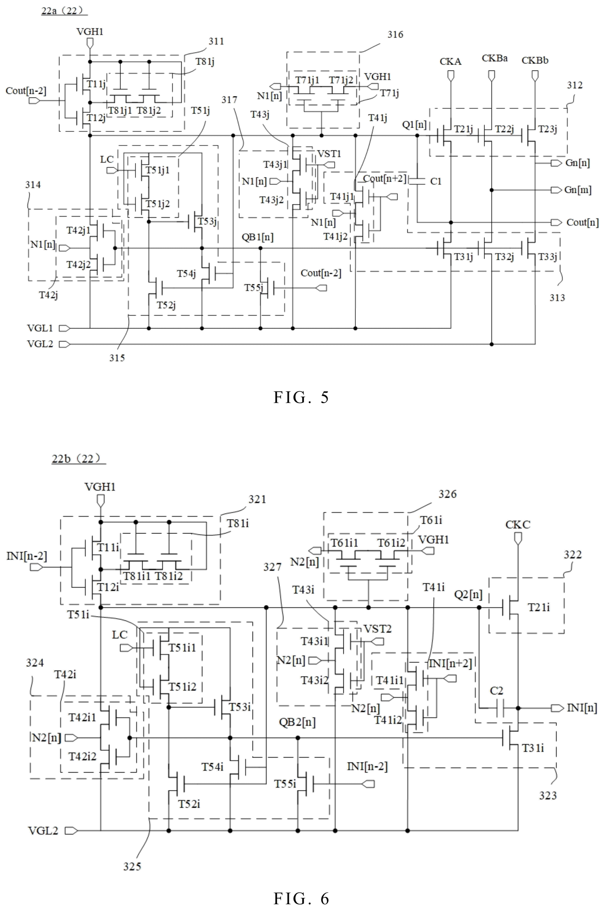

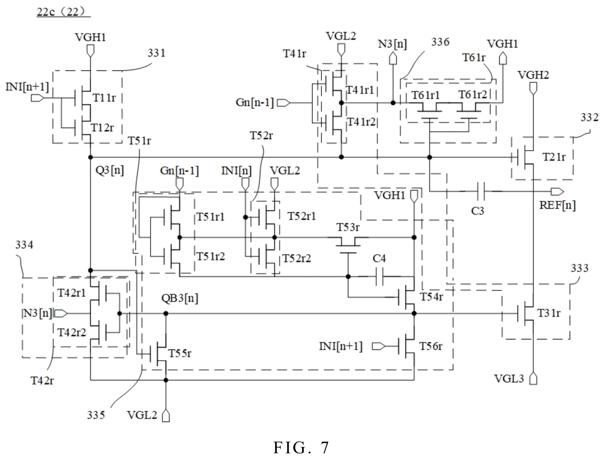

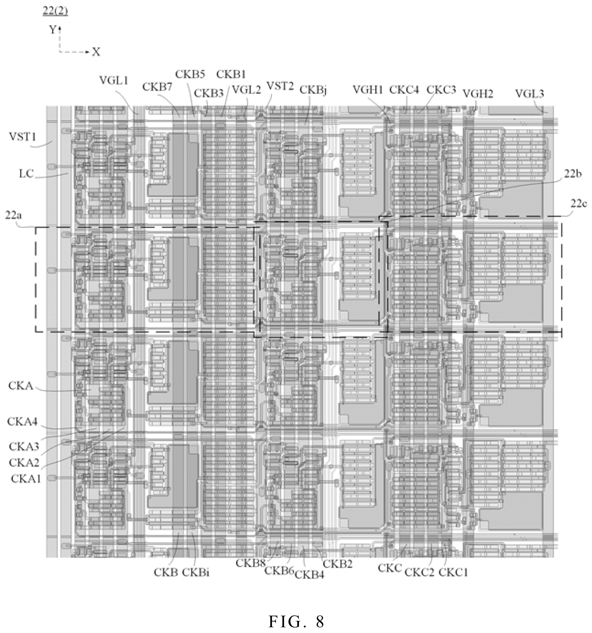

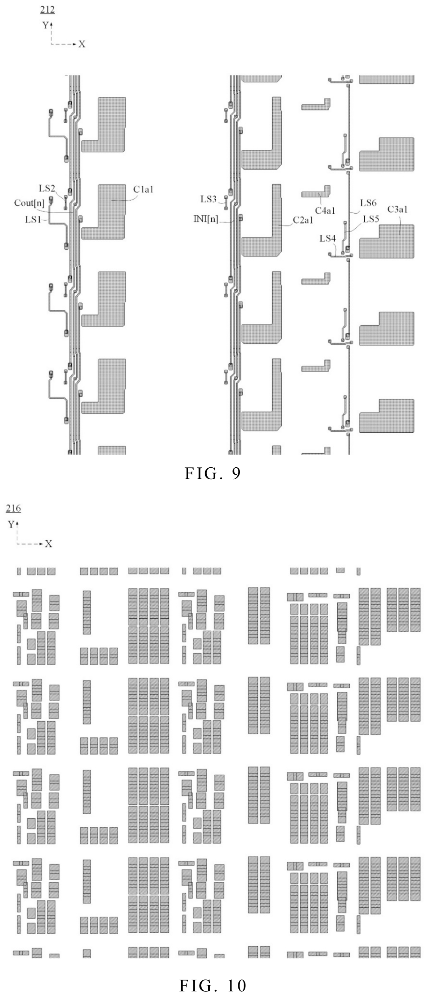

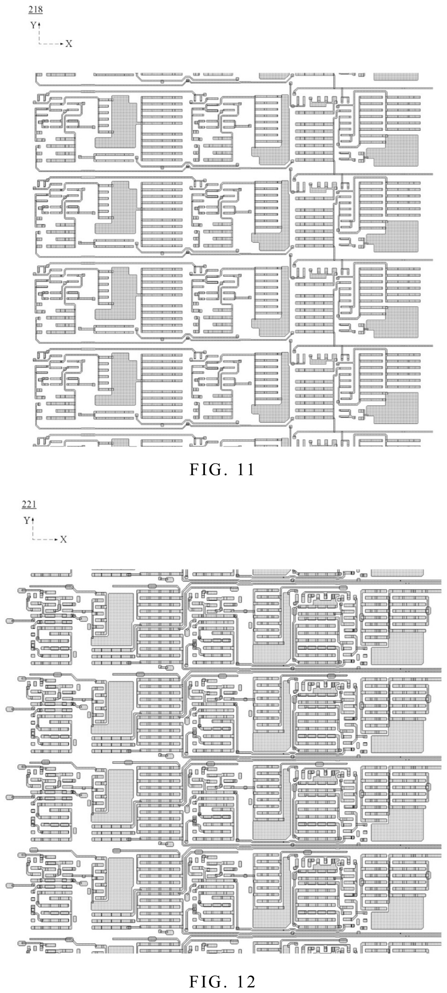

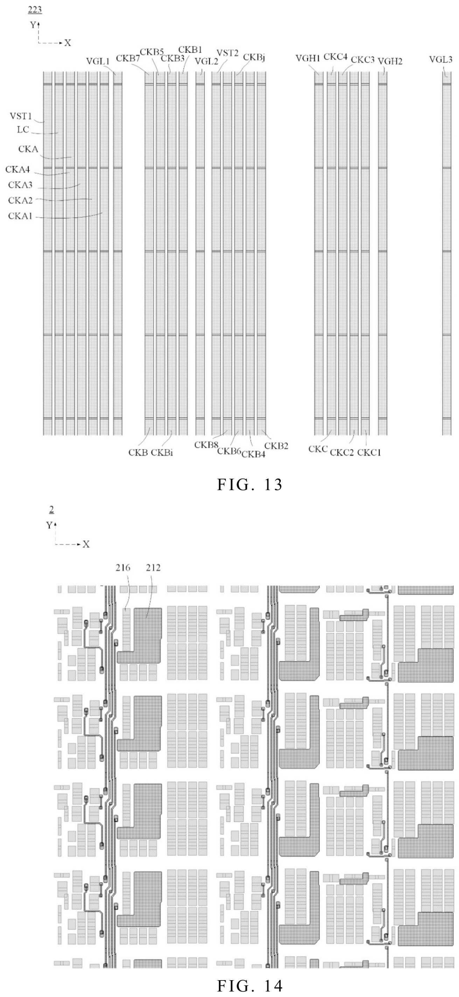

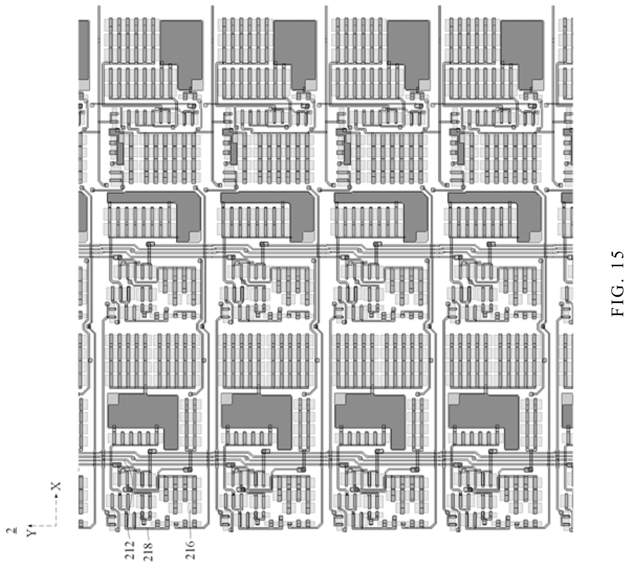

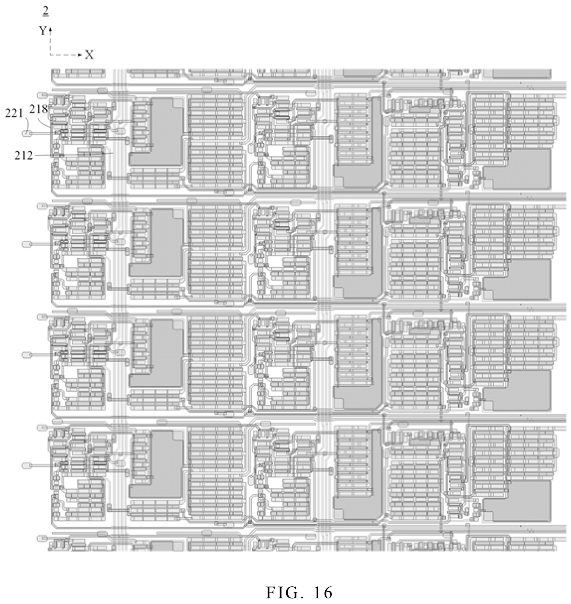

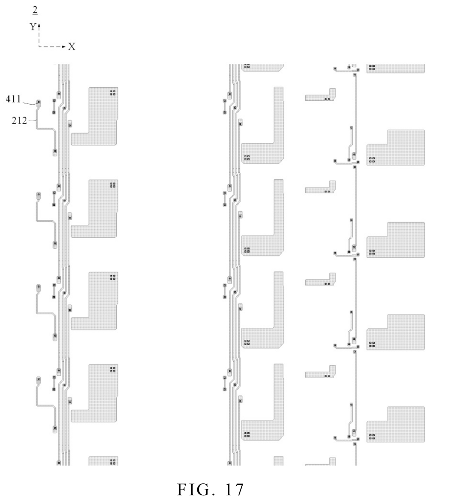

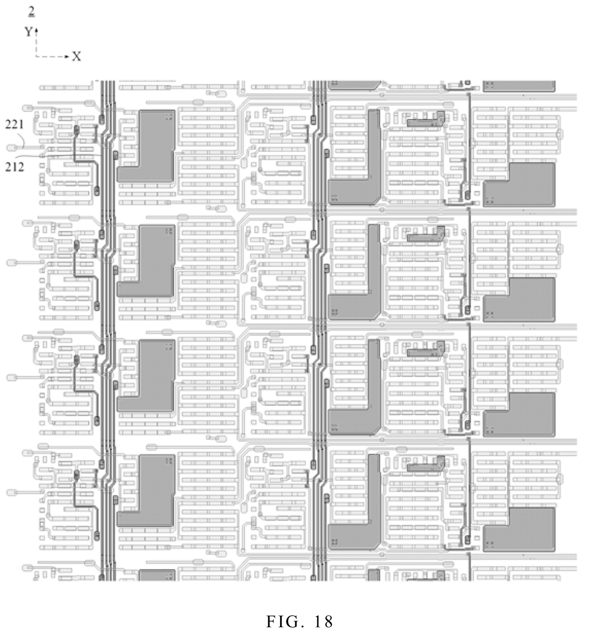

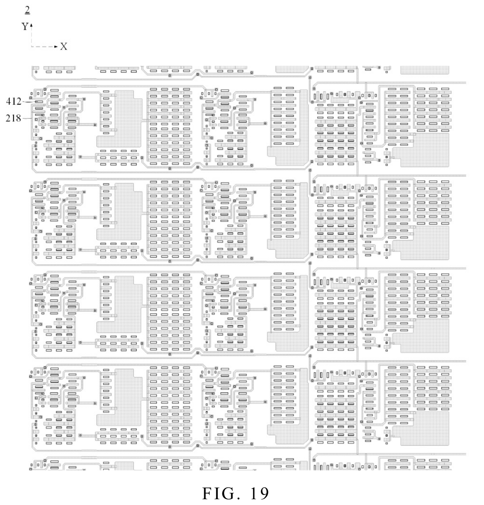

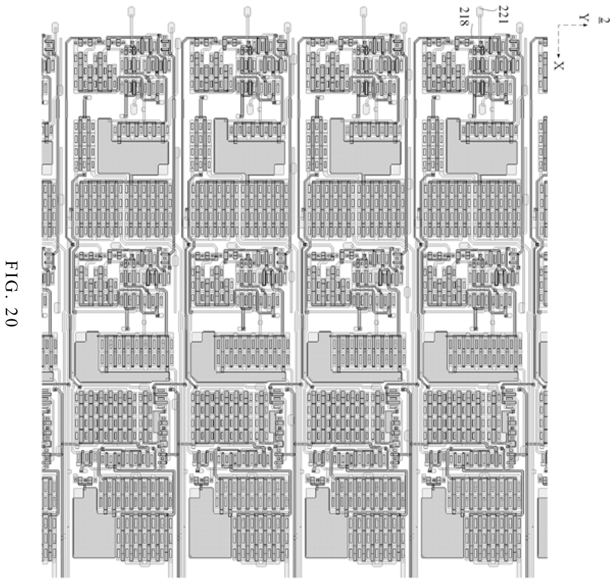

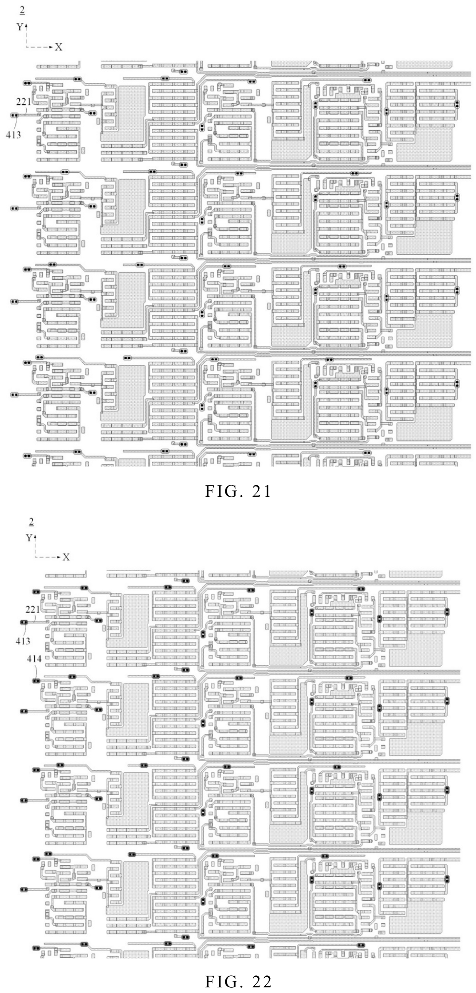

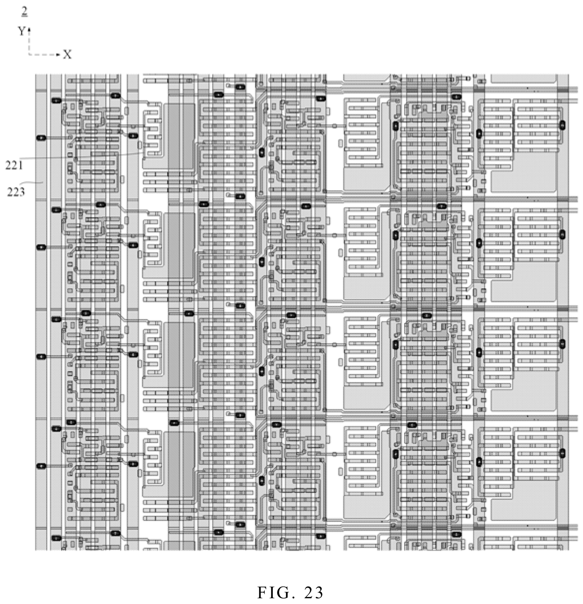

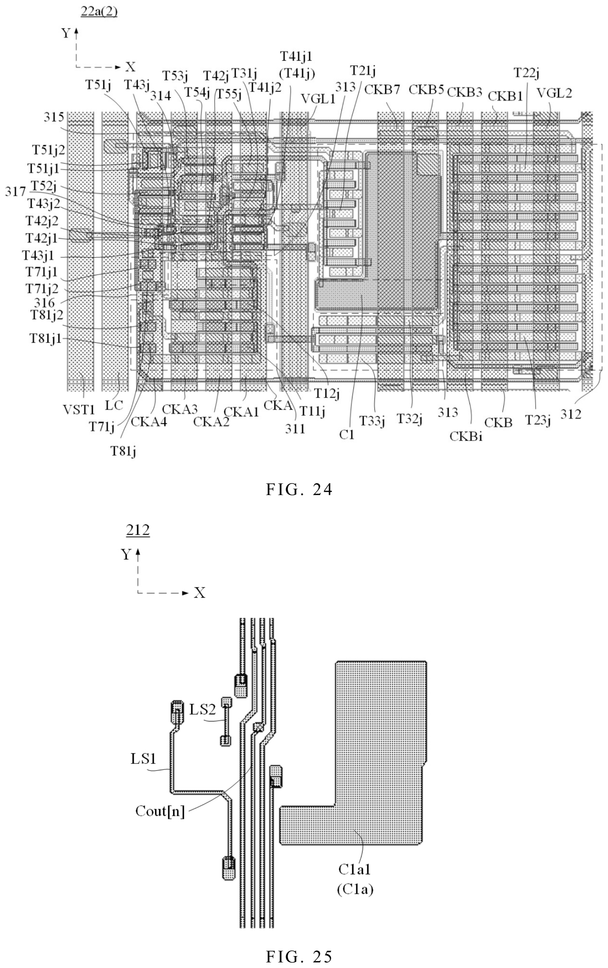

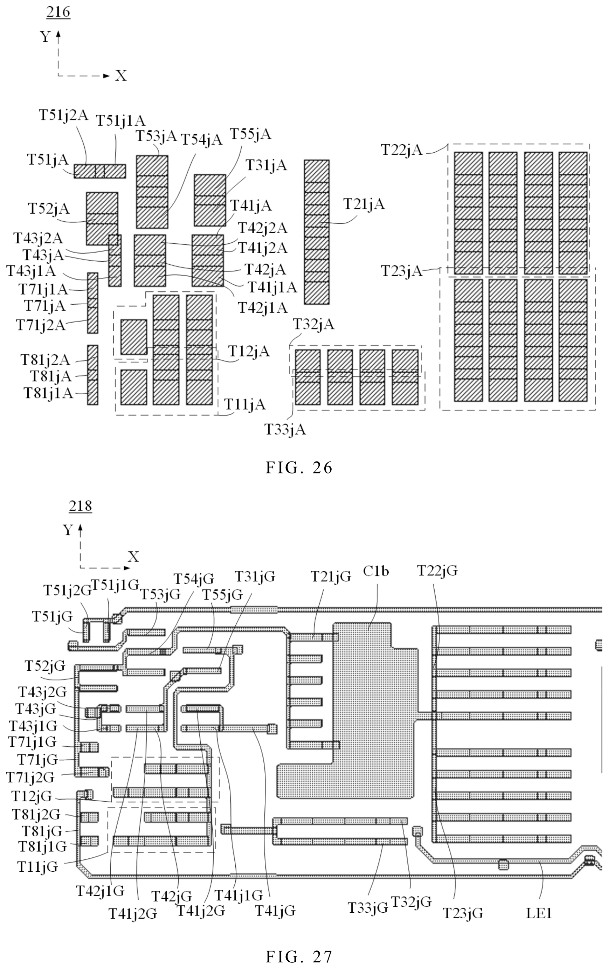

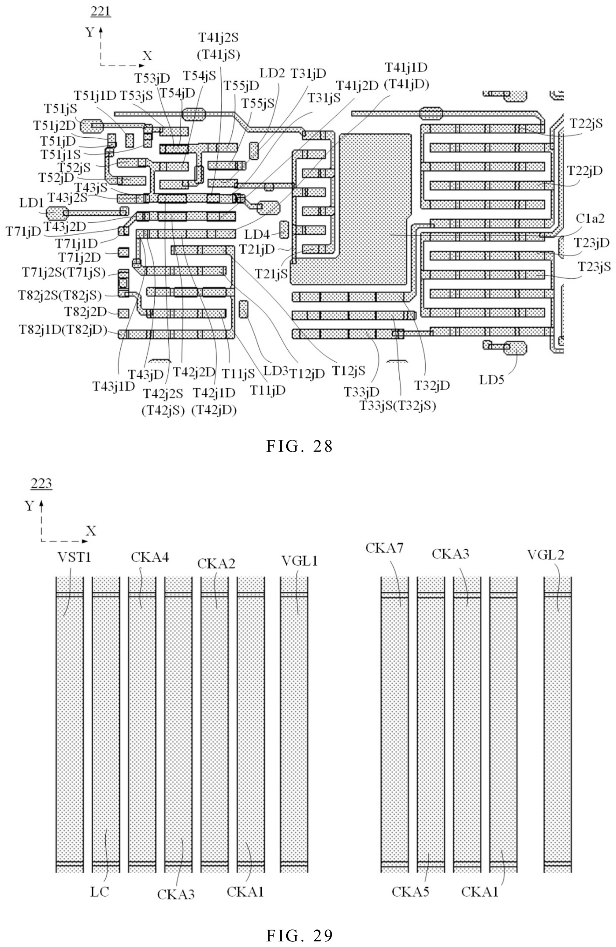

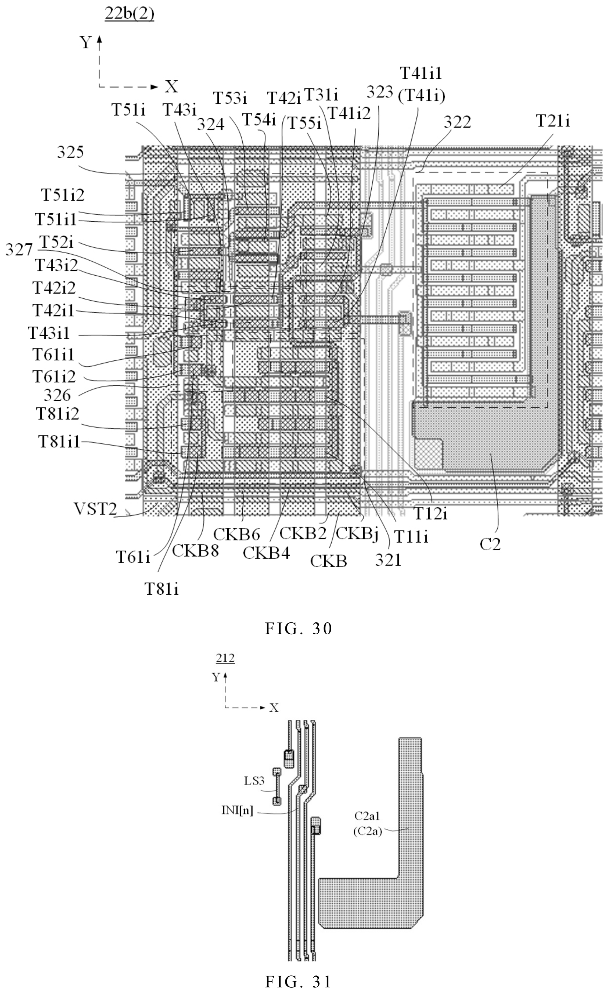

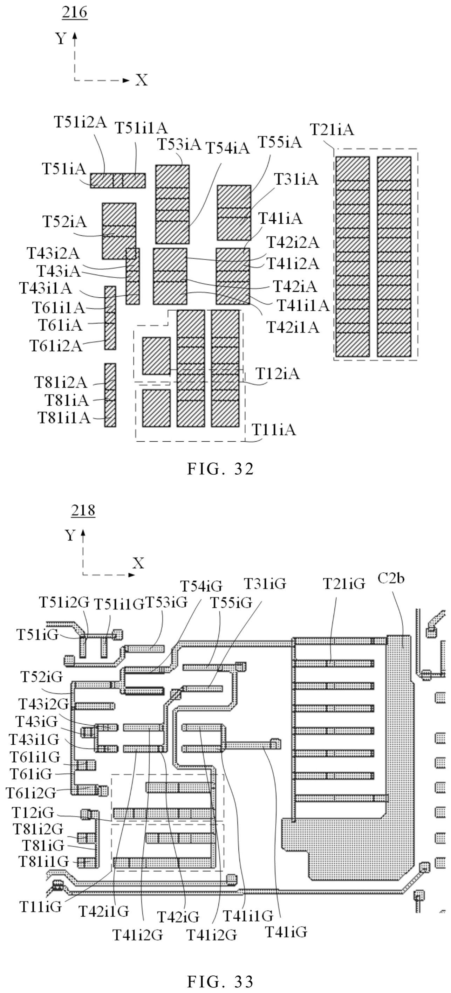

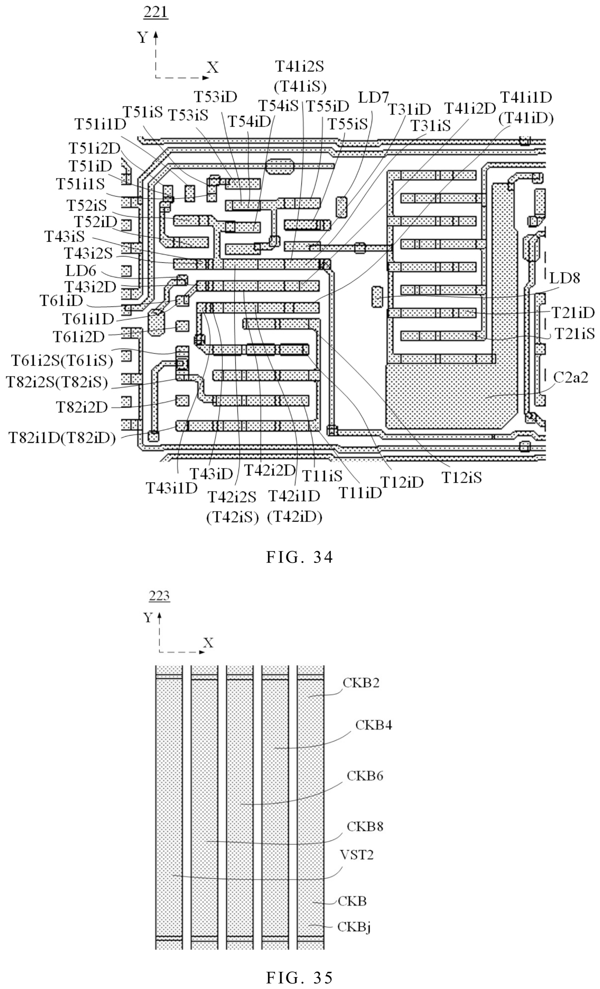

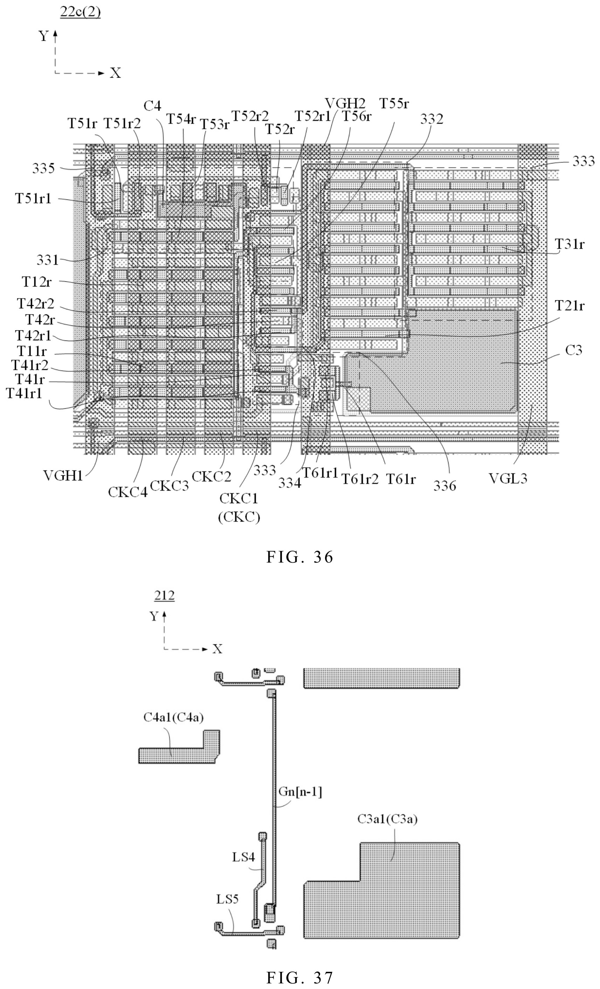

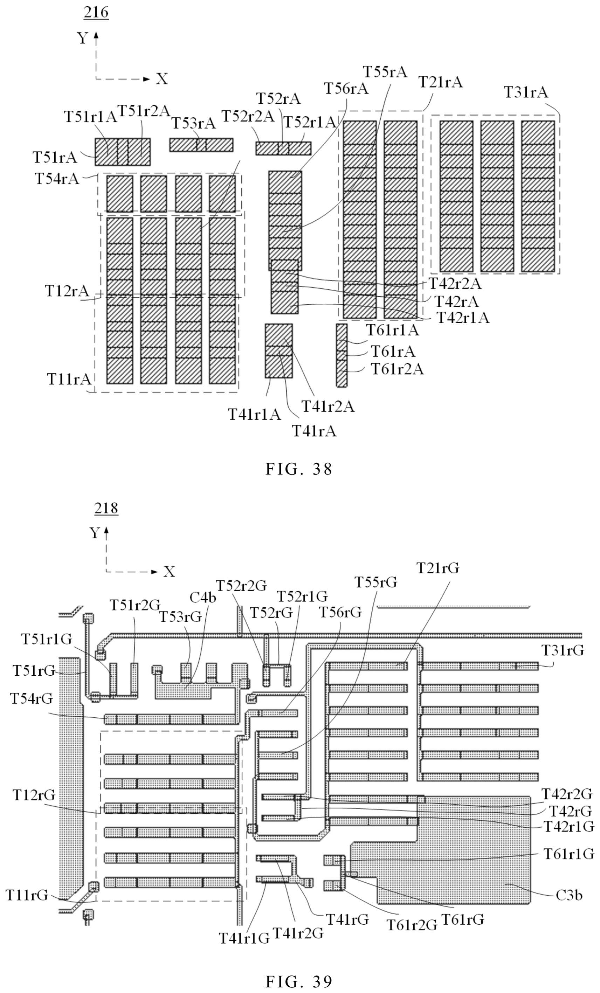

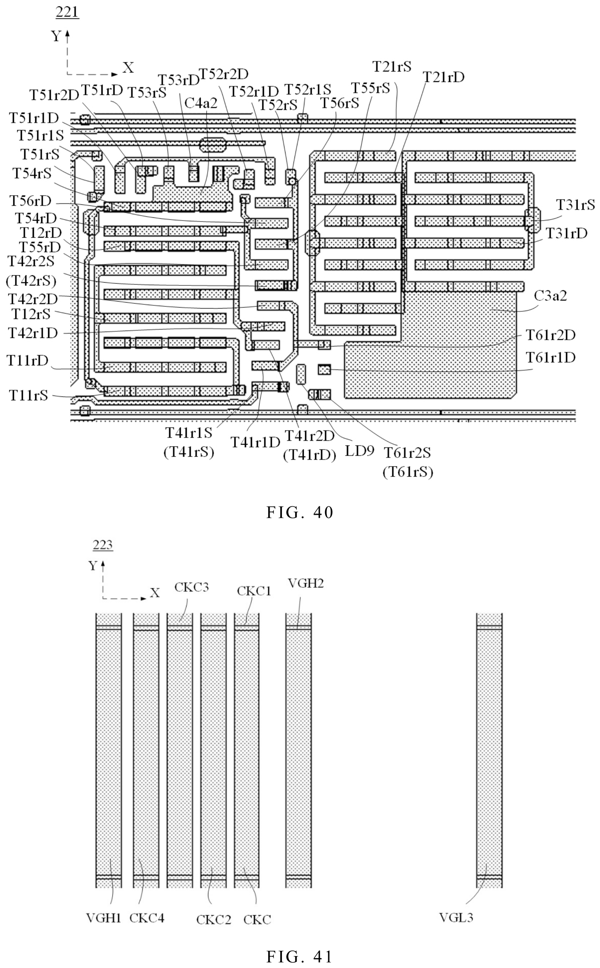

FIG. 1 is a schematic diagram of a comparative display device. FIG. 2 is a schematic plan view of a display panel provided by embodiments of the present application. FIG. 3 is a schematic cross-sectional view of a display panel provided by embodiments of the present application. FIG. 4 is a circuit diagram of a pixel driving circuit provided by embodiments of the present application. FIG. 5 is a circuit diagram of a first type gate driving circuit provided by embodiments of the present application. FIG. 6 is a circuit diagram of a second type gate driving circuit provided by embodiments of the present application. FIG. 7 is a circuit diagram of a third type gate driving circuit provided by embodiments of the present application. FIG. 8 is a stacked diagram of a light-shielding layer, an active layer, a first gate layer, a first source and drain layer, and a second source and drain layer of a display panel provided by embodiments of the present application. FIG. 9 is a decomposition diagram of the light-shielding layer of the display panel in FIG. 8. FIG. 10 is a decomposition diagram of the active layer of the display panel in FIG. 8. FIG. 11 is a decomposition diagram of the first gate layer of the display panel in FIG. 8. FIG. 12 is a decomposition diagram of the first source and drain layer of the display panel in FIG. 8. FIG. 13 is a decomposition diagram of the second source and drain layer of the display panel in FIG. 8. FIG. 14 is a stacked diagram of the light-shielding layer and the active layer of the display panel in FIG. 8. FIG. 15 is a stacked diagram of the light-shielding layer, the active layer, and the first gate layer of the display panel in FIG. 8. FIG. 16 is a stacked diagram of the light-shielding layer, the active layer, the first gate layer, and the first source and drain layer of the display panel in FIG. 8. FIG. 17 is a stacked diagram of the light-shielding layer and a first via hole of the display panel in FIG. 8. FIG. 18 is a stacked diagram of the light-shielding layer and the first source and drain layer in FIG. 8. FIG. 19 is a stacked diagram of the first gate layer and a second via hole in FIG. 8. FIG. 20 is a stacked diagram of a first gate layer and the first source and drain layer in FIG. 8. FIG. 21 is a stacked diagram of the first source and drain layer and a third via hole in FIG. 8. FIG. 22 is a stacked diagram of the first source and drain layer, a third via hole, and a fourth via hole in FIG. 8. FIG. 23 is a stacked diagram of the first source and drain layer and the second source and drain layer in FIG. 8. FIG. 24 is a local enlarged view of a region corresponding to a first type gate driving circuit of the display panel in FIG. 8. FIG. 25 is a decomposition diagram of the light-shielding layer of the display panel in FIG. 24. FIG. 26 is a decomposition diagram of the active layer of the display panel in FIG. 24. FIG. 27 is a decomposition diagram of the first gate layer of the display panel in FIG. 24. FIG. 28 is a decomposition diagram of the first source and drain layer of the display panel in FIG. 24. FIG. 29 is a decomposition diagram of the second source and drain layer of the display panel in FIG. 24. FIG. 30 is a local enlarged view of a region corresponding to a second type gate driving circuit of the display panel in FIG. 8. FIG. 31 is a decomposition diagram of the light-shielding layer of the display panel in FIG. 30. FIG. 32 is a decomposition diagram of the active layer of the display panel in FIG. 30. FIG. 33 is a decomposition diagram of the first gate layer of the display panel in FIG. 30. FIG. 34 is a decomposition diagram of the first source and drain layer of the display panel in FIG. 30. FIG. 35 is a decomposition diagram of the second source and drain layer of the display panel in FIG. 30. FIG. 36 is a local enlarged view of a region corresponding to a third type gate driving circuit of the display panel in FIG. 8. FIG. 37 is a decomposition diagram of the light-shielding layer of the display panel in FIG. 36. FIG. 38 is a decomposition diagram of the active layer of the display panel in FIG. 36. FIG. 39 is a decomposition diagram of the first gate layer of the display panel in FIG. 36. FIG. 40 is a decomposition diagram of the first source and drain layer of the display panel in FIG. 36. FIG. 41 is a decomposition diagram of the second source and drain layer of the display panel in FIG. 36.

As shown in FIG. 2, embodiments of the present application provide a display panel 2. The display panel 2 includes a display area 201 and a non-display area 202. A plurality of pixels 23 are provided in the display area 201. Each of the pixels 23 includes a light-emitting device LED and a pixel driving circuit 21 configured to drive the light-emitting device LED. Multistage gate driving circuits 22 are provided in the non-display area 202, the multistage gate driving circuits 22 may be arranged in a second direction Y, and the gate driving circuits 22 output scanning signals to the pixel driving circuits 21.

Specifically, as shown in FIG. 2, the non-display area 202 may be provided around the display area 201, but the embodiments of the present application are not limited thereto, and the non-display area 202 may be provided on one side, both sides, or three sides of the display area 201, and the non-display area 202 may be bent to a back of the display area 201. The non-display area 202 may include an upper frame area, a lower frame area, a left frame area, and a right frame area. The gate driving circuit 22 may be arranged in the left frame area and/or the right frame area, and the gate driving circuits 22 may be arranged on one side of the display area 201 or on both sides of the display area 201 in a first direction X.

As shown in FIG. 3, as a specific structure of a display panel 2 in the embodiments of the present application, the display panel 2 includes a substrate 211, a light-shielding layer 212, a buffer layer 213, a semiconductor layer 214, a first gate insulating layer 215, an active layer 216, a second gate insulating layer 217, a first gate layer 218, a third gate insulating layer 232, a second gate layer 225, a first interlayer insulating layer 219, a first source and drain layer 221, a passivation layer 222, a first planarization layer 224, a second source and drain layer 223, a second planarization layer 226, a third planarization layer 227, a pixel electrode layer 228, a first pixel definition layer 229, a second pixel definition layer 231, a light-emitting functional layer, and a common electrode layer.

Specifically, a material of the semiconductor layer 214 includes an oxide semiconductor, specifically a metal oxide, and more specifically an indium gallium zinc oxide.

Specifically, a material of the active layer 216 may include one of a silicon semiconductor and an oxide semiconductor, specifically, low-temperature polysilicon or a metal oxide, and specifically, Ln-IZO (indium zinc oxide doped with lanthanide elements) or IGZTO (indium gallium zinc tin oxide).

Specifically, as shown in FIG. 3, FIG. 3 shows that the display panel 2 includes the semiconductor layer 214 and the active layer 216, but the embodiments of the present application are not limited thereto, and the display panel 2 may include only one of the semiconductor layer 214 and the active layer 216.

Specifically, as shown in FIG. 3, FIG. 3 shows that the display panel includes two gate layers, but the embodiments of the present application are not limited thereto, and the display panel may include one gate layer or three gate layers.

Specifically, as shown in FIG. 3, FIG. 3 shows that the display panel 2 includes the first source and drain layer 221 and the second source and drain layer 223, but the embodiments of the present application are not limited thereto, and the display panel 2 may include the first source and drain layer 221, the second source and drain layer 223, and a third source and drain layer.

Specifically, as shown in FIG. 3, FIG. 3 shows that the light-shielding layer 212 is arranged only in the display area 201, but the embodiments of the present application are not limited thereto, and the light-shielding layer 212 may be arranged in the non-display area 202.

Specifically, as shown in FIG. 3, FIG. 3 shows that all transistors in the display area 201 use the semiconductor layer 214 as active portions, and all transistors in the non-display area 202 use the active layer 216 as active portions, but the embodiments of the present application are not limited thereto, and some transistors in the display area 201 may use the semiconductor layer 214 as the active portions, while other transistors in the display area 201 may use the active layer 216 as the active portions; similarly, some transistors in the non-display area 202 may use the semiconductor layer 214 as the active portions, while other transistors in the non-display area 202 may use the active layer 216 as the active portions.

Specifically, as shown in FIG. 3, FIG. 3 is illustrated by taking that the display panel 2 is an organic light-emitting diode display panel 2 as an example, but the embodiments of the present application are not limited thereto, and the display panel 2 may be a liquid crystal display panel 2 or another type of display panel 2.

Specifically, as shown in FIG. 5 to FIG. 7, each stage of gate driving circuit 22 includes a first type gate driving circuit 22a, a second type gate driving circuit 22b, and a third type gate driving circuit 22c.

As shown in FIG. 2 to FIG. 41, embodiments of the present application provide a display panel 2. The display panel 2 includes a plurality of rows of pixels 23 and multistage gate driving circuits 22. The pixel 23 includes a light-emitting device LED and a pixel driving circuit 21. The multistage gate driving circuits 22 are electrically connected to the corresponding pixel driving circuits 21, respectively. Each stage of gate driving circuit 22 includes a first type gate driving circuit 22a, a second type gate driving circuit 22b, and a third type gate driving circuit 22c arranged in the first direction X. The first type gate driving circuit 22a is electrically connected to at least a first clock signal line CKA, a second clock signal line CKB, a first high potential signal line VGH1, a first low potential signal line VGL1, a second low potential signal line VGL2, a first reset control line VST1, and a low frequency signal line LC. The second type gate driving circuit 22b is electrically connected to at least the first high potential signal line VGH1, the second low potential signal line VGL2, a third clock signal line CKC of the display panel, and a second reset control line VST2 of the display panel. The third type gate driving circuit 22c is electrically connected to at least the first high potential signal line VGH1, a second high potential signal line VGH2, the second low potential signal line VGL2, and a third low potential signal line VGL3.

The display panel 2 further includes a substrate 211, an active layer 216, a first gate layer 218, a first source and drain layer 221, and a second source and drain layer 223 arranged sequentially. At least one of the first clock signal line CKA, the second clock signal line CKB, the third clock signal line CKC, the first high potential signal line VGH1, the second high potential signal line VGH2, the first low potential signal line VGL1, the second low potential signal line VGL2, the third low potential signal line VGL3, the first reset control line VST1, the second reset control line VST2, and the low frequency signal line LC is arranged in the second source and drain layer 223.

Embodiments of the present application provides the display panel 2. In the display panel 2, at least one of the first clock signal line CKA, the second clock signal line CKB, the third clock signal line CKC, the first high potential signal line VGH1, the second high potential signal line VGH2, the first low potential signal line VGL1, the second low potential signal line VGL2, the third low potential signal line VGL3, the first reset control line VST1, the second reset control line VST2, and the low frequency signal line LC is arranged in the second source and drain layer 223, thereby reducing a number of traces in the first source and drain layer, reducing a horizontal space occupied by the first source and drain layer, reducing a space occupied by the gate driving circuit, and narrowing a frame of the display panel.

Specifically, in the comparative display device, sources and drains of transistors and signal traces are arranged in the first source and drain layer, so each of the signal traces and the sources and the drains of the transistors needs to occupy the horizontal space of the first source and drain layer. The signal traces need to be wound when connected to the sources and the drains of the transistors, further occupying the horizontal space, resulting in a relatively larger width of the first source and drain layer and a relatively wider frame of the gate driving circuit. Compared with the comparative display device, in the embodiments of the present application, by arranging at least part of the signal lines in the second source and drain layer, the number of traces in the first source and drain layer is reduced, and the horizontal space occupied by the first source and drain layer is reduced. The signal line in the second source and drain layer may overlap with the traces in the first source and drain layer in a thickness direction or may overlap with sources and drains of transistors in the thickness direction, reducing a space occupied by connection lines, reducing a space occupied by the gate driving circuit, and narrowing a frame of the display panel.

In some embodiments, as shown in FIG. 8 to FIG. 23, at least one of the first reset control line VST1, the low frequency signal line LC, the first clock signal line CKA, the second clock signal line CKB, the first low potential signal line VGL1, and the second low potential signal line VGL2 is arranged in the second source and drain layer 223. By arranging at least one of the first reset control line VST1, the low frequency signal line LC, the first clock signal line CKA, the second clock signal line CKB, the first low potential signal line VGL1, and the second low potential signal line VGL2 in the second source and drain layer 223, it is possible to reduce the horizontal space occupied by the signal lines electrically connected to the first type gate driving circuit, and to narrow the frame of the display panel.

Specifically, compared to the signal lines connected to the first type gate driving circuit 22a in the comparative display device being set in the first source and drain layer and needing to extend from the trace region to the transistor region, which results in a relatively larger occupied horizontal space, in the embodiments of the present application, by arranging the signal lines connected to the first type gate driving circuit 22a in the second source and drain layer, a width of the first source and drain layer can be reduced, and distances between the signal lines provided in the second source and drain layer and the connected transistors can be shortened, thereby reducing the space occupied by the connection lines, reducing the space occupied by the gate driving circuit, and narrowing the frame of the display panel.

In some embodiments, as shown in FIG. 8 to FIG. 23, the first reset control line VST1 is arranged in the second source and drain layer 223. By arranging the first reset control line VST1 in the second source and drain layer 223, the first reset control line VST1 does not need to occupy the horizontal space of the first source and drain layer 221, the horizontal space occupied by the gate driving circuit 22 is reduced, and the frame of the display panel is narrowed.

In some embodiments, as shown in FIG. 5, FIG. 8 to FIG. 23, and FIG. 24 to FIG. 29, the first type gate driving circuit 22a includes a first pull-up control module 311, and a projection of the first reset control line VST1 on the substrate 211 and a projection of the first pull-up control module 311 on the substrate 211 are spaced apart. Since the projection of the first reset control line VST1 on the substrate and the projection of the first pull-up control module 311 on the substrate 211 are spaced apart, the first reset control line VST1 can not affect signals of the signal lines and transistors in the first type gate driving circuit 22a, and a space can be reserved for other signal lines.

Specifically, the above-described embodiments takes that the projection of the first reset control line VST1 on the substrate 211 and the projection of the first pull-up control module 311 on the substrate 211 are spaced apart as an example, but the embodiments of the present application are not limited thereto, and the projection of the first reset control line VST1 on the substrate 211 may overlap with respective module of the first type gate driving circuit 22a, for example, the projection of the first reset control line VST1 on the substrate 211 overlaps with the projection of the first pull-up control module 311 on the substrate 211, or the projection of the first reset control line VST1 on the substrate 211 overlaps with the projection of a first reset module 317 on the substrate 211.

In some embodiments, as shown in FIG. 5, FIG. 8 to FIG. 23, and FIG. 24 to FIG. 29, the first type gate driving circuit 22a includes a first reset module 317, and the first reset module 317 is electrically connected to the first reset control line VST1.

The first source and drain layer 221 includes a first source connection line LD1, a projection of the first reset control line VST1 on the substrate 211 and a projection of the first reset module 317 on the substrate 211 are spaced apart, and the first reset control line VST1 is connected to the first reset module 317 through the first source connection line LD1. Since the projection of the first reset control line VST1 on the substrate 211 and the projection of the first reset module 317 on the substrate 211 are spaced apart, the first reset control line VST1 does not affect signals of the signal lines and transistors in the first type gate driving circuit 22a, and a space can be reserved for other signal lines. The first reset control line VST1 is connected to the first reset module 317 through the first source connection line LD1, so that a normal connection between the first reset control line VST1 and the first reset module can be realized.

In some embodiments, as shown in FIG. 8 to FIG. 23, the low frequency signal line LC is arranged in the second source and drain layer 223. By arranging the low frequency signal line LC in the second source and drain layer 223, the low frequency signal line LC does not need to occupy the horizontal space of the first source and drain layer 221, the horizontal space occupied by the gate driving circuit 22 is reduced, and the frame of the display panel is narrowed.

In some embodiments, as shown in FIG. 5, FIG. 8 to FIG. 23, and FIG. 24 to FIG. 29, the first type gate driving circuit 22a includes a first inverting module 315. The low frequency signal line LC is electrically connected to the first inverting module 315. A projection of the low frequency signal line LC on the substrate 211 overlaps with a projection of the first inverting module 315 on the substrate 211. Since the projection of the low frequency signal line LC on the substrate 211 overlaps with the projection of the first inverting module 315 on the substrate 211, signals of the signal lines and transistors in the first type gate driving circuit 22a can not be affected, and a space can be reserved for other signal lines.

In some embodiments, as shown in FIG. 8 to FIG. 23, the first clock signal line CKA is arranged in the second source and drain layer 223. By arranging the first clock signal line CKA in the second source and drain layer 223, the first clock signal line CKA does not need to occupy the horizontal space of the first source and drain layer 221, the horizontal space occupied by the gate driving circuit 22 is reduced, and the frame of the display panel is narrowed.

Specifically, it can be understood that each clock signal line in the display panel 2 includes a plurality of clock lines, and the plurality of clock lines may occupy a relatively large space of the first source and drain layer, and the plurality of clock lines may further occupy space by extending to the transistor region and connecting to the transistors, resulting in a relatively large horizontal space occupied by the gate driving circuit 22, and resulting in a relatively wider frame of the display panel 2. In the embodiments of the present application, by arranging the first clock signal line CKA in the second source and drain layer 223, the horizontal space occupied by the clock signal lines can be reduced, thereby narrowing the frame of the display panel 2.

In some embodiments, as shown in FIG. 5, FIG. 8 to FIG. 23, and FIG. 24 to FIG. 29, the first type gate driving circuit 22a includes a first pull-up control module 311, and a projection of the first clock signal line CKA on the substrate 211 overlaps with a projection of the first pull-up control module 311 on the substrate 211. By overlapping the projection of the first clock signal line CKA on the substrate 211 and the projection of the first pull-up control module 311 on the substrate 211, the first clock signal line does not need to occupy an additional space, the space occupied by the gate driving circuit is reduced, and the frame of the display panel 2 is narrowed.

Specifically, as shown in FIG. 8 to FIG. 23 and 24 to 29, the first clock signal line CKA may include a first clock first line CKA1, a first clock second line CKA2, a first clock third line CKA3, and a first clock fourth line CKA4. The four clock lines of the first clock signal line CKA are cyclically connected to every four stages of the first type gate driving circuit 22a. For example, a first stage of first type gate driving circuit 22a to a fourth stage of first type gate driving circuit 22a are connected to the first clock first line CKA1, the first clock second line CKA2, the first clock third line CKA3, and the first clock fourth line CKA4, respectively; and a fifth stage of first type gate driving circuit 22a to an eighth stage of first type gate driving circuit 22a are connected to the first clock first line CKA1, the first clock second line CKA2, the first clock third line CKA3, and the first clock fourth line CKA4, respectively. By analogy, the clock signal lines connected to other stages of the first type gate driving circuits 22a can be determined.

Specifically, the first clock fourth line CKA4, the first clock third line CKA3, the first clock second line CKA2, and the first clock first line CKA1 are arranged sequentially in the first direction.

Specifically, in the above-described embodiments, that the first clock signal line CKA includes four clock lines is taken as an example, but the embodiments of the present application are not limited thereto, and the first clock signal line CKA may include another number of clock lines, for example, eight clock lines.

Specifically, for every four stages of the first type gate driving circuits 22a, a position of the connection between each stage of first type gate driving circuit 22a and the first clock signal line CKA is different.

In some embodiments, as shown in FIG. 8 to FIG. 23, the second clock signal line CKB is arranged in the second source and drain layer 223. By arranging the second clock signal line CKB in the second source and drain layer 223, the second clock signal line CKB does not need to occupy the horizontal space of the first source and drain layer 221, the horizontal space occupied by the gate driving circuit 22 is reduced, and the frame of the display panel is narrowed.

Specifically, it can be understood that each clock signal line in the display panel 2 includes a plurality of clock lines, and the plurality of clock lines may occupy a relatively large space of the first source and drain layer, and the plurality of clock lines may further occupy space by extending to the transistor region and connecting to the transistors, resulting in a relatively large horizontal space occupied by the gate driving circuit 22, and resulting in a relatively wider frame of the display panel 2. In the embodiments of the present application, by arranging the second clock signal line CKB in the second source and drain layer 223, the horizontal space occupied by the clock signal lines can be reduced, thereby narrowing the frame of the display panel 2.

In some embodiments, as shown in FIG. 5, FIG. 8 to FIG. 23, and FIG. 24 to FIG. 29, the first type gate driving circuit 22a includes a first pull-up module 312, and a projection of the second clock signal line CKB on the substrate 211 overlaps with a projection of the first pull-up module 312 on the substrate 211. By overlapping the projection of the second clock signal line CKB on the substrate 211 and the projection of the first pull-up module 312 on the substrate 211, the second clock signal line CKB does not need to occupy an additional space, and the second clock signal line is easily connected to the first pull-up module 312, thereby reducing the occupied space of the connection lines, reducing the space occupied by the gate driving circuit, and narrowing the frame of the display panel 2.

Specifically, the second clock signal line CKB includes a first group of sub-lines CKBi and a second group of sub-lines CKBj, and a projection of the first group of sub-lines CKBi on the substrate 211 overlaps with a projection of the first pull-up module 312 on the substrate 211.

Specifically, the second clock signal line CKB may include a second clock first line CKB1, a second clock second line CKB2, a second clock third line CKB3, a second clock fourth line CKB4, a second clock fifth line CKB5, a second clock sixth line CKB6, a second clock seventh line CKB7, and a second clock eighth line CKB8. The second clock first clock line CKB1, the second clock third line CKB3, the second clock fifth line CKB5, and the second clock seventh line CKB7 are as the first group of sub-lines CKBi. The second clock second clock line CKB2, the second clock fourth line CKB4, the second clock sixth line CKB6, and the second clock eighth line CKB8 are as the second group of sub-lines CKBj. Second pull-up transistors T22j of every four stages of the first type gate driving circuit 22a are cyclically connected to the first group of sub-lines CKBi, respectively, and third pull-up transistors T23j of the every four stages of the first type gate driving circuit 22a are cyclically connected to the second group of sub-lines CKBj, respectively. For example, the second pull-up transistors T22j of the first stage of first type gate driving circuit 22a to the fourth stage of first type gate driving circuit 22a are connected to the second clock first line CKB1, the second clock third line CKB3, the second clock fifth line CKB5, and the second clock seventh line CKB7, respectively; and the third pull-up transistors T23j of the first stage of first type gate driving circuit 22a to the fourth stage of first type gate driving circuit 22a are connected to the second clock second line CKB2, the second clock fourth line CKB4, the second clock sixth line CKB6, and the second clock eighth line CKBS, respectively. Similarly, second pull-up transistors T22j of the fifth stage of first type gate driving circuit 22a to the eight stage of first type gate driving circuit 22a are connected to the second clock first line CKB1, the second clock third line CKB3, the second clock fifth line CKB5, and the second clock seventh line CKB7, respectively; and third pull-up transistors T23j of the fifth stage of first type gate driving circuit 22a to the eighth stage of first type gate driving circuit 22a are connected to the second clock second line CKB2, the second clock fourth line CKB4, the second clock sixth line CKB6, and the second clock eighth line CKB8, respectively. By analogy, the clock signal lines connected to other stages of the first type gate driving circuits 22a can be determined.

Specifically, the second clock seventh line CKB7, the second clock fifth line CKB5, the second clock third line CKB3, and the second clock first line CKB1 are arranged sequentially in the first direction.

Specifically, the second clock eighth line CKB 8, the second clock sixth line CKB 6, the second clock fourth line CKB 4, and the second clock second line CKB 2 are arranged sequentially in the first direction.

Specifically, the above-described embodiments are described by taking that the second clock signal line CKB includes eight clock lines as an example, but the embodiments of the present application are not limited thereto, and the second clock signal line CKB may include another number of clock lines, for example, four clock lines or sixteen clock lines.

Specifically, for every four stages of the first type gate driving circuits 22a, a position of the connection between the second pull-up transistor T22j of each stage of first type gate driving circuit 22a and the first group of sub-lines CKBi is different.

Specifically, for every four stages of the first type gate driving circuits 22a, a position of the connection between the third pull-up transistor T23j of each stage of first type gate driving circuit 22a and the second group of sub-lines CKBj is different.

In some embodiments, as shown in FIG. 8 to FIG. 23, the first low potential signal line VGL1 is arranged in the second source and drain layer 223. By arranging the first low potential signal line VGL1 in the second source and drain layer 223, the first low potential signal line VGL1 does not need to occupy the horizontal space of the first source and drain layer 221, the horizontal space occupied by the gate driving circuit 22 is reduced, and the frame of the display panel is narrowed.

In some embodiments, as shown in FIG. 5, FIG. 8 to FIG. 23, and FIG. 24 to FIG. 29, the first type gate driving circuit 22a includes a first inverting module 315 and a first pull-up module 312. The first inverting module 315 and the first pull-up module 312 are electrically connected to a first pull-up node Q1[n], and a projection of the first low potential signal line VGL1 on the substrate 211 is located between a projection of the first inverting module 315 on the substrate 211 and a projection of the first pull-up module 312 on the substrate 211. By arranging the first low potential signal line between the projection of the first inverting module 315 on the substrate 211 and the projection of the first pull-up module 312 on the substrate 211, the first low potential signal line VGL1 does not need to occupy an additional space, and the first low potential signal line does not affect a normal operation of the first pull-up module.

In some embodiments, as shown in FIG. 8 to FIG. 23, the second low potential signal line VGL2 is arranged in the second source and drain layer 223. By arranging the second low potential signal line VGL2 in the second source and drain layer 223, the second low potential signal line VGL2 does not need to occupy the horizontal space of the first source and drain layer 221, the horizontal space occupied by the gate driving circuit 22 is reduced, and the frame of the display panel is narrowed.

In some embodiments, as shown in FIG. 5, FIG. 8 to FIG. 23, and FIG. 24 to FIG. 29, the first type gate driving circuit 22a includes a first pull-up module 312, and a projection of the second low potential signal line VGL2 on the substrate 211 overlaps with a projection of the first pull-up module 312 on the substrate 211. By overlapping the projection of the second low potential signal line VGL2 on the substrate 211 and the projection of the first pull-up module 312 on the substrate 211, the second low potential signal line VGL2 does not need to occupy an additional space, the horizontal space occupied by the gate driving circuit 22 is reduced, and the frame of the display panel is narrowed.

In some embodiments, as shown in FIG. 8 to FIG. 23, the second reset control line VST2 is arranged in the second source and drain layer 223. By arranging the second reset control line VST2 in the second source and drain layer 223, the second reset control line VST2 does not need to occupy the horizontal space of the first source and drain layer 221, the horizontal space occupied by the gate driving circuit 22 is reduced, and the frame of the display panel is narrowed.

In some embodiments, as shown in FIG. 6, FIG. 8 to FIG. 23, and FIG. 30 to FIG. 35, the second type gate driving circuit 22b includes a second reset module 327. The second reset module 327 is electrically connected to the second reset control line VST2, and a projection of the second reset control line VST2 on the substrate 211 is located between a projection of the first type gate driving circuit 22a on the substrate 211 and a projection of the second reset module 327 on the substrate 211. By configuring the projection of the second reset control line VST2 on the substrate 211 to be located between the projection of the first type gate driving circuit 22a on the substrate 211 and the projection of the second reset module 327 on the substrate 211, the second reset control line VST2 does not need to occupy an additional horizontal space, the horizontal space occupied by the gate driving circuit 22 is reduced, the frame of the display panel is narrowed, and the connection line between the second reset control line VST2 and the second reset module 327 is relatively shorter or even not necessary, thereby further reducing the space occupied by the second reset control line VST2, and narrowing the frame of the display panel.

In some embodiments, as shown in FIG. 8 to FIG. 23, at least one of the third clock signal line CKC, the first high potential signal line VGH1, the second high potential signal line VGH2, and the third low potential signal line VGL3 is arranged in the second source and drain layer 223. By arranging at least one of the third clock signal line CKC, the first high potential signal line VGH1, the second high potential signal line VGH2, and the third low potential signal line VGL3 in the second source and drain layer 223, it is possible to reduce the horizontal space occupied by the signal lines electrically connected to the gate driving circuit, and to narrow the frame of the display panel.

Specifically, compared to the signal lines connected to the gate driving circuits in the comparative display device being set in the first source and drain layer and needing to extend from the trace region to the transistor region, which results in a relatively larger occupied horizontal space, in the embodiments of the present application, by arranging the signal lines connected to the gate driving circuit in the second source and drain layer, a width of the first source and drain layer can be reduced, and distances between the signal lines arranged in the second source and drain layer and the connected transistors can be shortened, thereby reducing the space occupied by the connection lines, reducing the space occupied by the gate driving circuit, and narrowing the frame of the display panel.

In some embodiments, as shown in FIG. 8 to FIG. 23, the first high potential signal line VGH1 is arranged in the second source and drain layer 223. By arranging the first high potential signal line VGH1 in the second source and drain layer 223, the first high potential signal line VGH1 does not need to occupy the horizontal space of the first source and drain layer 221, the horizontal space occupied by the gate driving circuit 22 is reduced, and the frame of the display panel is narrowed.

In some embodiments, as shown in FIG. 7, FIG. 8 to FIG. 23, and FIG. 36 to FIG. 41, the third type gate driving circuit 22c includes a third pull-up control module 331, and a projection of the first high potential signal line VGH1 on the substrate 211 overlaps with a projection of the third pull-up control module 331 on the substrate 211. By overlapping the projection of the first high potential signal line VGH1 on the substrate 211 and the projection of the third pull-up control module 331 on the substrate 211, the first high potential signal line VGH1 does not need to occupy an additional space, the horizontal space occupied by the gate driving circuit 22 is reduced, the frame of the display panel is narrowed, and the first high potential signal line VGH1 can be directly connected to the third pull-up control module, thereby reducing a length of the connection line, further reducing the occupied space, and narrowing the frame of the display panel.

In some embodiments, as shown in FIG. 8 to FIG. 23, the third clock signal line CKC is arranged in the second source and drain layer 223. By arranging the third clock signal line CKC in the second source and drain layer 223, the third clock signal line CKC does not need to occupy the horizontal space of the first source and drain layer 221, the horizontal space occupied by the gate driving circuit 22 is reduced, and the frame of the display panel is narrowed.

Specifically, it can be understood that each clock signal line in the display panel 2 includes a plurality of clock lines, and the plurality of clock lines may occupy a relatively large space of the first source and drain layer, and the plurality of clock lines may further occupy space by extending to the transistor region and connecting to the transistors, resulting in a relatively large horizontal space occupied by the gate driving circuit 22, and resulting in a relatively wider frame of the display panel 2. In the embodiments of the present application, by arranging the third clock signal line CKC in the second source and drain layer 223, the horizontal space occupied by the clock signal lines can be reduced, thereby narrowing the frame of the display panel 2.

In some embodiments, as shown in FIG. 7, FIG. 8 to FIG. 23, and FIG. 36 to FIG. 41, the third type gate driving circuit 22c includes a third pull-up control module 331, and a projection of the third clock signal line CKC on the substrate 211 overlaps with a projection of the third pull-up control module 331 on the substrate 211. By overlapping the projection of the third clock signal line CKC on the substrate 211 and the projection of the third pull-up control module 331 on the substrate 211, the first clock signal line does not need to occupy an additional space, the space occupied by the gate driving circuit is reduced, and the frame of the display panel 2 is narrowed.

Specifically, the third clock signal line CKC may include a third clock first line CKC1, a third clock second line CKC2, a third clock third line CKC3, and a third clock fourth line CKC4. The four clock lines of the third clock signal line CKC are cyclically connected to every four stages of the second type gate driving circuits 22b. For example, a first stage of second type gate driving circuit 22b to a fourth stage of second type gate driving circuit 22b are connected to the third clock first line CKC1, the third clock second line CKC2, the third clock third line CKC3, and the third clock fourth line CKC4, respectively; and a fifth stage of second type gate driving circuit 22b to an eighth stage of second type gate driving circuit 22b are connected to the third clock first line CKC1, the third clock second line CKC2, the third clock third line CKC3, and the third clock fourth line CKC4, respectively, respectively. By analogy, the clock signal lines connected to other stages of the second type gate driving circuits 22b can be determined.

Specifically, the third clock fourth line CKC4, the third clock third line CKC3, the third clock second line CKC2, and the third clock first line CKC1 are arranged sequentially in the first direction.

Specifically, in the above-described embodiments, that the third clock signal line CKC includes four clock lines is taken as an example, but the embodiments of the present application are not limited thereto, and the third clock signal line CKC may include another number of clock lines, for example, eight clock lines.

Specifically, for every four stages of the second type gate driving circuits 22b, a position of the connection between each stage of second type gate driving circuit 22b and the third clock signal line CKC is different.

In some embodiments, as shown in FIG. 8 to FIG. 23, the second high potential signal line VGH2 is arranged in the second source and drain layer 223. By arranging the second high potential signal line VGH2 in the second source and drain layer 223, the second high potential signal line VGH2 does not need to occupy the horizontal space of the first source and drain layer 221, the horizontal space occupied by the gate driving circuit 22 is reduced, and the frame of the display panel is narrowed.

In some embodiments, as shown in FIG. 7, FIG. 8 to FIG. 23, and FIG. 36 to FIG. 41, the third type gate driving circuit 22c includes a third pull-up module 332. The third pull-up module 332 is electrically connected to the second high potential signal line VGH2, and a projection of the second high potential signal line VGH2 on the substrate 211 overlaps with a projection of the third pull-up module 332 on the substrate 211. By overlapping the projection of the second high potential signal line VGH2 on the substrate 211 and the projection of the third pull-up module 332 on the substrate 211, the second high potential signal line VGH2 does not need to occupy an additional space, the space occupied by the gate driving circuit is reduced, the frame of the display panel 2 is narrowed, and the second high potential signal line VGH2 can be directly connected to the third pull-up module 332, so that the connection line is relatively shorter or even eliminated, the space occupied by the second high potential signal line VGH2 is further reduced, and the frame of the display panel is narrowed.

In some embodiments, as shown in FIG. 8 to FIG. 23, the third low potential signal line VGL3 is arranged in the second source and drain layer 223. By arranging the third low potential signal line VGL 3 in the second source and drain layer 223, the third low potential signal line VGL 3 does not need to occupy the horizontal space of the first source and drain layer 221, thereby reducing the horizontal space occupied by the gate driving circuit 22, and narrowing the frame of the display panel.

In some embodiments, as shown in FIG. 7, FIG. 8 to FIG. 23, and FIG. 36 to FIG. 41, the third type gate driving circuit 22c includes a third pull-down module 333. The third pull-down module 333 is electrically connected to the third low potential signal line VGL3, and a projection of the third low potential signal line VGL3 on the substrate 211 overlaps with a projection of the third pull-down module 333 on the substrate 211. By overlapping the projection of the third low potential signal line VGL3 on the substrate 211 and the projection of the third pull-down module 333 on the substrate 211, the third low potential signal line VGL3 does not need to occupy an additional space, the space occupied by the gate driving circuit is reduced, the frame of the display panel 2 is narrowed, and the third low potential signal line VGL3 can be directly connected to the third pull-down module 333, so that the connection line is relatively shorter or even eliminated, the space occupied by the third low potential signal line VGL3 is further reduced, and the frame of the display panel is narrowed.

In some embodiments, as shown in FIG. 8 to FIG. 23, the first clock signal line CKA, the second clock signal line CKB, the third clock signal line CKC, the first high potential signal line VGH1, the second high potential signal line VGH2, the first low potential signal line VGL1, the second low potential signal line VGL2, the third low potential signal line VGL3, the first reset control line VST1, the second reset control line VST2, and the low frequency signal line LC are all arranged in the second source and drain layer. By arranging all of the first clock signal line CKA, the second clock signal line CKB, the third clock signal line CKC, the first high potential signal line VGH1, the second high potential signal line VGH2, the first low potential signal line VGL1, the second low potential signal line VGL2, the third low potential signal line VGL3, the first reset control line VST1, the second reset control line VST2, and the low frequency signal line LC in the second source and drain layer, it is possible to further reduce the horizontal space occupied by the gate driving circuit and narrow the frame of the display panel.

Specifically, the second clock signal line CKB includes a first group of sub-lines CKBi and a second group of sub-lines CKBj.

Specifically, the first reset control line VST1, the low frequency signal line LC, the first clock signal line CKA, the first low potential signal line VGL1, the first group of sub-lines CKBi, the second low potential signal line VGL2, the second reset control line VST2, the second group of sub-lines CKBj, the first high potential signal line VGH1, the third clock signal line CKC, the second high potential signal line VGH2, and the third low potential signal line VGL3 are arranged in the first direction X.

In some embodiments, as shown in FIG. 5, the first type gate driving circuit 22a includes a first pull-up module 312, and the second clock signal line CKB includes a first group of sub-lines CKBi and a second group of sub-lines CKBj, and the first pull-up module 312 includes:
a first pull-up transistor T21j, a first electrode of the first pull-up transistor T21j being electrically connected to the first clock signal line CKA, and a second electrode of the first pull-up transistor T21j being electrically connected to a cascade signal terminal Cout[n] of a current stage of first type gate driving circuit 22a;
a second pull-up transistor T22j, a first electrode of the second pull-up transistor T22j being electrically connected to the first group of sub-lines CKBi, and a second electrode of the second pull-up transistor T22j being electrically connected to a first signal output terminal Gn[m] of another stage of first type gate driving circuit 22a: and
a third pull-up transistor T23j, a first electrode of the third pull-up transistor T23j being electrically connected to the second group of sub-lines CKBj, and a second electrode of the third pull-up transistor T23j being electrically connected to a first signal output terminal Gn[n] of the current stage of first type gate driving circuit 22a. By configuring one stage of first type gate driving circuit 22a to have the first signal output terminals of the two stages of the first type gate driving circuits, so that one stage of first type gate driving circuit can occupy the space of the two stages of the first type gate driving circuits, thereby reducing the horizontal space occupied by the first type gate driving circuits and narrowing the frame.

Specifically, in the embodiments of the present application, the first signal output terminal Gn[m] of another stage of first type gate driving circuit 22a may be a first signal output terminal of one of subsequent stages of the first type gate driving circuits 22a. For example, the first signal output terminal Gn[m] of another stage of first type gate driving circuit 22a may be a first signal output terminal of a first subsequent-stage of first type gate driving circuit 22a, taking that n is 3 as an example, m may be 4. The embodiments of the present application are not limited thereto, and the first signal output terminal Gn[m] of another stage of first type gate driving circuit 22a may be a first signal output terminal of a second subsequent-stage of first type gate driving circuit 22a or a first signal output terminal of one of other stages of the first type gate driving circuits 22a.

Specifically, it can be understood that, compared with the comparative display device, in which one stage of first type gate driving circuit includes only one first signal output terminal, and each stage of first type gate driving circuit is connected to the corresponding first signal output terminal, in the embodiments of the present application, one stage of first type gate driving circuit includes two first signal output terminals, correspondingly, the first type gate driving circuit can be shortened by half, and correspondingly, the first signal output terminals connected to each of the first type gate driving circuits can be arranged sequentially. For example, the two first signal output terminals of the first stage of first type gate driving circuit can be considered as the first signal output terminal of the first stage of first type gate driving circuit and the first signal output terminal of the second stage of first type gate driving circuit in the comparative display device. Similarly, the first signal output terminals of other stages of first type gate driving circuits can be determined.

Specifically, the gate driving circuit includes a plurality of transistors (e.g., a first pull-up control transistor and a first pull-up transistor), and the pixel driving circuit includes a plurality of transistors (e.g., a driving transistor and a switching transistor).

In some embodiments, a mobility of at least one of the transistors in the gate driving circuit 22 is greater than a mobility of each of the transistors in the pixel driving circuit 21. Thus, a size of the transistors in the gate driving circuit can be reduced, thereby reducing the space occupied by the gate driving circuit 22 and narrowing the frame.

Specifically, under the condition that the mobility of at least one of the transistors in the gate driving circuit 22 is greater than the mobility of each of the transistors in the pixel driving circuit 21, for example, a mobility of a first inverting transistor in the gate driving circuit 22 is greater than a mobility of an initialization transistor in the pixel driving circuit 21, but the embodiments of the present application are not limited thereto, and mobility of other transistors in the gate driving circuit may be greater than the mobility of each of the transistors in the pixel driving circuit, or mobility of a plurality of transistors in the gate driving circuit may be greater than the mobility of each of the transistors in the pixel driving circuit.

Specifically, a material of an active portion of each transistor in the gate driving circuit may be the same, a material of an active portion of each transistor in the pixel driving circuit may be the same, and the mobility of the active portion of each transistor in the gate driving circuit may be greater than the mobility of the active portion of each transistor in the pixel driving circuit.

Specifically, the mobility of the active portion of the transistor in the gate driving circuit may be greater than 20, and for example, the material of the active portion of each transistor in the gate driving circuit may be Ln-IZO (indium zinc oxide doped with lanthanide elements) or IGZTO (indium gallium zinc tin oxide), and the material of the active portion of each transistor in the pixel driving circuit may be indium gallium zinc oxide, so that an area of each transistor in the gate driving circuit may be relatively small.

Specifically, in order to improve the performance of the transistor, the area of the transistor is generally made larger. For example, under the condition that indium gallium zinc oxide is used as the material of the active portion, a channel width of the transistor needs to be 1000 and a length of the transistor needs to be 5 to meet the electrical requirements of the transistor. In the embodiments of the present application, by configuring the mobility of transistors in the gate driving circuit to be greater than the mobility of transistors in the pixel driving circuit, the area of the transistors can be reduced while still meeting the electrical requirements, thus reducing the area occupied by the transistors and narrowing the frame of the display panel.

Meanwhile, in order to more clearly explain a structure of each film layer of the display panel, FIG. 9 to FIG. 13 are provided. As shown in FIG. 9, a position of each structure and a relative positional relationship of each structure in the light-shielding layer 212 can be seen. As shown in FIG. 10, a position of each structure and a relative positional relationship of each structure in the active layer 216 can be seen. As shown in FIG. 11, a position of each structure and a relative positional relationship of each structure in the first gate layer 218 can be seen. As shown in FIG. 12, a position of each structure and a relative positional relationship of each structure in the first source and drain layer 221 can be seen. As shown in FIG. 13, a position of each structure and a relative positional relationship of each structure in the second source and drain layer 223 can be seen.

Meanwhile, in order to explain corresponding relationships between different film layers, FIG. 14 to FIG. 23 are provided. As shown in FIG. 14, a relative positional relationship between the light-shielding layer 212 and the active layer 216 can be seen. As shown in FIG. 15, relative positional relationships between the light-shielding layer 212, the active layer 216, and the first gate layer 218 can be seen. As shown in FIG. 16, relative positional relationships between the light-shielding layer 212, the active layer 216, the first gate layer 218, and the first source and drain layer 221 can be seen. As shown in FIG. 8, relative positional relationships between the light-shielding layer 212, the active layer 216, the first gate layer 218, the first source and drain layer 221, and the second source and drain layer 223 can be seen. As shown in FIG. 17, a relative positional relationship between the light-shielding layer 212 and a first via hole 411 can be seen, and the first via hole 411 refers to a via hole through which the first source and drain layer 221 and the light-shielding layer 212 are connected, and the first via hole includes a via hole of the buffer layer 213. As shown in FIG. 18, a relative positional relationship and a connection position between the light-shielding layer 212 and the first source and drain layer 221 can be seen. As shown in FIG. 19, a relative positional relationship between the first gate layer 218 and a second via hole 412 can be seen, and the second via hole 412 refers to via holes of the first interlayer insulating layer 219 and the third gate insulating layer 232. As shown in FIG. 20, a relative positional relationship and a connection position between the first gate layer 218 and the first source and drain layer 221 can be seen. As shown in FIG. 21, a relative positional relationship between the first source and drain layer 221 and a third via hole 413 can be seen, and the third via hole 413 refers to a via hole of the passivation layer 222. As shown in FIG. 22, relative positional relationships between the first source and drain layer 221, the third via hole 413, and a fourth via hole 414 can be seen, and the fourth via hole 414 refers to a via hole of the first planarization layer 224. As shown in FIG. 23, a relative positional relationship and a connection position between the first source and drain layer 221 and the second source and drain layer 223 can be seen.

In some embodiments, as shown in FIG. 5, the first type gate driving circuit 22a includes a first pull-up control module 311, a first pull-up module 312, a first pull-down module 313, a first pull-down maintenance module 314, a first inverting module 315, a first anti negative-bias module 316, and a first reset module 317. The first pull-up control module 311 and the first pull-up module 312 are electrically connected to a first pull-up node Q1[n]. The first pull-down module 313 is electrically connected to the first pull-up node Q1[n] and a signal output terminal Gn[n] of a current stage of first type gate driving circuit 22a. The first pull-down maintenance module 314 is electrically connected between the first pull-up node Q1[n] and the first low potential signal line VGL1. The first inverting module 315 is electrically connected to the first pull-up node Q1[n], the first low potential signal line VGL1, and the low frequency signal line LC. The first anti negative-bias module 316 is electrically connected between the first high potential signal line VGH1 and the first pull-up node Q1[n]. The first reset module 317 is electrically connected between the first pull-up node Q1[n] and the first low potential signal line VGL1.

In some embodiments, as shown in FIG. 5 and FIG. 24 to FIG. 29, at least two of the first pull-up control module 311, the first pull-up module 312, the first pull-down module 313, the first pull-down maintenance module 314, the first inverting module 315, the first anti negative-bias module 316, and the first reset module 317 are arranged in the second direction, and an included angle between the first direction and the second direction is greater than 0 degree and is less than or equal to 90 degrees. By arranging at least two of the first pull-up control module 311, the first pull-up module 312, the first pull-down module 313, the first pull-down maintenance module 314, the first inverting module 315, the first anti negative-bias module 316, and the first reset module 317 in the second direction, it is possible to reduce the horizontal space occupied by the first type gate driving circuit 22a, thereby reducing the horizontal space occupied by the gate driving circuit 22 and narrowing the frame of the display panel 2.

Specifically, compared to an horizontal arrangement of various modules of the comparative display device, in the embodiments of the present application, at least two of the modules in the first type gate driving circuit 22a are arranged in the second direction, so that the horizontal space occupied by the first type gate driving circuit 22a can be reduced, the horizontal space occupied by the gate driving circuit 22 can be reduced, and the frame of the display panel 2 can be narrowed.

In some embodiments, as shown in FIG. 5 and FIG. 24, a part of the first pull-up control module 311, a part of the first inverting module 315, the first anti negative-bias module 316, and the first reset module 317 are arranged in the second direction Y. By arranging a part of the first pull-up control module 311, a part of the first inverting module 315, the first anti negative-bias module 316, and the first reset module 317 in the second direction Y, a horizontal space occupied by the first pull-up control module 311, the first inverting module 315, the first anti negative-bias module 316, and the first reset module 317 can be reduced, the horizontal space occupied by the first type gate driving circuit 22a can be reduced, and the horizontal space occupied by the gate driving circuit 22 can be reduced, thereby narrowing the frame of the display panel 2.

Specifically, as shown in FIG. 24, it can be seen that in the second direction, a part of the first inverting module 315, the first reset module 317, the first anti negative-bias module 316, and a part of the first pull-up control module 311 are arranged in the second direction.

In some embodiments, as shown in FIG. 5 and FIG. 24, another part of the first pull-up control module 311, another part of the first inverting module 315, and the first pull-down maintenance module 314 are arranged in the second direction Y. By arranging another part of the first pull-up control module 311, another part of the first inverting module 315, and the first pull-down maintenance module 314 in the second direction Y, it is possible to reduce the horizontal space occupied by the first type gate driving circuit 22a and reduce the horizontal space occupied by the gate driving circuit 22, thereby narrowing the frame of the display panel 2.

Specifically, as shown in FIG. 24, it can be seen that in the second direction Y, the first inverting module 315, the first pull-down maintenance module 314, and another part of the first pull-up control module 311 are sequentially arranged, and the first pull-down maintenance module 314 is arranged between the first inverting module 315 and the first pull-up control module 311.

In some embodiments, as shown in FIG. 5 and FIG. 24 to FIG. 29, another part of the first pull-up control module 311, another part of the first inverting module 315, and a part of the first pull-down module 313 are arranged in the second direction Y. The first reset module 317, the first pull-down maintenance module 314, and a part of the first pull-down module 313 are arranged in the first direction X. By arranging another part of the first pull-up control module 311, another part of the first inverting module 315, and a part of the first pull-down module 313 in the second direction Y, it is possible to further reduce the horizontal space occupied by the gate driving circuit 22, thereby narrowing the frame of the display panel 2.

Specifically, as shown in FIG. 24, it can be seen that another part of the first inverting module 315, a part of the first pull-down module 313, and another part of the first pull-up control module 311 are sequentially arranged in the second direction.

Specifically, as shown in FIG. 24, a part of the first inverting module 315 and a part of the first pull-up control module 311 are arranged in the second direction, and another part of the first inverting module 315 and another part of the first pull-up control module 311 are arranged in the second direction.

In some embodiments, as shown in FIG. 5 and FIG. 24, a part of the first pull-up module 312 and another part of the first pull-down module 313 are arranged in the second direction Y. By arranging a part of the first pull-up module 312 and another part of the first pull-down module 313 in the second direction Y, the horizontal space occupied by the gate driving circuit 22 can be further reduced, thereby narrowing the frame of the display panel 2.

Specifically, as shown in FIG. 24, it can be seen that a part of the first pull-up module 312 and another part of the first pull-down module 313 are sequentially arranged in the second direction Y.

In some embodiments, as shown in FIG. 5 and FIG. 24 to FIG. 29, the first pull-up control module 311 includes a first pull-up control transistor T11j, a second pull-up control transistor T12j, and a third pull-up control transistor T81j. A gate T11jG of the first pull-up control transistor T11j is electrically connected to a cascade output terminal Cout[n-2] of a second previous-stage of first type gate driving circuit 22a. A first electrode T11jS of the first pull-up control transistor T11j is electrically connected to the first high potential signal line VGH1. A second electrode T11jD of the first pull-up control transistor T11j is electrically connected to a first electrode T12jS of the second pull-up control transistor T12j. A gate T12jG of the second pull-up control transistor T12j is electrically connected to the cascade output terminal Cout[n-2] of the second previous-stage of first type gate driving circuit 22a. A second electrode T12jD of the second pull-up control transistor T12j is electrically connected to the first pull-up node Q1[n]. A gate T81jG of the third pull-up control transistor T81j is electrically connected to the first high potential signal line VGH1. A first electrode T81jS of the third pull-up control transistor T81j is electrically connected to the first high potential signal line VGH1. A second electrode T81jD of the third pull-up control transistor T81j is electrically connected to the second electrode T11jD of the first pull-up control transistor T11j.

In each stage of gate driving circuit 22, the first pull-up control transistor T11j and the second pull-up control transistor T12j are sequentially arranged in the second direction, and the first pull-up control transistor T11j and the third pull-up control transistor T81j are sequentially arranged in the first direction. By arranging the first pull-up control transistor T11j and the second pull-up control transistor T12j sequentially in the second direction, the space occupied by the first pull-up control module 311 can be reduced, thereby narrowing the frame of the display panel 2.

In some embodiments, as shown in FIG. 5 and FIG. 24 to FIG. 29, the third pull-up control transistor T81j includes a first pull-up control sub-transistor T81j1 and a second pull-up control sub-transistor T81j2. A gate T81j2G and a first electrode T81j2S of the second pull-up control sub-transistor T81j2 are electrically connected to the first high potential signal line VGH1, and a second electrode T81j2D of the second pull-up control sub-transistor T81j2 is electrically connected to a first electrode of the first pull-up control sub-transistor T81j1. A gate T81j1G of the first pull-up control sub-transistor T81j1 is electrically connected to the first high potential signal line VGH1, and a second electrode TS1j1D of the first pull-up control sub-transistor T81j1 is electrically connected to the second electrode T11jD of the first pull-up control transistor T11j.

The first pull-up control sub-transistor T81j1 and the second pull-up control sub-transistor T81j2 are arranged in the second direction. By configuring the third pull-up control transistor T81j to include the first pull-up control sub-transistor T81j1 and the second pull-up control sub-transistor T81j2, the performance of the third pull-up control transistor T81j can be improved, and the first pull-up control sub-transistor T81j1 and the second pull-up control sub-transistor T81j2 are arranged in the first direction, so that a horizontal area occupied by the third pull-up control transistor T81j can be reduced, and the frame of the display panel 2 can be narrowed.

Specifically, the first pull-up control sub-transistor T81j1 and the second pull-up control sub-transistor T81j2 may be regarded as two independent transistors, or may be regarded as two sub-transistors of the third pull-up control transistor T81j. Similarly, other sub-transistors can refer to the above explanation and will not be elaborated further in the following embodiments.

Specifically, under the condition that one transistor includes a plurality of sub-transistors, the first electrode of the transistor is an electrode connected to the signal line. For example, the third pull-up control transistor T81j includes the first pull-up control sub-transistor T81j1 and the second pull-up control sub-transistor T81j2, and since the first electrode T81j2S of the second pull-up control sub-transistor T81j2 is electrically connected to the first high potential signal line VGH1, the first electrode T81jS of the third pull-up control transistor T81j corresponds to the first electrode T81j2S of the second pull-up control sub-transistor T81j2. Similarly, first electrodes of other transistors can be determined.

Specifically, the multistage gate driving circuits 22 include multistage first type gate driving circuits 22a. In the first stage of first type gate driving circuits 22a, the gate T11jG of the first pull-up control transistor T11j can be connected to a start signal line. In another stage of first type gate driving circuit 22a, the gate T11jG of the first pull-up control transistor T11j and the gate T12jG of the second pull-up control transistor T12j are connected to a first signal output terminal of a second previous-stage of first type gate driving circuit 22a. The first electrode T11jS of the first pull-up control transistor T11j and the first electrode T12jS of the second pull-up control transistor T12j are electrically connected to the first high potential signal line VGH1.

In some embodiments, as shown in FIG. 5 and FIG. 24 to FIG. 29, the first pull-down module 313 includes a first pull-down transistor T31j, a second pull-down transistor T32j, a third pull-down transistor T33j, and a fourth pull-down transistor T41j. A gate T31jG of the first pull-down transistor T31j is electrically connected to a first pull-down node Qb1[n], a first electrode T31jD of the first pull-down transistor T31j is electrically connected to the first low potential signal line VGL1, and a second electrode T31jD of the first pull-down transistor T31j is electrically connected to the cascade output terminal Cout[n] of the current stage of first type gate driving circuit 22a. A gate T32jG of the second pull-down transistor T32j is electrically connected to the first pull-down node QB1[n], a first electrode T32jS of the second pull-down transistor T32j is electrically connected to the second low potential signal line VGL2, and a second electrode T32jD of the second pull-down transistor T32j is electrically connected to a first signal output terminal Gn[m] of another stage of first type gate driving circuit 22a. A gate T33jG of the third pull-down transistor T33j is electrically connected to the first pull-down node QB1[n], a first electrode T33jS of the third pull-down transistor T33j is electrically connected to the second low potential signal line VGL2, and a second electrode T33jD of the third pull-down transistor T33j is electrically connected to a first signal output terminal Gn[n] of the current stage of first type gate driving circuit 22a. A gate T41jG of the fourth pull-down transistor T41j is electrically connected to a cascade output terminal Cout[n+2] of a second subsequent-stage of first type gate driving circuit 22a, a first electrode T41jS of the fourth pull-down transistor T41j is electrically connected to the first low potential signal line VGL1, and a second electrode T41jD of the fourth pull-down transistor T41j is electrically connected to the first pull-up node Q1[n].

The first pull-down transistor T31j and the fourth pull-down transistor T41j are arranged in the second direction, and the second pull-down transistor T32j and the third pull-down transistor T33j are arranged in the second direction. By arranging the first pull-down transistor T31j and the fourth pull-down transistor T41j in the second direction, and arranging the second pull-down transistor T32j and the third pull-down transistor T33j in the second direction, a space occupied by the first pull-down module 313 can be reduced, and the frame of the display panel 2 can be narrowed.

In some embodiments, as shown in FIG. 5 and FIG. 24 to FIG. 29, the fourth pull-down transistor T41j includes a first pull-down sub-transistor T41j1 and a second pull-down sub-transistor T41j2. A gate T41j2G of the second pull-down sub-transistor T41j2 is electrically connected to a cascade output terminal Cout[n+2] of a second subsequent-stage of first type gate driving circuit 22a, a first electrode T41j2S of the second pull-down sub-transistor T41j2 is electrically connected to the first low potential signal line VGL1, and a second electrode T41j2D of the second pull-down sub-transistor T41j2 is electrically connected to a first electrode T41j1S of the first pull-down sub-transistor T41j1 at a first internal node N1[n]. A gate T41j1G of the first pull-up control sub-transistor T41j1 is electrically connected to the cascade output terminal Cout[n+2] of the second subsequent-stage of first type gate driving circuit 22a, and a second electrode T41j1D of the first pull-up control sub-transistor T41j 1 is electrically connected to the first pull-up node Q1[n].

The first pull-down sub-transistor T41j1 and the second pull-down sub-transistor T41j2 are arranged in the second direction. By configuring the fourth pull-down transistor T41j to include the first pull-down sub-transistor T41j1 and the second pull-down sub-transistor T41j2, the performance of the fourth pull-down transistor T41j can be improved, and the first pull-down sub-transistor T41j1 and the second pull-down sub-transistor T41j2 are arranged in the second direction, so that a horizontal area occupied by the fourth pull-down transistor T41j can be reduced, and the frame of the display panel 2 can be narrowed.

In some embodiments, as shown in FIG. 5 and FIG. 24 to 29, the first inverting module 315 includes a first inverting transistor T51j, a second inverting transistor T52j, a third inverting transistor T53j, a fourth inverting transistor T54j, and a fifth inverting transistor T55j. A gate T51jG and a first electrode T51jS of the first inverting transistor T51j are electrically connected to the low frequency signal line LC, and a second electrode T51jD of the first inverting transistor T51j is electrically connected to a second electrode T52jD of the second inverting transistor T52j. A gate T52jG of the second inverting transistor T52j is electrically connected to the first pull-up node Q1[n], and a first electrode T52jS of the second inverting transistor T52j is electrically connected to the first low potential signal line VGL1. A gate T53jG of the third inverting transistor T53j is electrically connected to the second electrode T51jD of the first inverting transistor T51j, a first electrode T53jS of the third inverting transistor T53j is electrically connected to the low frequency signal line LC, and a second electrode T53jD of the third inverting transistor T53j is electrically connected to the first pull-down node Qb1[n]. A gate T54jG of the fourth inverting transistor T54j is electrically connected to the first pull-up node QB1[n], a first electrode T54jS of the fourth inverting transistor T54j is electrically connected to the first low potential signal line VGL1, and a second electrode T54jD of the fourth inverting transistor T54j is electrically connected to the first pull-down node Qb1[n]. A gate T55jG of the fifth inverting transistor T55j is electrically connected to a cascade output terminal Cout[n-2] of a second previous-stage of first type gate driving circuit 22a, a first electrode T55jS of the fifth inverting transistor T55j is electrically connected to the first low potential signal line VGL1, and a second electrode T55jD of the fifth inverting transistor T55j is electrically connected to the first pull-down node QB1[n].

The first inverting transistor T51j and the second inverting transistor T52j are arranged in the second direction, the third inverting transistor T53j and the fourth inverting transistor T54j are arranged in the second direction, and the second inverting transistor T52j, the fourth inverting transistor T54j, and the fifth inverting transistor T55j are arranged in the first direction. By arranging the first inverting transistor T51j and the second inverting transistor T52j in the second direction, and arranging the third inverting transistor T53j and the fourth inverting transistor T54j in the second direction, it is possible to reduce a horizontal space occupied by the first inverting module 315, thereby narrowing the frame of the display panel 2.

In some embodiments, as shown in FIG. 5 and FIG. 24 to FIG. 29, the first inverting transistor T51j includes a first inverting sub-transistor T51j1 and a second inverting sub-transistor T51j2. A gate T51j1G and a first electrode T51j1S of the first inverting sub-transistor T51j1 are electrically connected to the low frequency signal line LC, and a second electrode T51j1D of the first inverting sub-transistor T51j1 is electrically connected to a first electrode of the second inverting sub-transistor T51j2. A gate T51j2G of the second inverting sub-transistor T51j2 is electrically connected to to the low frequency signal line LC, and a second electrode T51j2D of the second inverting sub-transistor T51j2 is electrically connected to the second electrode T52jD of the second inverting transistorr T52j.

The first inverting sub-transistor T51j1 and the second inverting sub-transistor T51j2 are arranged in the first direction. By configuring the first inverting transistor T51j to include the first inverting sub-transistor T51j1 and the second inverting sub-transistor T51j2, the performance of the first inverting transistor T51j can be improved.

In some embodiments, as shown in FIG. 5 and FIG. 24 to FIG. 29, the first pull-down maintenance module 314 includes a first pull-down maintenance transistor T42j. A gate T42jG of the first pull-down maintenance transistor T42j is electrically connected to a first pull-down node QB1[n] of the first type gate driving circuit, a first electrode T42jS of the first pull-down maintenance transistor T42j is electrically connected to the first low potential signal line VGL1, and a second electrode T42jD of the first pull-down maintenance transistor T42j is electrically connected to the first pull-up node Q1[n].

In the second direction, the first pull-down maintenance transistor T42j is disposed between the fourth inverting transistor T54j and the second pull-up control transistor T12j. Therefore, it is possible to reduce a horizontal space occupied by the first pull-down maintenance transistor T42j disposed between the fourth inverting transistor T54j and the second pull-up control transistor T12j, and to narrow the frame of the display panel 2.

In some embodiments, as shown in FIG. 5 and FIG. 24 to FIG. 29, the first pull-down maintenance transistor T42j includes a first pull-down maintenance sub-transistor T42j 1 and a second pull-down maintenance sub-transistor T42j2. A gate T42j2G of the second pull-down maintenance sub-transistor T42j2 is electrically connected to the first pull-down node QB1[n], a first electrode T42j2S of the second pull-down maintenance sub-transistor T42j2 is electrically connected to the first low potential signal line VGL1, and a second electrode T42j2D of the second pull-down maintenance sub-transistor T42j2 is electrically connected to a first electrode T42j1S of the first pull-down maintenance sub-transistor T42j1 at the first internal node N1[n]. A gate T42j1G of the first pull-down maintenance sub-transistor T42j1 is electrically connected to the first pull-down node Qb1[n], and a second electrode of the first pull-down maintenance sub-transistor T42j1 is electrically connected to the first pull-up node Q1[n].

The first pull-down maintenance sub-transistor T42j1 and the second pull-down maintenance sub-transistor T42j2 are arranged in the second direction. By configuring the first pull-down maintenance transistor T42j to include the first pull-down maintenance sub-transistor T42j1 and the second pull-down maintenance sub-transistor T42j2, the performance of the first pull-down maintenance transistor T42j can be improved, and the first pull-down maintenance sub-transistor T42j1 and the second pull-down maintenance sub-transistor T42j2 are arranged in the second direction, so that a horizontal space occupied by the first pull-down maintenance transistor T42j can be reduced, and the frame of the display panel 2 can be narrowed.

In some embodiments, as shown in FIG. 5 and FIG. 24 to 29, the first reset module 317 includes a first reset transistor T43j. A gate T43jG of the first reset transistor T43j is electrically connected to the first reset control line VST1 of the display panel, a first electrode T43jS of the first reset transistor T43j is electrically connected to the first low potential signal line VGL1. and a second electrode T43jD of the first reset transistor T43j is electrically connected to the first pull-up node Q1[n].

The first reset transistor T43j is disposed between the second inverting transistor T52j and the third pull-up control transistor T81j. By arranging the first reset transistor T43j between the second inverting transistor T52j and the third pull-up control transistor T81j, a horizontal space occupied by the first reset transistor T43j, the second inverting transistor T52j, and the third pull-up control transistor T81j is reduced, thereby narrowing the frame of the display panel 2.

In some embodiments, as shown in FIG. 5 and FIG. 24 to FIG. 29, the first reset transistor T43j includes a first reset sub-transistor T43j1 and a second reset sub-transistor T43j2. A gate T43j1G of the second reset sub-transistor T43j2 is electrically connected to the first reset control line VST1, a first electrode of the second reset sub-transistor T43j2 is electrically connected to the first low potential signal line VGL1, and a second electrode T43j2D of the first second reset sub-transistor T43j2 is electrically connected to a first electrode T43j1S of the first reset sub-transistor T43j1 at the first internal node N1[n]. A gate T43j1G of the first reset sub-transistor T43j1 is electrically connected to the first reset control line VST1, and a second electrode T43j1D of the first reset sub-transistor T43j1 is electrically connected to the first pull-up node Q1[n].

The first reset sub-transistor T43j1 and the second reset sub-transistor T43j2 are arranged in the second direction. By configuring the first reset transistor T43j to include the first reset sub-transistor T43j1 and the second reset sub-transistor T43j2, the performance of the first reset transistor T43j can be improved, and the first reset sub-transistor T43j1 and the second reset sub-transistor T43j2 are arranged in the second direction, so that a horizontal space occupied by the first reset transistor T43j can be reduced, and the frame of the display panel 2 can be narrowed.

In some embodiments, as shown in FIG. 5 and FIG. 24 to FIG. 29, the first anti negative-bias module 316 includes a first anti negative-bias transistor T71j. A gate T71jG of the first anti negative-bias transistor T71j is electrically connected to the first pull-up node Q1[n], a first electrode T71jS of the first anti negative-bias transistor T71j is electrically connected to the first high potential signal line VGH1, and a second electrode T71jD of the first anti negative-bias transistor T71j is electrically connected to the first internal node N1[n].

The first anti negative-bias transistor T71j is disposed between the first reset transistor T43j and the third pull-up control transistor T81j in the second direction. By arranging the first anti negative-bias transistor T71j between the first reset transistor T43j and the third pull-up control transistor T81j in the second direction, a horizontal area occupied by the first anti negative-bias module 316 can be reduced, and the frame of the display panel 2 can be narrowed.

In some embodiments, as shown in FIG. 5 and FIG. 24 to FIG. 29, the first anti negative-bias transistor T71j includes a first anti negative-bias sub-transistor T71j1 and a second anti negative-bias sub-transistor T71j2. A gate T71j2G of the second anti negative-bias sub-transistor T71j2 is electrically connected to the first pull-up node Q1[n], a first electrode T71j2S of the second anti negative-bias sub-transistor T71j2 is electrically connected to the first high potential signal line, and a second electrode T71j2D of the second anti negative-bias sub-transistor T71j2 is electrically connected to a first electrode of the first anti negative-bias sub-transistor T71j1. A gate T71j1G of the first anti negative-bias sub-transistor T71j1 is electrically connected to the first pull-up node Q1[n], and a second electrode T71j1D of the first anti negative-bias sub-transistor T71j 1 is electrically connected to the first internal node N1[n].

The first anti negative-bias sub-transistor T71j1 and the second anti negative-bias sub-transistor T71j2 are arranged in the second direction. By configuring the first anti negative-bias transistor T71j include the first anti negative-bias sub-transistor T71j 1 and the second anti negative-bias sub-transistor T71j2, the performance of the first anti negative-bias transistor T71j can be improved, and the first anti negative-bias sub-transistor T71j 1 and the second anti negative-bias sub-transistor T71j2 are arranged in the second direction, so that a horizontal space occupied by the first anti negative-bias transistor T71j can be reduced, and the frame of the display panel 2 can be narrowed.

In some embodiments, as shown in FIG. 5, FIG. 8, and FIG. 24 to FIG. 29, the second clock signal line CKB includes a first group of sub-lines CKBi and a second group of sub-lines CKBj. The first pull-up module 312 includes a first pull-up transistor T21j, a second pull-up transistor T22j, and a third pull-up transistor T23j. A gate T21jG of the first pull-up transistor T21j is electrically connected to the first pull-up node Q1[n], a first electrode T21jS of the first pull-up transistor T21j is electrically connected to the first clock signal line CKA, and a second electrode T21jD of the first pull-up transistor T21j is electrically connected to a cascade output terminal Cout[n] of the current stage of first type gate driving circuit 22a. A gate T22jG of the second pull-up transistor T22j is electrically connected to the first pull-up node Q1[n], a first electrode T22jS of the second pull-up transistor T22j is electrically connected to the first group of sub-lines CKBi, and a second electrode T22jD of the second pull-up transistor T22j is electrically connected to a first signal output terminal Gn[m] of another stage of first type gate driving circuit 22a. A gate T23jG of the third pull-up transistor T23j is electrically connected to the first pull-up node Q1[n], a first electrode T23jS of the third pull-up transistor T23j is electrically connected to the second group of sub-lines CKBj, and a second electrode T23jD of the third pull-up transistor T23j is electrically connected to a first signal output terminal Gn[n] of the current stage of first type gate driving circuit 22a.

The first pull-up transistor T21j and the second pull-down transistor T32j are arranged in the second direction Y, the second pull-up transistor T22j and the third pull-up transistor T23j are arranged in the second direction Y, and the first pull-up transistor T21j and the second pull-up transistor T22j are arranged in the first direction X. By arranging the first pull-up transistor T21j and the second pull-down transistor T32j in the second direction Y, and arranging the second pull-up transistor T22j and the third pull-up transistor T23j in the second direction Y, a horizontal area occupied by the first pull-down module and the first pull-up module can be reduced, and the frame of the display panel 2 can be narrowed.

In some embodiments, as shown in FIG. 5 and FIG. 24 to FIG. 29, the first inverting transistor T51j, the second inverting transistor T52j, the first reset transistor T43j, the first anti negative-bias transistor T71j, and the third pull-up control transistor T81j are arranged in the second direction Y.

The third inverting transistor T53j, the fourth inverting transistor T54j, the fourth pull-down transistor T42j, the second pull-up control transistor T12j, and the first pull-up control transistor T11j are arranged in the second direction.

The fifth inverting transistor T55j, the first pull-down transistor T31j, the fourth pull-down transistor T41j, the second pull-up control transistor T12j, and the first pull-up control transistor T11j are arranged in the second direction Y.

The second inverting transistor T52j, the fourth inverting transistor T54j, the fifth inverting transistor T55j, the first pull-up transistor T21j, and the second pull-up transistor T22j are arranged in the first direction X. Therefore, different transistors can be arranged in the second direction, the horizontal space occupied by the first type gate driving circuit is reduced, and the frame of the display panel is narrowed.

In some embodiments, as shown in FIG. 5, the first type gate driving circuit 22a further includes a first capacitor C1. A plate of the first capacitor C1 is electrically connected to the first pull-up node Q1[n], and another plate of the first capacitor C1 is electrically connected to the cascade output terminal Cout[n] of the current stage of first type gate driving circuit 22a.

Specifically, the first capacitor includes a first plate of the first capacitor and a second plate of the first capacitor. The first plate of the first capacitor includes a first portion of the first plate of the first capacitor and a second portion of the first plate of the first capacitor.

In some embodiments, as shown in FIG. 24 and FIG. 25, the display panel 2 includes the light-shielding layer 212, and the light-shielding layer includes a first shielding connection line LS1, a second shielding connection line LS2, the cascade output terminal Cout[n] of the current stage of first type gate driving circuit 22a, and the first portion C1a1 of the first plate C1a of the first capacitor C1.

In some embodiments, as shown in FIG. 24 and FIG. 26, the display panel 2 includes the active layer 216. The active layer 216 includes an active portion T11jA of the first pull-up control transistor T11j, an active portion T12jA of the second pull-up control transistor T12j, an active portion T81jA of the third pull-up control transistor T81j, an active portion T21jA of the first pull-up transistor T21j, an active portion T22jA of the second pull-up transistor T22j, an active portion T23jA of the third pull-up transistor T23j, an active portion T31jA of the first pull-down transistor T31j, an active portion T32jA of the second pull-down transistor T32j, an active portion T33jA of the third pull-down transistor T33j, an active portion T41jA of the fourth pull-down transistor T41j, an active portion T42jA of the first pull-down maintenance transistor T42j, an active portion T51jA of the first inverting transistor T51j, an active portion T52jA of the second inverting transistor T52j, an active portion T53jA of the third inverting transistor T53j, an active portion T54jA of the fourth inverting transistor T54j, an active portion T55jA of the fifth inverting transistor T55j, an active portion T43jA of the first reset transistor T43j, and an active portion T71jA of the first anti negative-bias transistor T71j.

The active portion T51jA of the first inverting transistor T51j, the active portion T52jA of the second inverting transistor T52j, the active portion T43jA of the first reset transistor T43j, the active portion T71jA of the first anti negative-bias transistor T71j, and the active portion T81jA of the third pull-up control transistor T81j are sequentially arranged in the second direction Y.

The active portion T53jA of the third inverting transistor T53j, the active portion T54jA of the fourth inverting transistor T54j, the active portion T42jA of the first pull-down maintenance transistor T42j, the active portion T12jA of the second pull-up control transistor T12j, and the active portion T11jA of the first pull-up control transistor T11j are sequentially arranged in the second direction Y.

The active portion T55jA of the fifth inverting transistor T55j, the active portion T31jA of the first pull-down transistor T31j, the active portion T41jA of the fourth pull-down transistor T41j, the active portion T12jA of the second pull-up control transistor T12j, and the active portion T11jA of the first pull-up control transistor T11j are sequentially arranged in the second direction Y.

The active portion T21jA of the first pull-up transistor T21j, the active portion T33jA of the third pull-down transistor T33j, and the active portion T32jA of the second pull-down transistor T32j are sequentially arranged in the second direction.

The active portion T22jA of the second pull-up transistor T22j and the active portion T23jA of the third pull-up transistor T23j are sequentially arranged in the second direction.

The active portion T52jA of the second inverting transistor T52j, the active portion T54jA of the fourth inverting transistor T54j, the active portion T55jA of the fifth inverting transistor T55j, the active portion T21jA of the first pull-up transistor T21j, and the active portion T22jA of the second pull-up transistor T22j are sequentially arranged in the first direction.

Specifically, as shown in FIG. 26, the active portion T81jA of the third pull-up control transistor T81j includes an active portion T81j1A of the first pull-up control sub-transistor T81j1 and an active portion T81j2A of the second pull-up control sub-transistor T81j2. The active portion T81j1A of the first pull-up control sub-transistor T81j1 and the active portion T81j2A of the second pull-up control sub-transistor T81j2 are arranged sequentially in the second direction.

Specifically, as shown in FIG. 26, the active portion T41jA of the fourth pull-down transistor T41j includes an active portion T41j1A of the first pull-down sub-transistor T41j1 and an active portion T41j2A of the second pull-down sub-transistor T41j2. The active portion T41j1A of the first pull-down sub-transistor T41j1 and the active portion T41j2A of the second pull-down sub-transistor T41j2 are arranged in the second direction.

Specifically, as shown in FIG. 26, the active portion T42jA of the first pull-down maintenance transistor T42j includes an active portion T42j1A of the first pull-down maintenance sub-transistor T42j1 and an active portion T42j2A of the second pull-down maintenance sub-transistor T42j2. The active portion T42j1A of the first pull-down maintenance sub-transistor T42j1 and the active portion T42j2A of the second pull-down maintenance sub-transistor T42j2 are arranged in the second direction.

Specifically, as shown in FIG. 26, the active portion T43jA of the first reset transistor T43j includes an active portion T43j1A of the first reset sub-transistor T43j1 and an active portion T43j1A of the second reset sub-transistor T43j2. The active portion T43j1A of the first reset sub-transistor T43j1 and the active portion T43j1A of the second reset sub-transistor T43j2 are arranged in the second direction.

Specifically, as shown in FIG. 26, the active portion T51jA of the first inverting transistor T51j includes an active portion T51j1A of the first inverting sub-transistor T51j1 and an active portion T51j2A of the second inverting sub-transistor T51j2. The active portion T51j1A of the first inverting sub-transistor T51j1 and the active portion T51j2A of the second inverting sub-transistor T51j2 are arranged in the first direction.

Specifically, as shown in FIG. 26, the active portion T71jA of the first anti negative-bias transistor T71j includes an active portion T71j1A of the first anti negative-bias sub-transistor T71j1 and an active portion T71j2A of the second anti negative-bias sub-transistor T71j2. The active portion T71j1A of the first anti negative-bias sub-transistor T71j1 and the active portion T71j2A of the second anti negative-bias sub-transistor T71j2 are arranged in the first direction.

In some embodiments, as shown in FIG. 24 and FIG. 27, the display panel 2 includes the first gate layer 218. The first gate layer 218 includes the gate T11jG of the first pull-up control transistor T11j, the gate T12jG of the second pull-up control transistor T12j, the gate T81jG of the third pull-up control transistor T81j, the gate T21jG of the first pull-up transistor T21j, the gate T22jG of the second pull-up transistor T22j, the gate T23jG of the third pull-up transistor T23j, the gate T31jG of the first pull-down transistor T31j, the gate T32jG of the second pull-down transistor T32j, the gate T33jG of the third pull-down transistor T33j, the gate T41jG of the fourth pull-down transistor T41j, the gate T42jG of the first pull-down maintenance transistor T42j, the gate T51jG of the first inverting transistor T51j, the gate T52jG of the second inverting transistor T52j, the gate T53jG of the third inverting transistor T53j, the gate T54jG of the fourth inverting transistor T54j, the gate T55jG of the fifth inverting transistor T55j, the gate T43jG of the first reset transistor T43j, the gate T71jG of the first anti negative-bias transistor T71j, a second plate C1b of the first capacitor C1, and a first gate connection line LE1.

The gate T51jG of the first inverting transistor T51j, the gate T52jG of the second inverting transistor T52j, the gate T43jG of the first reset transistor T43j, the gate T71jG of the first anti negative-bias transistor T71j, and the gate T81jG of the third pull-up control transistor T81j are arranged in the first direction Y.

The gate T53jG of the third inverting transistor T53j, the gate T54jG of the fourth inverting transistor T54j, the gate T42jG of the first pull-down maintenance transistor T42j, the gate T12jG of the second pull-up control transistor T12j, and the gate T11jG of the first pull-up control transistor T11j are arranged in the second direction Y.

The gate T55jG of the fifth inverting transistor T55j, the gate T31jG of the first pull-down transistor T31j. the gate T41jG of the fourth pull-down transistor T41j, the gate T12jG of the second pull-up control transistor T12j, and the gate T11jG of the first pull-up control transistor T11j are arranged in the second direction Y.

The gate T21jG of the first pull-up transistor T21j, a part of the second plate C1b of the first capacitor C1, the gate T33jG of the third pull-down transistor T33j, and the gate T32jG of the second pull-down transistor T32j are sequentially arranged in the second direction Y.

The gate T22jG of the second pull-up transistor T22j and the gate T23jG of the third pull-up transistor T23j are sequentially arranged in the second direction Y.

The gate T52jG of the second inverting transistor T52j, the gate T54jG of the fourth inverting transistor T54j, the gate T55jG of the fifth inverting transistor T55j, the gate T21jG of the first pull-up transistor T21j, another part of the second plate C1b of the first capacitor C1, and the gate T22jG of the second pull-up transistor T22j are sequentially arranged in the first direction X.

Specifically, as shown in FIG. 27, the gate T81jG of the third pull-up control transistor T81j includes the gate T81j1G of the first pull-up control sub-transistor T81j1 and the gate T81j2G of the second pull-up control sub-transistor T81j2. The gate T81j1G of the first pull-up control sub-transistor T81j1 and the gate T81j2G of the second pull-up control sub-transistor T81j2 are arranged sequentially in the second direction.

Specifically, as shown in FIG. 27, the gate T41jG of the fourth pull-down transistor T41j includes the gate T41j1G of the first pull-down sub-transistor T41j1 and the gate T41j2G of the second pull-down sub-transistor T41j2. The gate T41j1G of the first pull-down sub-transistor T41j1 and the gate T41j2G of the second pull-down sub-transistor T41j2 are arranged in the second direction.

Specifically, as shown in FIG. 27, the gate T42jG of the first pull-down maintenance transistor T42j includes the gate T42j1 G of the first pull-down maintenance sub-transistor T42j1 and the gate T42j2G of the second pull-down maintenance sub-transistor T42j2. The gate T42j1G of the first pull-down maintenance sub-transistor T42j1 and the gate T42j2G of the second pull-down maintenance sub-transistor T42j2 are arranged in the second direction.

Specifically, as shown in FIG. 27, the gate T43jG of the first reset transistor T43j includes the gate T43j1G of the first reset sub-transistor T43j1 and the gate T43j1G of the second reset sub-transistor T43j2. The gate T43j1G of the first reset sub-transistor T43j1 and the gate T43j1G of the second reset sub-transistor T43j2 are arranged in the second direction.

Specifically, as shown in FIG. 27, the gate T51jG of the first inverting transistor T51j includes the gate T51j1G of the first inverting sub-transistor T51j1 and the gate T51j2G of the second inverting sub-transistor T51j2. The gate T51j1G of the first inverting sub-transistor T51j1 and the gate T51j2G of the second inverting sub-transistor T51j2 are arranged in the first direction.

Specifically, as shown in FIG. 27, the gate T71jG of the first anti negative-bias transistor T71j includes the gate T71j1G of the first anti negative-bias sub-transistor T71j1 and the gate T71j2G of the second anti negative-bias sub-transistor T71j2. The gate T71j1G of the first anti negative-bias sub-transistor T71j1 and the gate T71j2G of the second anti negative-bias sub-transistor T71j2 are arranged in the first direction.

In some embodiments, as shown in FIG. 24 and FIG. 28, the display panel 2 includes the first source and drain layer 221. The first source and drain layer 221 includes the first electrode T11jS of the first pull-up control transistor T11j, the first electrode T12jS of the second pull-up control transistor T12j, the first electrode T81jS of the third pull-up control transistor T81j, the first electrode T21jS of the first pull-up transistor T21j, the first electrode T22jS of the second pull-up transistor T22j, the first electrode T23jS of the third pull-up transistor T23j, the first electrode T31jS of the first pull-down transistor T31j, the first electrode T32jS of the second pull-down transistor T32j, the first electrode T33jS of the third pull-down transistor T33j, the first electrode T41jS of the fourth pull-down transistor T41j, the first electrode T42jS of the first pull-down maintenance transistor T42j, the first electrode T51jS of the first inverting transistor T51j, the first electrode T52jS of the second inverting transistor T52j, the first electrode T53jS of the third inverting transistor T53j, the first electrode T54jS of the fourth inverting transistor T54j, the first electrode TSSjS of the fifth inverting transistor T55j, the first electrode T43jS of the first reset transistor T43j, the first electrode T71jS of the first anti negative-bias transistor T71j, the second electrode T11jD of the first pull-up control transistor T11j, the second electrode T12jD of the second pull-up control transistor T12j, the second electrode T81jD of the third pull-up control transistor T81j, the second electrode T21jD of the first pull-up transistor T21j, the second electrode T22jD of the second pull-up transistor T22j, the second electrode T23jD of the third pull-up transistor T23j, the second electrode T31jD of the first pull-down transistor T31j, the second electrode T32jD of the second pull-down transistor T32j, the second electrode T33jD of the third pull-down transistor T33j, the second electrode T41jD of the fourth pull-down transistor T41j, the second electrode T42jD of the first pull-down maintenance transistor T42j, the second electrode T51jD of the first inverting transistor T51j, the second electrode T52jD of the second inverting transistor T52j, the second electrode T53jD of the third inverting transistor T53j, the second electrode T54jD of the fourth inverting transistor T54j, the second electrode T55jD of the fifth inverting transistor T55j, the second electrode T43jD of the first reset transistor T43j, the second electrode T71jD of the first anti negative-bias transistor T71j, the second portion C1a2 of the first plate C1a of the first capacitor C1, a first source connection line LD1, a second source connection line LD2, a third source connection line LD3, a fourth source connection line LD4, and a fifth source connection line LD5.

The first electrode T51jS of the first inverting transistor T51j, the first electrode T52jS of the second inverting transistor T52j, the first electrode T43jS of the first reset transistor T43j, the first electrode T71jS of the first anti negative-bias transistor T71j, and the first electrode T81jS of the third pull-up control transistor T81j are sequentially arranged in the second direction Y.

The first electrode T53jS of the third inverting transistor T53j, the first electrode T54jS of the fourth inverting transistor T54j, the first electrode T42jS of the first pull-down maintenance transistor T42j, the first electrode T12jS of the second pull-up control transistor T12j, and the first electrode T11jS of the first pull-up control transistor T11j are sequentially arranged in the second direction Y.

The first electrode T55jS of the fifth inverting transistor T55j, the first electrode T31jS of the first pull-down transistor T31j, the first electrode T41jS of the fourth pull-down transistor T41j, the first electrode T12jS of the second pull-up control transistor T12j, and the first electrode T11jS of the first pull-up control transistor T11j are sequentially arranged in the second direction Y.

The first electrode T21jS of the first pull-up transistor T21j, the first electrode T33jS of the third pull-down transistor T33j, and the first electrode T32jS of the second pull-down transistor T32j are sequentially arranged in the second direction Y.

The first electrode T22jS of the second pull-up transistor T22j and the first electrode T23jS of the third pull-up transistor T23j are sequentially arranged in the second direction Y.

The first electrode T52jS of the second inverting transistor T52j, the first electrode T54jS of the fourth inverting transistor T54j, the first electrode TSSjS of the fifth inverting transistor T55j, the first electrode T21jS of the first pull-up transistor T21j, and the first electrode T22jS of the second pull-up transistor T22j are sequentially arranged in the first direction.

The second source connection line LD2 connects the gate T55jG of the fifth inverting transistor T55j to the cascade signal terminal Cout[n-2] of the second previous-stage of first type gate driving circuit 22a. The third source connection line LD3 connects the gate T32jG of the second pull-down transistor T32j to a first shielding connection line LS1. The first shielding connection line LS1 connects to the second electrode T55jD of the fifth inverting transistor T55j. The fourth source connection line LD4 connects the gate T41jG of the fourth pull-down transistor T41j to the cascade signal terminal Cout[n+2] of the second subsequent-stage of first type gate driving circuit 22a. A second shielding connection line LS2 connects the first electrode TSSjS of the fourth inverting transistor T54j to the first electrode T31jS of the first pull-down transistor T31j.

Specifically, in the circuit diagram in the embodiments of the present application, in order to explain the connection relationship of each transistor, each transistor includes a gate, a first electrode, and a second electrode. However, during the actual design process, to reduce the space occupied by the transistors, electrodes of some transistors may be formed using the same structure. For example, the first electrode of the first pull-up control sub-transistor T81j1 and the second electrode T81j2D of the second pull-up control sub-transistor T81j2 may be formed using the same structure. Therefore, in the diagram, only the second electrode T81j2D of the second pull-up control sub-transistor T81j2 is identified, and it is understandable that this structure also serves as the first electrode of the first pull-up control sub-transistor T81j1. Similarly, structures of the electrodes of other transistors can be determined.

Specifically, as shown in FIG. 24 to FIG. 29, the first portion C1a1 of the first plate C1a of the first capacitor C1 is connected to the second portion C1a2 of the first plate C1a of the first capacitor C1.

Specifically, as shown in FIG. 24 to FIG. 29, the first plate of the first capacitor C1 includes the first portion of the first plate of the first capacitor C1 and the second portion of the first plate of the first capacitor C1.

Specifically, as shown in FIG. 28, the first source and drain layer 221 includes the first electrode of the first pull-up control sub-transistor T81j1, the second electrode T81j1D of the first pull-up control sub-transistor T81j1, the first electrode T81j2S of the second pull-up control sub-transistor T81j2, and the second electrode T81j2D of the second pull-up control sub-transistor T81j2. The first electrode T81j2S of the second pull-up control sub-transistor T81j2, and the second electrode T81j2D of the second pull-up control sub-transistor T81j2, and the second electrode T81j1D of the first pull-up control sub-transistor T81j1 are sequentially arranged in the second direction.

Specifically, as shown in FIG. 28, the first source and drain layer 221 includes the first electrode T41j1S of the first pull-down sub-transistor T41j1, the second electrode T41j1D of the first pull-down sub-transistor T41j1, the first electrode T41j2S of the second pull-down sub-transistor T41j2, and the second electrode T41j2D of the second pull-down sub-transistor T41j2. The second electrode T41j2D of the second pull-down sub-transistor T41j2, the first electrode T41j2S of the second pull-down sub-transistor T41j2, and the second electrode T41j1D of the first pull-down sub-transistor T41j1 are sequentially arranged in the second direction.

Specifically, as shown in FIG. 28, the first source and drain layer 221 includes the first electrode T42j1S of the first pull-down maintenance sub-transistor T42j1, the second electrode of the first pull-down maintenance sub-transistor T42j1, the first electrode T42j2S of the second pull-down maintenance sub-transistor T42j2, and the second electrode T42j2D of the second pull-down maintenance sub-transistor T42j2. The second electrode T42j2D of the second pull-down maintenance sub-transistor T42j2, the first electrode T42j2S of the second pull-down maintenance sub-transistor T42j2, and the first electrode T42j1S of the first pull-down maintenance sub-transistor T42j1 are sequentially arranged in the second direction.

Specifically, as shown in FIG. 28, the first source and drain layer 221 includes the first electrode T43j1S of the first reset sub-transistor T43j1, the second electrode T43j1D of the first reset sub-transistor T43j1, the first electrode of the second reset sub-transistor T43j2, and the second electrode T43j1D of the second reset sub-transistor T43j2. The second electrode T43j1D of the second reset sub-transistor T43j2, the first electrode of the second reset sub-transistor T43j2, and the second electrode T43j1D of the first reset sub-transistor T43j1 are sequentially arranged in the second direction.

Specifically, as shown in FIG. 28, the first source and drain layer 221 includes the first electrode T51j1S of the first inverting sub-transistor T51j1, the second electrode T51j1D of the first inverting sub-transistor T51j1, the first electrode of the second inverting sub-transistor T51j2, and the second electrode T51j2D of the second inverting sub-transistor T51j2. The first electrode T51j1S of the first inverting sub-transistor T51j1, the second electrode T51j11D of the first inverting sub-transistor T51j1, and the second electrode T51j2D of the second inverting sub-transistor T51j2 are sequentially arranged in the first direction.

Specifically, as shown in FIG. 28, the first source and drain layer 221 includes the first electrode of the first anti negative-bias sub-transistor T71j1, the second electrode T71j1D of the first anti negative-bias sub-transistor T71j1, the first electrode T71j2S of the second anti negative-bias sub-transistor T71j2, and the second electrode T71j2D of the second anti negative-bias sub-transistor T71j2. The first electrode T71j2S of the second anti negative-bias sub-transistor T71j2, the second electrode T71j2D of the second anti negative-bias sub-transistor T71j2, and the second electrode T71j1D of the first anti negative-bias sub-transistor T71j1 are sequentially arranged in the first direction.

In some embodiments, as shown in FIG. 24 and FIG. 29, the second clock signal line CKB includes the first group of sub-lines CKBi and the second group of sub-lines CKBj. The display panel 2 includes the second source and drain layer 223. The second source and drain layer 223 includes the first reset control line VST1, the low frequency control line LC, the first clock signal line CKA, the first low potential signal line VGL1, the second clock signal line CKB, and the second low potential signal line VGL2.

The first reset control line VST1, the low frequency control line LC, the first clock signal line CKA, the first low potential signal line VGL1, the first group of sub-lines CKBi, the second low potential signal line VGL2, and the second group of sub-lines CKBj are arranged in the first direction X.

The first reset control line VST1 is connected to the gate T43jG of the first reset transistor T43j through the first source connection line LD1. The second low potential signal line VGL2 is connected to the first gate connection line LE1 through the fifth source connection line LD5. The first gate connection line LE1 is connected to the first electrode T32jS of the second pull-down transistor T32j.

In some embodiments, as shown in FIG. 6 and FIG. 30, the second type gate driving circuit 22b includes a second pull-up control module 321, a second pull-up module 322, a second pull-down module 323, a second pull-down maintenance module 324, a second inverting module 325, a second anti negative-bias module 326, and a second reset module 327. The second pull-up control module 321 is electrically connected to the second pull-up module 322 at a second pull-up node Q2[n]. The second pull-down module 323 is electrically connected to the second pull-up node Q2[n] and a second signal output terminal INI[n] of a current stage of second type gate driving circuit 22b. The second pull-down maintenance module 324 is electrically connected between the second pull-up node Q2[n] and the second low potential signal line VGL2. The second inverting module 325 is electrically connected to the second pull-up node Q2[n], the second low potential signal line VGL2, and the low frequency signal line LC. The second anti negative-bias module 326 is electrically connected between the first high potential signal line VGH1 and the second pull-up node Q2[n]. The second reset module 327 is electrically connected between the second pull-up node Q2[n] and the second low potential signal line VGL2.

In some embodiments, as shown in FIG. 6 and FIG. 30, at least two of the second pull-up control module 321, the second pull-up module 322, the second pull-down module 323, the second pull-down maintenance module 324, the second inverting module 325, the second anti negative-bias module 326, and the second reset module 327 are arranged in the second direction, and an included angle between the first direction and the second direction is greater than 0 degree and is less than or equal to 90 degrees. By arranging at least two of the second pull-up control module 321, the second pull-up module 322, the second pull-down module 323, the second pull-down maintenance module 324, the second inverting module 325, the second anti negative-bias module 326, and the second reset module 327 in the second direction, a horizontal space occupied by the second type gate driving circuit 22b can be reduced, thereby reducing the horizontal space occupied by the gate driving circuit 22 and narrowing the frame of the display panel 2.

Specifically, compared to an horizontal arrangement of various modules of the comparative display device, in the embodiments of the present application, at least two of the modules in the second type gate driving circuit 22b are arranged in the second direction, so that the horizontal space occupied by the second type gate driving circuit 22b can be reduced, the horizontal space occupied by the gate driving circuit 22 can be reduced, and the frame of the display panel 2 can be narrowed.

In some embodiments, as shown in FIG. 6 and FIG. 30, a part of the second pull-up control module 321, a part of the second inverting module 325, the second anti negative-bias module 326, and the second reset module 327 are arranged in the second direction Y. By arranging a part of the second pull-up control module 321, a part of the second inverting module 325, the second anti negative-bias module 326, and the second reset module 327 in the second direction Y, a horizontal space occupied by the second pull-up control module 321, the second inverting module 325, the second anti negative-bias module 326, and the second reset module 327 can be reduced, the horizontal space occupied by the second type gate driving circuit 22b can be reduced, and the horizontal space occupied by the gate driving circuit 22 can be reduced, thereby narrowing the frame of the display panel 2.

Specifically, as shown in FIG. 30, it can be seen that in the second direction, a part of the second inverting module 325, the second reset module 327, the second anti negative-bias module 326, and a part of the second pull-up control module 321 are arranged in the second direction Y.

In some embodiments, as shown in FIG. 6 and FIG. 30, another part of the second pull-up control module 321, another part of the second inverting module 325, and the second pull-down maintenance module 324 are arranged in the second direction Y. By arranging another part of the second pull-up control module 321, another part of the second inverting module 325, and the second pull-down maintenance module 324 in the second direction Y, a horizontal space occupied by the second pull-up control module 321, the second inverting module 325, and the second pull-down maintenance module 324 can be reduced, the horizontal space occupied by the second type gate driving circuit 22b can be reduced, and the horizontal space occupied by the gate driving circuit 22 can be reduced, thereby narrowing the frame of the display panel 2.

Specifically, as shown in FIG. 30. it can be seen that another part of the second pull-up control module 321, the second pull-down maintenance module 324, and another part of the second inverting module 325 are sequentially arranged in the second direction Y.

In some embodiments, as shown in FIG. 6 and FIG. 30, another part of the second pull-up control module 321, another part of the second inverting module 325, and the second pull-down module 323 are arranged in the second direction Y. The second reset module 327, the second pull-down maintenance module 324, a part of the second pull-down module 323, and the second pull-up module 322 are arranged in the first direction X.

In some embodiments, as shown in FIG. 6 and FIG. 30 to FIG. 35, the second pull-up control module 321 includes a fourth pull-up control transistor T11i, a fifth pull-up control transistor T12i, and a sixth pull-up control transistor T81i. A gate T11iG of the fourth pull-up control transistor T11i is electrically connected to a second signal output terminal INI[n-2] of the second previous-stage of second type gate driving circuit 22b, a first electrode T11iS of the fourth pull-up control transistor T11i is electrically connected to the first high potential signal line VGH1, and a second electrode T11iD of the fourth pull-up control transistor T11i is electrically connected to a first electrode T12iS of the fifth pull-up control transistor T12i. A gate T12iG of the fifth pull-up control transistor T12i is electrically connected to a second signal output terminal INI[n-2] of the second previous-stage of second type gate driving circuit 22b, and a second electrode T12iD of the fifth pull-up control transistor T12i is electrically connected to the second pull-up node Q2[n]. A gate T81iG of the sixth pull-up control transistor T81i is electrically connected to the first high potential signal line VGH1, a first electrode T81iS of the sixth pull-up control transistor T81i is electrically connected to the first high potential signal line VGH1, and a second electrode T81iD of the sixth pull-up control transistor T81i is electrically connected to the second electrode T11iD of the fourth pull-up control transistor T11i.

The fourth pull-up control transistor T11i and the fifth pull-up control transistor T12i are arranged in the second direction Y, and the sixth pull-up control transistor T81i and the fourth pull-up control transistor T11i are arranged in the first direction X. By arranging the fourth pull-up control transistor T11i and the fifth pull-up control transistor T12i in the second direction Y, a space occupied by the second pull-up control module 321 can be reduced, thereby narrowing the frame of the display panel 2.

In some embodiments, as shown in FIG. 6 and FIG. 30 to FIG. 35, the sixth pull-up control transistor T81i includes a third pull-up control sub-transistor T81i1 and a fourth pull-up control sub-transistor T81i2. A gate T81i2G and a first electrode T81i2S of the fourth pull-up control sub-transistor T81i2 are electrically connected to the first high potential signal line VGH1, and a second electrode T81i2D of the fourth pull-up control sub-transistor T81i2 is electrically connected to a first electrode of the third pull-up control sub-transistor T81i1. A gate T81i1G of the third pull-up control sub-transistor T81i1 is electrically connected to the first high potential signal line VGH1, and a second electrode T81i1D of the third pull-up control sub-transistor T81i1 is electrically connected to the second electrode T11iD of the fourth pull-up control transistor T11i.

The third pull-up control sub-transistor T81i1 and the fourth pull-up control sub-transistor T81i2 are arranged in the second direction. By configuring the sixth pull-up control transistor T81i to include the third pull-up control sub-transistor T81i1 and the fourth pull-up control sub-transistor T81i2, the performance of the sixth pull-up control transistor T81i can be improved, and the third pull-up control sub-transistor T81i1 and the fourth pull-up control sub-transistor T81i2 are arranged in the first direction, so that a horizontal area occupied by the sixth pull-up control transistor T81i can be reduced, and the frame of the display panel 2 can be narrowed.

Specifically, the third pull-up control sub-transistor T81i1 and the fourth pull-up control sub-transistor T81i2 may be regarded as two independent transistors, or may be regarded as two sub-transistors of the sixth pull-up control transistor T81i. Similarly, other sub-transistors can refer to the above explanation and will not be elaborated further in the following embodiments.

Specifically, under the condition that one transistor includes a plurality of sub-transistors, the first electrode of the transistor is an electrode connected to the signal line. For example, the sixth pull-up control transistor T81i includes the third pull-up control sub-transistor T81i1 and the fourth pull-up control sub-transistor T81i2, and since the first electrode T81i2S of the fourth pull-up control sub-transistor T81i2 is electrically connected to the first high potential signal line VGH1, the first electrode T81iS of the sixth pull-up control transistor T81i corresponds to the first electrode T81i2S of the fourth pull-up control sub-transistor T81i2. Similarly, first electrodes of other transistors can be determined.

Specifically, the multistage gate driving circuits 22 include multistage second type gate driving circuits 22b. In a first stage of second type gate driving circuit 22b, the gate T11iG of the fourth pull-up control transistor T11i can be connected to a start signal line. In another stage of second type gate driving circuit 22b, the gate T11iG of the fourth pull-up control transistor T11i and the gate T12iG of the fifth pull-up control transistor T12i are electrically connected to a second signal output terminal INI[n-2] of a second previous-stage of second type gate driving circuit 22b. The first electrode T11iS of the fourth pull-up control transistor T11i and the first electrode T12iS of the fifth pull-up control transistor T12i are electrically connected to the first high potential signal line VGH1.

In some embodiments, as shown in FIG. 6 and FIG. 30 to FIG. 35, the second pull-down module 323 includes a fifth pull-down transistor T31i and a sixth pull-down transistor T41i. A gate T31iG of the fifth pull-down transistor T31i is electrically connected to a second pull-down node QB2[n], a first electrode T31iS of the fifth pull-down transistor T31i is electrically connected to the second low potential signal line VGL2, and a second electrode T31iD of the fifth pull-down transistor T31i is electrically connected to the second signal output terminal INI[n] of a current stage of second type gate driving circuit 22b. A gate T41iG of the sixth pull-down transistor T41i is electrically connected to a second signal output terminal INI[n+2] of a second subsequent-stage of second type gate driving circuit 22b, a first electrode T41iS of the sixth pull-down transistor T41i is connected to the second low potential signal line VGL2, and a second electrode T41iD of the sixth pull-down transistor T41i is electrically connected to the second pull-up node Q2[n].

The fifth pull-down transistor T31i and the sixth pull-down transistor T41i are arranged in the second direction Y. By arranging the fifth pull-down transistor T31i and the sixth pull-down transistor T41i in the second direction, a space occupied by the second pull-down module 323 can be reduced, and the frame of the display panel 2 can be narrowed.

In some embodiments, as shown in FIG. 6 and FIG. 30 to FIG. 35, the sixth pull-down transistor T41i includes a third pull-down sub-transistor T41i1 and a fourth pull-down sub-transistor T41i2. A gate T41i2G of the fourth pull-down sub-transistor T41i2 is electrically connected to the second signal output terminal INI[n+2] of the second subsequent-stage of second type gate driving circuit 22b, a first electrode T41i2S of the fourth pull-down sub-transistor T41i2 is electrically connected to the second low potential signal line VGL2, and a second electrode T41i2D of the fourth pull-down sub-transistor T41i2 is electrically connected to the first electrode T41i1S of the third pull-down sub-transistor T41i1 at a second internal node N2[n]. A gate T41i1G of the third pull-down sub-transistor T41i1 is electrically connected to the second signal output terminal INI[n+2] of the second subsequent-stage of second type gate driving circuit 22b, and a second electrode T41i1D of the third pull-down sub-transistor T41i1 is electrically connected to the second pull-up node Q2[n].

The third pull-down sub-transistor T41i1 and the fourth pull-down sub-transistor T41i2 are arranged in the second direction Y. By configuring the sixth pull-down transistor T41i to include the third pull-down sub-transistor T41i1 and the fourth pull-down sub-transistor T41i2, the performance of the sixth pull-down transistor T41i can be improved, and the third pull-down sub-transistor T41i1 and the fourth pull-down sub-transistor T41i2 are arranged in the second direction, a horizontal area occupied by the sixth pull-down transistor T41i can be reduced, and the frame of the display panel 2 can be narrowed.

In some embodiments, as shown in FIG. 6 and FIG. 30 to FIG. 35, the second inverting module 325 includes a sixth inverting transistor T51i, a seventh inverting transistor T52i, an eighth inverting transistor T53i, a ninth inverting transistor T54i, and a tenth inverting transistor T55i. A gate T51iG and a first electrode T51iS of the sixth inverting transistor T51i are electrically connected to the low frequency signal line LC, and a second electrode T51iD of the sixth inverting transistor T51i is electrically connected to a second electrode T52iD of the seventh inverting transistor T52i. A gate T52iG of the seventh inverting transistor T52i is electrically connected to the second pull-up node Q2[n], and a first electrode T52iS of the seventh inverting transistor T52i is electrically connected to the second low potential signal line VGL2. A gate T53iG of the eighth inverting transistor T53i is electrically connected to the second electrode T51iD of the sixth inverting transistor T51i, a first electrode T53iS of the eighth inverting transistor T53i is electrically connected to the low frequency signal line LC, and a second electrode T53iD of the eighth inverting transistor T53i is electrically connected to the second pull-down node QB2[n]. A gate T54iG of the ninth inverting transistor T54i is electrically connected to the second pull-up node Q2[n]., a first electrode T54iS of the ninth inverting transistor T54i is electrically connected to the second low potential signal line VGL2, and a second electrode T54iD of the ninth inverting transistor T54i is electrically connected to the second pull-down node QB2[n]. A gate T55iG of the tenth inverting transistor T55i is electrically connected to the second signal output terminal INI[n-2] of the second previous-stage of second type gate driving circuit 22b, a first electrode T55iS of the tenth inverting transistor T55i is electrically connected to the second low potential signal line VGL2, and a second electrode T55iD of the tenth inverting transistor T55i is electrically connected to the second pull-down node QB2[n].

The sixth inverting transistor T51i and the seventh inverting transistor T52i are arranged in the second direction Y, the eighth inverting transistor T53i and the ninth inverting transistor T54i are arranged in the second direction Y, and the sixth inverting transistor T51i, the eighth inverting transistor T53i, and the tenth inverting transistor T55i are arranged in the first direction X. By arranging the sixth inverting transistor T51i and the seventh inverting transistor T52i in the second direction, and arranging the eighth inverting transistor T53i and the ninth inverting transistor T54i in the second direction, a horizontal space occupied by the second inverting module 325 can be reduced, thereby narrowing the frame of the display panel 2.

In some embodiments, as shown in FIG. 6 and FIG. 30 to FIG. 35, the sixth inverting transistor T51i includes a third inverting sub-transistor T51i1 and a fourth inverting sub-transistor T51i2. A gate T51i1G and a first electrode T51i1S of the third inverting sub-transistor T51i1 are electrically connected to the low frequency signal line LC, and a second electrode T51i1D of the third inverting sub-transistor T51i1 is electrically connected to a first electrode of the fourth inverting sub-transistor T51i2. A gate T51i2G of the fourth inverting sub-transistor T51i2 is electrically connected to the low frequency signal line LC, and a second electrode T51i2D of the fourth inverting sub-transistor T51i2 is electrically connected to the second electrode T52iD of the seventh inverting transistor T52i.

The third inverting sub-transistor T51i1 and the fourth inverting sub-transistor T51i2 are arranged in the first direction X. By configuring the sixth inverting transistor T51i to include the third inverting sub-transistor T51i1 and the fourth inverting sub-transistor T51i2, the performance of the sixth inverting transistor T51i can be improved.

In some embodiments, as shown in FIG. 6 and FIG. 30 to FIG. 35, the sixth inverting transistor T51i and the sixth pull-up control transistor T81i are arranged in the second direction Y, the eighth inverting transistor T53i and the fifth pull-up control transistor T12i are arranged in the second direction Y, and the tenth inverting transistor T55i and the fifth pull-down transistor T31i are arranged in the second direction Y. Thus, a horizontal space occupied by the second inverting module 325, the second pull-up control module 321, and the second pull-down module 323 can be reduced, and the frame of the display panel 2 can be narrowed.

In some embodiments, as shown in FIG. 6 and FIG. 30 to FIG. 35, the second pull-down maintenance module 324 includes a second pull-down maintenance transistor T42i. A gate T42iG of the second pull-down maintenance transistor T42i is electrically connected to a second pull-down node QB2[n], a first electrode T42iS of the second pull-down maintenance transistor T42i is electrically connected to the second low potential signal line VGL2, and a second electrode T42iD of the second pull-down maintenance transistor T42i is electrically connected to the second pull-up node Q2[n].

In the second direction, the second pull-down maintenance transistor T42i is disposed between the ninth inverting transistor T54i and the fifth pull-up control transistor T12i. Thus, a horizontal space occupied by the second pull-down maintenance transistor T42i, the ninth inverting transistor T54i, and the fifth pull-up control transistor T12i can be reduced, and the frame of the display panel 2 can be narrowed.

In some embodiments, as shown in FIG. 6 and FIG. 30 to FIG. 35, the second pull-down maintenance transistor T42i includes a third pull-down maintenance sub-transistor T42i1 and a fourth pull-down maintenance sub-transistor T42i2. A gate T42i2G of the fourth pull-down maintenance sub-transistor T42i2 is electrically connected to the second pull-down node Qb2[n], a first electrode T42i2S of the fourth pull-down maintenance sub-transistor T42i2 is electrically connected to the second low potential signal line VGL2, and a second electrode T42i2D of the fourth pull-down maintenance sub-transistor T42i2 is electrically connected to a first electrode T42i1S of the third pull-down maintenance sub-transistor T42i1 at the second internal node N2[n]. A gate of the third pull-down maintenance sub-transistor T42i1 is electrically connected to the second pull-down node QB2[n], and a second electrode of the third pull-down maintenance sub-transistor T42i1 is electrically connected to the second pull-up node Q2[n].

The third pull-down maintenance sub-transistor T42i1 and the fourth pull-down maintenance sub-transistor T42i2 are arranged in the second direction Y. By configuring the second pull-down maintenance transistor T42i to include the third pull-down maintenance sub-transistor T42i1 and the fourth pull-down maintenance sub-transistor T42i2, the performance of the second pull-down maintenance transistor T42i can be improved, and the third pull-down maintenance sub-transistor T42i1 and the fourth pull-down maintenance sub-transistor T42i2 are arranged in the second direction, so that a horizontal space occupied by the second pull-down maintenance transistor T42i can be reduced, and the frame of the display panel 2 can be narrowed.

In some embodiments, as shown in FIG. 6 and FIG. 30 to FIG. 35, the second reset module 327 includes a second reset transistor T43i. A gate T43iG of the second reset transistor T43i is electrically connected to the second reset control line VST2, a first electrode T43iS of the second reset transistor T43i is electrically connected to the second low potential signal line VGL2, and a second electrode T43iD of the second reset transistor T43i is electrically connected to the second pull-up node Q2[n].

In the second direction Y, the second reset transistor T43i is arranged on a side of the seventh inverting transistor T52i away from the sixth inverting transistor T51i. By arranging the second reset transistor T43i on the side of the seventh inverting transistor T52i away from the sixth inverting transistor T51i, a horizontal space occupied by the second reset transistor T43i and the second inverting module 325 is reduced, thereby narrowing the frame of the display panel 2, and and facilitating the second reset transistor T43i to be connected to the second reset control line VST2.

In some embodiments, as shown in FIG. 6 and FIG. 30 to FIG. 35, the second reset transistor T43i includes a third reset sub-transistor T43i1 and a fourth reset sub-transistor T43i2. A gate T43i1G of the fourth reset sub-transistor T43i2 is electrically connected to the second reset control line VST2, a first electrode of the fourth reset sub-transistor T43i2 is electrically connected to the second low potential signal line VGL2, and a second electrode T43i2D of the fourth reset sub-transistor T43i2 is electrically connected to a first electrode T43i1S of the third reset sub-transistor T43il at the second internal node N2[n]. A gate T43i1G of the third reset sub-transistor T43i1 is electrically connected to the second reset control line VST2, and a second electrode T43i1D of the third reset sub-transistor T43i1 is electrically connected to the second pull-up node Q2[n].

The third reset sub-transistor T43i1 and the fourth reset sub-transistor T43i2 are arranged in the second direction. By configuring the second reset transistor T43i to include the third reset sub-transistor T43i1 and the fourth reset sub-transistor T43i2, the performance of the second reset transistor T43i can be improved, and the third reset sub-transistor T43i1 and the fourth reset sub-transistor T43i2 are arranged in the second direction, so that a horizontal space occupied by the second reset transistor T43i can be reduced and the frame of the display panel 2 can be narrowed.

In some embodiments, as shown in FIG. 6 and FIG. 30 to FIG. 35, the second anti negative-bias module 326 includes a second anti negative-bias transistor T61i. A gate T61iG of the second anti negative-bias transistor T61i is electrically connected to the second pull-up node Q2[n], a first electrode T61iS of the second anti negative-bias transistor T61i is electrically connected to the first high potential signal line VGH1, and a second electrode T61iD of the second anti negative-bias transistor T61i is electrically connected to the second internal node N2 [n].

The second anti negative-bias transistor T61i is disposed between the seventh inverting transistor T52i and the sixth pull-up control transistor T81i in the second direction Y. By arranging the second anti negative-bias transistor T61i between the seventh inverting transistor T52i and the sixth pull-up control transistor T81i in the second direction Y, a horizontal area occupied by the second anti negative-bias module 326 can be reduced, and the frame of the display panel 2 can be narrowed.

In some embodiments, as shown in FIG. 6 and FIG. 30 to FIG. 35, the second anti negative-bias transistor T61i includes a third anti negative-bias sub-transistor T61i1 and a fourth anti negative-bias sub-transistor T61i2. A gate T61i2G of the fourth anti negative-bias sub-transistor T61i2 is electrically connected to the second pull-up node Q2[n], a first electrode T61i2S of the fourth anti negative-bias sub-transistor T61i2 is electrically connected to the first high potential signal line, and a second electrode T61i2D of the fourth anti negative-bias sub-transistor T61i2 is electrically connected to a first electrode of the third anti negative-bias sub-transistor T61i1. A gate T61i1G of the third anti negative-bias sub-transistor T61i1 is electrically connected to the second pull-up node Q2[n], and a second electrode T61i1D of the third anti negative-bias sub-transistor T61i1 is electrically connected to the second internal node N2[n].

The third anti negative-bias sub-transistor T61i1 and the fourth anti negative-bias sub-transistor T61i2 are arranged in the second direction. By configuring the second anti negative-bias transistor T61i to include the third anti negative-bias sub-transistor T61i1 and the fourth anti negative-bias sub-transistor T61i2, the performance of the second anti negative-bias transistor T61i can be improved, and the third anti negative-bias sub-transistor T61i1 and the fourth anti negative-bias sub-transistor T61i2 are arranged in the second direction, so that a horizontal space occupied by the second anti negative-bias transistor T61i can be reduced, and the frame of the display panel 2 can be narrowed.

In some embodiments, as shown in FIG. 6 and FIG. 30 to 35, the second pull-up module 322 includes a fourth pull-up transistor T21i. A gate T21iG of the fourth pull-up transistor T21i is electrically connected to the second pull-up node Q2[n], a first electrode T21iS of the fourth pull-up transistor T21i is electrically connected to the third clock signal line CKC, and a second electrode T21iD of the fourth pull-up transistor T21i is electrically connected to the second signal output terminal INI[n] of the current stage of second type gate driving circuit 22b.

The fourth pull-up transistor T21i and the tenth inverting transistor T55i are arranged in the first direction X.

In some embodiments, as shown in FIG. 6 and FIG. 30 to FIG. 35, the second type gate driving circuit 22b further includes a second capacitor C2. A plate of the second capacitor C2 is electrically connected to the second pull-up node Q2[n], and another plate of the second capacitor C2 is electrically connected to the second signal output terminal INI[n] of the current stage of second type gate driving circuit 22b.

Specifically, the second capacitor C2 includes a first plate C2a of the second capacitor C2 and a second plate C2b of the second capacitor C2. The first plate C2a of the second capacitor C2 includes a first portion C2a1 of the first plate C2a of the second capacitor C2 and a second portion C2a2 of the first plate C2a of the second capacitor C2.

In some embodiments, as shown in FIG. 30 and FIG. 31, the display panel 2 includes the light-shielding layer 212, and the light-shielding layer 212 includes a third shielding connection line LS3, the second signal output terminal INI[n] of the current stage of second type gate driving circuit 22b, and the first portion C2a1 of the first plate C2a of the second capacitor C2, which are sequentially arranged in the first direction X.

In some embodiments, as shown in Figures 30 and 32, the display panel 2 includes the active layer 216. The active layer 216 includes an active portion T11iA of the fourth pull-up control transistor T11i, an active portion T12iA of the fifth pull-up control transistor T12i, an active portion T81iA of the sixth pull-up control transistor T81i, an active portion T21iA of the fourth pull-up transistor T21i, an active portion T31iA of the fifth pull-down transistor T31i, an active portion T41iA of the sixth pull-down transistor T41i, an active portion T42iA of the second pull-down maintenance transistor T42i, an active portion T51iA of the sixth inverting transistor T51i, an active portion T52iA of the seventh inverting transistor T52i, an active portion T53iA of the eighth inverting transistor T53i, an active portion T54iA of the ninth inverting transistor T54i, an active portion T55iA of the tenth inverting transistor T55i, an active portion T43iA of the second reset transistor T43i, and an active portion T61iA of the second anti negative-bias transistor T61i.

The active portion T51iA of the sixth inverting transistor T51i, the active portion T52iA of the seventh inverting transistor T52i, the active portion T61iA of the second anti negative-bias transistor T61i, and the active portion T81iA of the sixth pull-up control transistor T81i are sequentially arranged in the second direction Y.

The active portion T51 iA of the sixth inverting transistor T51i, the active portion T52iA of the seventh inverting transistor T52i, and the active portion T43iA of the second reset transistor T43i are sequentially arranged in the second direction Y.

The active portion T53iA of the eighth inverting transistor T53i, the active portion T54iA of the ninth inverting transistor T54i, the active portion T42iA of the second pull-down maintenance transistor T42i, the active portion T12iA of the fifth pull-up control transistor T12i, and the active portion T11iA of the fourth pull-up control transistor T11i are sequentially arranged in the second direction Y.

The active portion T55iA of the tenth inverting transistor T55i, the active portion T31iA of the fifth pull-down transistor T31i, the active portion T41iA of the sixth pull-down transistor T41i, the active portion T12iA of the fifth pull-up control transistor T12i, and the active portion T11iA of the fourth pull-up control transistor T11i are sequentially arranged in the second direction.

The active portion T51iA of the sixth inverting transistor T51i, the active portion T53iA of the eighth inverting transistor T53i, the active portion T55iA of the tenth inverting transistor T55i, and the active portion T21iA of the fourth pull-up transistor T21i are arranged sequentially in the first direction X.

Specifically, as shown in FIG. 32, the active portion T81iA of the sixth pull-up control transistor T81i includes an active portion T81i1A of the third pull-up control sub-transistor T81i1 and an active portion T81 i2A of the fourth pull-up control sub-transistor T81i2. The active portion T81i1A of the third pull-up control sub-transistor T81i1 and the active portion T81i2A of the fourth pull-up control sub-transistor T81i2 are arranged sequentially in the second direction.

Specifically, as shown in FIG. 32, the active portion T41 iA of the sixth pull-down transistor T41i includes an active portion T41i1A of the third pull-down sub-transistor T41i1 and an active portion T41i2A of the fourth pull-down sub-transistor T41i2. The active portion T41i1A of the third pull-down sub-transistor T41i1 and the active portion T41 i2A of the fourth pull-down sub-transistor T41 i2 are arranged in the second direction.

Specifically, as shown in FIG. 32, the active portion T42iA of the second pull-down maintenance transistor T42i includes an active portion of the third pull-down maintenance sub-transistor T42i1 and an active portion T42i2A of the fourth pull-down maintenance sub-transistor T42i2. The active portion of the third pull-down maintenance sub-transistor T42i1 and the active portion T42i2A of the fourth pull-down maintenance sub-transistor T42i2 are arranged in the second direction.

Specifically, as shown in FIG. 32, the active portion T43iA of the second reset transistor T43i includes an active portion T43i1A of the third reset sub-transistor T43i1 and an active portion T43i1A of the fourth reset sub-transistor T43i2. The active portion T43i1A of the third reset sub-transistor T43i1 and the active portion T43i1A of the fourth reset sub-transistor T43i2 are arranged in the second direction.

Specifically, as shown in FIG. 32, the active portion T51iA of the sixth inverting transistor T51i includes an active portion T51i1A of the third inverting sub-transistor T51i1 and an active portion T51i2A of the fourth inverting sub-transistor T51i2. The active portion T51i1A of the third inverting sub-transistor T51i1 and the active portion T51i2A of the fourth inverting sub-transistor T51i2 are arranged in the first direction.

Specifically, as shown in FIG. 32, the active portion T61iA of the second anti negative-bias transistor T61i includes an active portion T61ilA of the third anti negative-bias sub-transistor T61il and an active portion T61i2A of the fourth anti negative-bias sub-transistor T61i2. The active portion T61i1A of the third anti negative-bias sub-transistor T61 i1 and the active portion T61 i2A of the fourth anti negative-bias sub-transistor T61i2 are arranged in the second direction.

In some embodiments, as shown in FIG. 30 and FIG. 33, the display panel 2 includes the gate layer 218. The gate layer 218 includes the gate T11iG of the fourth pull-up control transistor T11i, the gate T12iG of the fifth pull-up control transistor T12i, the gate T81iG of the sixth pull-up control transistor T81i, the gate T21 iG of the fourth pull-up transistor T21i, the gate T31iG of the fifth pull-down transistor T31i, the gate T41iG of the sixth pull-down transistor T41i, the gate T42iG of the second pull-down maintenance transistor T42i, the gate T51iG of the sixth inverting transistor T51i, the gate T52iG of the seventh inverting transistor T52i, the gate T53iG of the eighth inverting transistor T53i, the gate T54iG of the ninth inverting transistor T54i, the gate T55iG of the tenth inverting transistor T55i, the gate T43iG of the second reset transistor T43i, the gate T61iG of the second anti negative-bias transistor T61i, and the second plate C2b of the second capacitor C2.

The gate T81iG of the sixth inverting transistor T51i, the gate T52iG of the seventh inverting transistor T52i, the gate T61iG of the second anti negative-bias transistor T61i, and the gate T81iG of the sixth pull-up control transistor T81i are sequentially arranged in the second direction Y.

The gate T81iG of the sixth inverting transistor T51i, the gate T52iG of the seventh inverting transistor T52i, and the gate T43iG of the second reset transistor T43i are sequentially arranged in the second direction Y.

The gate T53iG of the eighth inverting transistor T53i, the gate T54iG of the ninth inverting transistor T54i, the gate T42iG of the second pull-down maintenance transistor T42i, the gate T12iG of the fifth pull-up control transistor T12i, and the gate T11iG of the fourth pull-up control transistor T11i are sequentially arranged in the second direction Y.

The gate T55iG of the tenth inverting transistor T55i, the gate T31iG of the fifth pull-down transistor T31i, the gate T41iG of the sixth pull-down transistor T41i, the gate T12iG of the fifth pull-up control transistor T12i, and the gate T11iG of the fourth pull-up control transistor T11i are sequentially arranged in the second direction.

The gate T11iG of the fourth pull-up transistor T11i and a part of a second plate C2b of the second capacitor C2 are sequentially arranged in the second direction Y.

The gate T81iG of the sixth inverting transistor T51i, the gate T53iG of the eighth inverting transistor T53i, the gate T55iG of the tenth inverting transistor T55i, the gate T21iG of the fourth pull-up transistor T21i, and another part of the second plate C2b of the second capacitor C2 are sequentially arranged in the first direction X.

Specifically, as shown in FIG. 33, the gate T81iG of the sixth pull-up control transistor T81i includes the gate T81i1G of the third pull-up control sub-transistor T81i1 and the gate T81i2G of the fourth pull-up control sub-transistor T81i2. The gate T81i1G of the third pull-up control sub-transistor T81i1 and the gate T81i2G of the fourth pull-up control sub-transistor T81i2 are sequentially arranged in the second direction.

Specifically, as shown in FIG. 33, the gate T41iG of the sixth pull-down transistor T41i includes the gate T41i1G of the third pull-down sub-transistor T41i1 and the gate T41i2G of the fourth pull-down sub-transistor T41i2. The gate T41i1G of the third pull-down sub-transistor T41i1 and the gate T41i2G of the fourth pull-down sub-transistor T41i2 are arranged in the second direction.

Specifically, as shown in FIG. 33, the gate T42iG of the second pull-down maintenance transistor T42i includes the gate of the third pull-down maintenance sub-transistor T42i1 and the gate T42i2G of the fourth pull-down maintenance sub-transistor T42i2. The gate of the third pull-down maintenance sub-transistor T42i1 and the gate T42i2G of the fourth pull-down maintenance sub-transistor T42i2 are arranged in the second direction.

Specifically, as shown in FIG. 33, the gate T43iG of the second reset transistor T43i includes the gate T43i1G of the third reset sub-transistor T43i1 and the gate T43i1G of the fourth reset sub-transistor T43i2. The gate T43i1G of the third reset sub-transistor T43i1 and the gate T43i1G of the fourth reset sub-transistor T43i2 are arranged in the second direction.

Specifically, as shown in FIG. 33, the gate T81iG of the sixth inverting transistor T51i includes the gate T51i1G of the third inverting sub-transistor TS1i1 and the gate TS1i2G of the fourth inverting sub-transistor T51i2. The gate TS1i1G of the third inverting sub-transistor T51i1 and the gate T51i2G of the fourth inverting sub-transistor T51i2 are arranged in the first direction.

Specifically, as shown in FIG. 33, the gate T61iG of the second anti negative-bias transistor T61i includes the gate T61i1G of the third anti negative-bias sub-transistor T61i1 and the gate T61i2G of the fourth anti negative-bias sub-transistor T61i2. The gate T61i1G of the third anti negative-bias sub-transistor T61i1 and the gate T61 i2G of the fourth anti negative-bias sub-transistor T61 i2 are arranged in the second direction.

In some embodiments, as shown in FIG. 30 and FIG. 34, the display panel 2 includes the first source and drain layer 221. The first source and drain layer 221 includes the first electrode T11iS of the fourth pull-up control transistor T11i, the first electrode T12iS of the fifth pull-up control transistor T12i, the first electrode T81iS of the sixth pull-up control transistor T51i, the first electrode T21iS of the fourth pull-up transistor T21i, the first electrode T31iS of the fifth pull-down transistor T31i, the first electrode T41iS of the sixth pull-down transistor T41i, the first electrode T42iS of the second pull-down maintenance transistor T42i, the first electrode T51iS of the sixth inverting transistor T51i, the first electrode T52iS of the seventh inverting transistor T52i, the first electrode T53iS of the eighth inverting transistor T53i, the first electrode T54iS of the ninth inverting transistor T54i, the first electrode T55iS of the tenth inverting transistor T55i, the first electrode T43iS of the second reset transistor T43i, the first electrode T61is of the second anti negative-bias transistor T61i, the second electrode T11 iD of the fourth pull-up control transistor T11i, the second electrode T12iD of the fifth pull-up control transistor T12i, the second electrode T81iD of the sixth pull-up control transistor T81i, the second electrode T21iD of the fourth pull-up transistor T21i, the second electrode T31iD of the fifth pull-down transistor T31i, the second electrode T41iD of the sixth pull-down transistor T41i, the second electrode T42iD of the second pull-down maintenance transistor T42i, the second electrode T51iD of the sixth inverting transistor T51i, the second electrode T52iD of the seventh inverting transistor T52i, the second electrode T53iD of the eighth inverting transistor T53i, the second electrode T54iD of the ninth inverting transistor T54i, the second electrode T55iD of the tenth inverting transistor T55i, the second electrode T43iD of the second reset transistor T43i, the second electrode T61iD of the second anti negative-bias transistor T61i, the second portion C2a2 of the first plate C2a of the second capacitor C2, a sixth source connection line LD6, a seventh source connection line LD7, and an eighth source connection line LD8.

The first electrode T51iS of the sixth inverting transistor T51i, the first electrode T52iS of the seventh inverting transistor T52i, the first electrode T61iS of the second anti negative-bias transistor T61i, and the first electrode T81iS of the sixth pull-up control transistor T81i are sequentially arranged in the second direction Y.

The first electrode T51iS of the described sixth inverting transistor T51i, the first electrode T52iS of the seventh inverting transistor T52i, and the first electrode T43iS of the second reset transistor T43i are sequentially arranged in the second direction Y.

The first electrode T53iS of the eighth inverting transistor T53i, the first electrode T54iS of the ninth inverting transistor T54i, the first electrode T42iS of the second pull-down maintenance transistor T42i, the first electrode T12iS of the fifth pull-up control transistor T12i, and the first electrode T11iS of the fourth pull-up control transistor T11i are sequentially arranged in the second direction Y.

The first electrode T55iS of the tenth inverting transistor T55i, the first electrode T31iS of the fifth pull-down transistor T31i, the first electrode T41iS of the sixth pull-down transistor T41i, the first electrode T12iS of the fifth pull-up control transistor T12i, and the first electrode T11iS of the fourth pull-up control transistor T11i are sequentially arranged in the second direction.

The first electrode T51iS of the sixth inverting transistor T51i, the first electrode T53iS of the eighth inverting transistor T53i, the first electrode T55iS of the tenth inverting transistor T55i, and the first electrode T21iS of the fourth pull-up transistor T21i are sequentially arranged in the first direction X.

A third shielding connection line LS3 connects the first electrode T41iS of the sixth pull-down transistor T41i and the first electrode T55iS of the tenth inverting transistor T55i. The seventh source connection line LD7 connects the gate T55iG of the tenth inverting transistor T55i and the second signal output terminal INI[n-2] of the second previous-stage of second type gate driving circuit 22b. The eighth source connection line LD8 connects the gate T41iG of the sixth pull-down transistor T41i and the second signal output terminal INI[n+2] of the second subsequent-stage of second type gate driving circuit 22b.

Specifically, in the circuit diagram in the embodiments of the present application, in order to explain the connection relationship of each transistor, each transistor includes a gate, a first electrode, and a second electrode. However, during the actual design process, to reduce the space occupied by the transistors, electrodes of some transistors may be formed using the same structure. For example, the first electrode of the third pull-up control sub-transistor T81i1 and the fourth electrode T81i2D of the second pull-up control sub-transistor T81i2 may be formed using the same structure. Therefore, in the diagram, only the second electrode T81i2D of the fourth pull-up control sub-transistor T81i2 is identified, and it is understandable that this structure also serves as the first electrode of the third pull-up control sub-transistor T81i1. Similarly, structures of the electrodes of other transistors can be determined.

Specifically, as shown in FIG. 30 to FIG. 35, the first portion C2a1 of the first plate C2a of the second capacitor C2 is connected to the second portion C2a2 of the first plate C2a of the second capacitor C2.

Specifically, as shown in FIG. 34, the first source and drain layer 221 includes the first electrode of the third pull-up control sub-transistor T81i1, the second electrode T81i1D of the third pull-up control sub-transistor T81i1, the first electrode T81i2S of the fourth pull-up control sub-transistor T81i2, and the second electrode T81i2D of the fourth pull-up control sub-transistor T81i2. The first electrode T81i2S of the fourth pull-up control sub-transistor T81i2, the second electrode T81i2D of the fourth pull-up control sub-transistor T81i2, and the second electrode T81i1D of the third pull-up control sub-transistor T81i1 are sequentially arranged in the second direction Y.

Specifically, as shown in FIG. 34, the first source and drain layer 221 includes the first electrode of the third pull-down sub-transistor T41i1, the second electrode T41i1D of the third pull-down sub-transistor T41i1, the first electrode T41i2S of the fourth pull-down sub-transistor T41 i2, and the second electrode T41i2D of the fourth pull-down sub-transistor T41i2. The first electrode T41i2S of the fourth pull-down sub-transistor T41i2, the second electrode T41i2D of the fourth pull-down sub-transistor T41i2, and the second electrode T41i1D of the third pull-down sub-transistor T41i1 are arranged sequentially in the second direction Y.

Specifically, as shown in FIG. 34, the first source and drain layer 221 includes the first electrode of the third pull-down maintenance sub-transistor T42i1, the second electrode T42i1D of the third pull-down maintenance sub-transistor T42i1, the first electrode T42i2S of the fourth pull-down maintenance sub-transistor T42i2, and the second electrode T42i2D of the fourth pull-down maintenance sub-transistor T42i1. The first electrode T42i2S of the fourth pull-down maintenance sub-transistor T42i2, the second electrode T42i2D of the fourth pull-down maintenance sub-transistor T42i1, and the second electrode T42i1D of the third pull-down maintenance sub-transistor T42i1 are arranged sequentially in the second direction Y.

Specifically, as shown in FIG. 34, the first source and drain layer 221 includes the first electrode of the third reset sub-transistor T43i1, the second electrode T43i1D of the third reset sub-transistor T43i1, the first electrode T43i2S of the fourth reset sub-transistor T43i2, and the second electrode T43i1D of the fourth reset sub-transistor T43i2. The first electrode T43i2S of the fourth reset sub-transistor T43i2, the second electrode T43i1D of the fourth reset sub-transistor T43i2, and the second electrode T43i1D of the third reset sub-transistor T43i1 are arranged sequentially in the second direction Y.

Specifically, as shown in FIG. 34, the first source and drain layer 221 includes the first electrode T51i1S of the third inverting sub-transistor T51i1, the second electrode T51i1D of the third inverting sub-transistor T51i1, the first electrode of the fourth inverting sub-transistor T51i2, and the second electrode T51i2D of the fourth inverting sub-transistor T51i2. The first electrode T51i1S of the third inverting sub-transistor T51i1, the second electrode T51i1D of the third inverting sub-transistor T51i1, and the second electrode T51i2D of the fourth inverting sub-transistor T51i1 are arranged sequentially in the first direction X.

Specifically, as shown in FIG. 34, the first source and drain layer 221 includes the first electrode of the third anti negative-bias sub-transistor T61i1, the second electrode T61i1D of the third anti negative-bias sub-transistor T61i1, the first electrode T61i2S of the fourth anti negative-bias sub-transistor T61i2, and the second electrode T61i2D of the fourth anti negative-bias sub-transistor T61i2. The first electrode T61i2S of the fourth anti negative-bias sub-transistor T61i2, the second electrode T61i2D of the fourth anti negative-bias sub-transistor T61i2, and the second electrode T61i1D of the third anti negative-bias sub-transistor T61i1 are arranged sequentially in the second direction Y.

In some embodiments, as shown in FIG. 30 and FIG. 35, the second clock signal line CKB includes the first group of sub-lines CKBi and the second group of sub-lines CKBj. The display panel 2 includes the second source and drain layer 223, and the second source and drain layer 223 includes the second reset control line VST2 and the second group of sub-lines CKBj sequentially arranged in the first direction X.

The second reset control line VST2 is connected to the gate T43iG of the second reset transistor T43i through the sixth source connection line LD6.

In some embodiments, as shown in FIG. 7, the third type gate driving circuit 22c includes a third pull-up control module 331, a third pull-up module 332, a third pull-down module 333, a third pull-down maintenance module 334, a third inverting module 335, and a third anti negative-bias module 336. The third pull-up control module 331 is electrically connected to the third pull-up module 332 at a third pull-up node Q3[n] of the third type gate driving circuit. The third pull-down module 333 is electrically connected to the third pull-up node Q3[n] and a third signal output terminal REF[n] of a current stage of third type gate driving circuit 22c. The third pull-down maintenance module 334 is electrically connected between the third pull-up node Q3[n] and the second low potential signal line VGL2 of the display panel. The third inverting module 335 is electrically connected to the third pull-up node Q3[n], the first high potential signal line VGH1 of the display panel, the second low potential signal line VGL2, a first signal output terminal Gn[n-1] of a first previous-stage of first type gate driving circuit 22a, a second signal output terminal INI[n] of the current stage of second type gate driving circuit 22b, and a second signal output terminal INI[n+1] of a first subsequent-stage of second type gate driving circuit 22b. The third anti negative-bias module 336 is electrically connected between the first high potential signal line VGH1 and the third pull-up node Q3[n].

In some embodiments, as shown in FIG. 7 and FIG. 36, at least two of the third pull-up control module 331, the third pull-up module 332, the third pull-down module 333, the third pull-down maintenance module 334, the third inverting module 335, and the third anti negative-bias module 336 are arranged in the second direction, and an included angle between the first direction and the second direction is greater than 0 degree and is less than or equal to 90 degrees. By arranging at least two of the third pull-up control module 331, the third pull-up module 332, the third pull-down module 333, the third pull-down maintenance module 334, the third inverting module 335, and the third anti negative-bias module 336 in the second direction, a horizontal space occupied by the third type gate driving circuit 22c can be reduced, thereby reducing the horizontal space occupied by the gate driving circuit 22 and narrowing the frame of the display panel 2.

Specifically, compared to an horizontal arrangement of various modules of the comparative display device, in the embodiments of the present application, at least two of the modules in the third type gate driving circuit 22c are arranged in the second direction, so that the horizontal space occupied by the third type gate driving circuit 22c can be reduced, the horizontal space occupied by the gate driving circuit 22 can be reduced, and the frame of the display panel 2 can be narrowed.

In some embodiments, as shown in FIG. 7 and FIG. 36, a part of the third inverting module 335 and the third pull-up control module 331 are arranged in the second direction Y. By arranging a part of the third inverting module 335 and the third pull-up control module 331 in the second direction, a horizontal space occupied by a part of the third inverting module 335 and a part of the third pull-up control module 331 can be reduced, the horizontal space occupied by the third type gate driving circuit 22c can be reduced, and the horizontal space occupied by the gate driving circuit 22 can be reduced, thereby narrowing the frame of the display panel 2.

Specifically, as shown in FIG. 36, it can be seen that a part of the third inverting module 335 is located upside the third pull-up control module 331 in the second direction.

In some embodiments, as shown in FIG. 7 and FIG. 36, another part of the third inverting module 335, the third pull-down maintenance module 334, and a part of the third pull-down module 333 are arranged in the second direction Y. By arranging another part of the third inverting module 335, the third pull-down maintenance module 334, and a part of the third pull-down module 333 in the second direction Y, a horizontal space occupied by anther part of the third inverting module 335, the third pull-down maintenance module 334, and the third pull-down module 333 can be reduced, the horizontal space occupied by the third type gate driving circuit 22c can be reduced, and the horizontal space occupied by the gate driving circuit 22 can be reduced, thereby narrowing the frame of the display panel 2.

Specifically, as shown in FIG. 36, it can be seen that in the second direction, another part of the third inverting module 335, the third pull-down maintenance module 334, and a part of the third pull-down module 333 are sequentially arranged in the second direction Y.

In some embodiments, as shown in FIG. 7 and FIG. 36, the third pull-up module 332 and the third anti negative-bias module 336 are arranged in the second direction Y;

The third inverting module 335, the third pull-up module 332, and another part of the third pull-down module 333 are arranged in the first direction X. By arranging the third pull-up module 332 and the third anti negative-bias module 336 in the second direction Y, a horizontal space occupied by the third pull-up module 332 and the third anti negative-bias module 336 can be reduced, the horizontal space occupied by the third type gate driving circuit 22c can be reduced, and the horizontal space occupied by the gate driving circuit 22 can be reduced, thereby narrowing the frame of the display panel 2.

Specifically, as shown in FIG. 36, it can be seen that the third pull-up module 332 is located upside the third anti negative-bias module 336 in the second direction.

In some embodiments, as shown in FIG. 7 and FIG. 36 to FIG. 41, the third inverting module 335 includes an eleventh inverting transistor T51r, a twelfth inverting transistor T52r, a thirteenth inverting transistor T53r, a fourteenth inverting transistor T54r, a fifteenth inverting transistor T55r, and a sixteenth inverting transistor T56r. A gate T51rG of the eleventh inverting transistor T51r and a first electrode T51rS of the eleventh inverting transistor T51r are electrically connected to the first signal output terminal Gn[n-1] of the first previous-stage of first type gate driving circuit 22a, and a second electrode T51rD of the eleventh inverting transistor T51r is electrically connected to a second electrode T52rD of the twelfth inverting transistor T52r. A gate T52rG of the twelfth inverting transistor T52r is electrically connected to the second signal output terminal INI[n] of the current stage of second type gate driving circuit 22b, and a first electrode T52rS of the twelfth inverting transistor T52r is electrically connected to the second low potential signal line VGL2. A gate T53rG of the thirteenth inverting transistor T53r is electrically connected to the second electrode T51rD of the eleventh inverting transistor T51r, and a first electrode T53rS of the thirteenth inverting transistor T53r is electrically connected to the first high potential signal line VGH1. A gate T54rG of the fourteenth inverting transistor T54r is electrically connected to the second electrode T51rD of the eleventh inverting transistor T51r, a first electrode T54rS of the fourteenth inverting transistor T54r is electrically connected to the first high potential signal line VGH1, and a second electrode T54rD is electrically connected to the third pull-down node QB3[n]. A gate T55rG of the fifteenth inverting transistor T55r is electrically connected to the third pull-up node Q3[n], a first electrode T55rS of the fifteenth inverting transistor T55r is electrically connected to the second low potential signal line VGL2, and a second electrode of the fifteenth inverting transistor T55r is electrically connected to the third pull-down node QB3[n]. A gate T56rG of the sixteenth inverting transistor T56r is electrically connected to the second signal output terminal INI[n+1] of the first subsequent-stage of second type gate driving circuit 22b, a first electrode T56rS of the sixteenth inverting transistor T56r is electrically connected to the second low potential signal line VGL2, and a second electrode T56rD of the sixteenth inverting transistor T56r is electrically connected to the third pull-down node QB3[n].

The eleventh inverting transistor T51r, the thirteenth inverting transistor T53r, and the twelfth inverting transistor T52r are arranged in the first direction. The eleventh inverting transistor T51r, the thirteenth inverting transistor T53r, and the fourteenth inverting transistor T54r are arranged in the second direction. The twelfth inverting transistor T52r, the sixteenth inverting transistor T56r, and the fifteenth inverting transistor T55r are arranged in the second direction Y. Therefore, a horizontal space occupied by the third inverting module 335 can be reduced, thereby narrowing the frame of the display panel 2.

In some embodiments, as shown in FIG. 7 and FIG. 36 to FIG. 41, the eleventh inverting transistor T51r includes a fifth inverting sub-transistor T51r1 and a sixth inverting sub-transistor T51r2. A gate T51r1G and a first electrode T51r1S of the fifth inverting sub-transistor T51r1 are electrically connected to the first signal output terminal Gn[n-1] of the first previous-stage of first type gate driving circuit 22a, and a second electrode T51r1D of the fifth inverting sub-transistor T51r1 is electrically connected to a first electrode of the sixth inverting sub-transistor T51r2. A gate T51r2G of the sixth inverting sub-transistor T51r2 is electrically connected to the first signal output terminal Gn[n-1] of the first previous-stage of first type gate driving circuit 22a, and a second electrode T51r2D of the sixth inverting sub-transistor T51r2 is electrically connected to the second electrode T52rD of the twelfth inverting transistor T52r.

The fifth inverting sub-transistor T51r1 and the sixth inverting sub-transistor T51r2 are arranged in the first direction. By configuring the eleventh inverting transistor T51r to include the fifth inverting sub-transistor T51r1 and the sixth inverting sub-transistor T51r2, the performance of the eleventh inverting transistor T51r can be improved.

In some embodiments, as shown in FIG. 7 and FIG. 36 to FIG. 41, the twelfth inverting transistor T52r includes a seventh inverting sub-transistor T52r1 and an eighth inverting sub-transistor T52r2. A gate T52r1G of the seventh inverting sub-transistor T52r1 and a first electrode T52r1S of the seventh inverting sub-transistor T52r1 are electrically connected to the second signal output terminal INI[n] of the current stage of second type gate driving circuit 22b, and a second electrode T52r1D of the seventh inverting sub-transistor T52r1 is electrically connected to a first electrode T52r2S of the eighth inverting sub-transistor T52r2. A gate T52r2G of the eighth inverting sub-transistor T52r2 is electrically connected to the second signal output terminal INI[n] of the current stage of second type gate driving circuit 22b, and a second electrode T52r2D of the eighth inverting sub-transistor T52r2 is electrically connected to the second electrode T51rD of the eleventh inverting transistor T51r.

The seventh inverting sub-transistor T52r1 and the eighth inverting sub-transistor T52r2 are arranged in the first direction X. By configuring the twelfth inverting transistor T52r to include the seventh inverting sub-transistor T52r1 and the eighth inverting sub-transistor T52r2, the performance of the twelfth inverting transistor T52r can be improved.

In some embodiments, as shown in FIG. 7 and FIG. 36 to FIG. 41, the third pull-up control module 331 includes a seventh pull-up control transistor T11r and an eighth pull-up control transistor T12r. A gate T11rG of the seventh pull-up control transistor T11r is electrically connected to the second signal output terminal INI[n+1] of the first previous-stage of second type gate driving circuit 22b, a first electrode T11rS of the seventh pull-up control transistor T11r is electrically connected to the first high potential signal line VGH1, and a second electrode T11rD of the seventh pull-up control transistor T11r is electrically connected to a first electrode T12rS of the eighth pull-up control transistor T12r. A gate T12rG of the eighth pull-up control transistor T12r is electrically connected to the second signal output terminal INI[n+1] of the first previous-stage of second type gate driving circuit 22b, and a second electrode T12rD of the eighth pull-up control transistor T12r is electrically connected to the third pull-up node Q3[n].

The fourteenth inverting transistor T54r, the eighth pull-up control transistor T12r, and the seventh pull-up control transistor T11r are arranged in the second direction Y. By arranging the fourteenth inverting transistor T54r, the eighth pull-up control transistor T12r, and the seventh pull-up control transistor T11r in the second direction Y, a horizontal space occupied by the third inverting module 335 and the third pull-up control module 331 can be reduced, and the frame of the display panel 2 can be narrowed.

In some embodiments, as shown in FIG. 7 and FIG. 36 to FIG. 41, the third pull-down module 333 includes a seventh pull-down transistor T31r and an eighth pull-down transistor T41r. A gate T31rG of the seventh pull-down transistor T31r is electrically connected to the third pull-down node Qb3[n], a first electrode T31rS of the seventh pull-down transistor T31r is electrically connected to the third low potential signal line VGL3 of the display panel, and a second electrode T31rD of the seventh pull-down transistor T31r is electrically connected to the third signal output terminal REF[n] of the current stage of third type gate driving circuit 22c. A gate T41rG of the eighth pull-down transistor T41r is electrically connected to the first signal output terminal of the first previous-stage of first type gate driving circuit 22a, a first electrode T41rS of the eighth pull-down transistor T41r is connected to the second low potential signal line VGL2, and a second electrode T41rD of the eighth pull-down transistor T41r is electrically connected to the third pull-up node Q3[n].

The eighth pull-down transistor T41r and the fifteenth inverting transistor T55r are arranged in the second direction Y. By arranging the eighth pull-down transistor T41r and the fifteenth inverting transistor T55r in the second direction Y, a space occupied by the third pull-down module 333 and the third inverting module 335 can be reduced, and the frame of the display panel 2 can be narrowed.

In some embodiments, as shown in FIG. 7 and FIG. 36 to FIG. 41, the eighth pull-down transistor T41r includes a fifth pull-down sub-transistor T41r1 and a sixth pull-down sub-transistor T41r2. A gate T41r1G of the fifth pull-down sub-transistor T41r1 is electrically connected to the first signal output terminal of the first previous-stage of first type gate driving circuit 22a, a first electrode T41r1S of the fifth pull-down sub-transistor T41r1 is electrically connected to the second low potential signal line VGL2, and a second electrode T41r1D of the fifth pull-down sub-transistor T41r1 is electrically connected to the first electrode of the sixth pull-down sub-transistor T41r2 at the third internal node N3[n] of the third type gate driving circuit. A gate T41r2G of the sixth pull-down sub-transistor T41r2 is electrically connected to the first signal output terminal of the first previous-stage of first type gate driving circuit 22a, and a second electrode T41r2D of the sixth pull-down sub-transistor T41r2 is electrically connected to the third pull-up node Q3[n].

The fifth pull-down sub-transistor T41r1 and the sixth pull-down sub-transistor T41r2 are arranged in the second direction. By configuring the eighth pull-down transistor T41r to include the fifth pull-down sub-transistor T41 r1 and the sixth pull-down sub-transistor T41r2, the performance of the eighth pull-down transistor T41r can be improved, and the fifth pull-down sub-transistor T41r1 and the sixth pull-down sub-transistor T41r2 are arranged in the second direction, so that a horizontal area occupied by the eighth pull-down transistor T41r can be reduced, and the frame of the display panel 2 can be narrowed.

In some embodiments, as shown in FIG. 7 and FIG. 36 to FIG. 41, the third pull-down maintenance module 334 includes a third pull-down maintenance transistor T42r. A gate T42rG of the third pull-down maintenance transistor T42r is electrically connected to the third pull-down node QB3 [n], a first electrode T42rS of the third pull-down maintenance transistor T42r is electrically connected to the second low potential signal line VGL2, and a second electrode T42rD of the third pull-down maintenance transistor T42r is electrically connected to the third pull-up node Q3[n].

In the second direction Y, the third pull-down maintenance transistor T42r is disposed between the fifteenth inverting transistor T55r and the eighth pull-down transistor T41r. Therefore, it is possible to reduce a horizontal space occupied by the third pull-down maintenance transistor T42r, the fifteenth inverting transistor T55r, and the eighth pull-down transistor T41r, and to narrow the frame of the display panel 2.

In some embodiments, as shown in FIG. 7 and FIG. 36 to FIG. 41, the third pull-down maintenance transistor T42r includes a fifth pull-down maintenance sub-transistor T42r1 and a sixth pull-down maintenance sub-transistor T42r2. A gate T42r2G of the sixth pull-down maintenance sub-transistor T42r2 is electrically connected to the third pull-down node Qb3[n], a first electrode T42r2S of the sixth pull-down maintenance sub-transistor T42r2 is electrically connected to the second low potential signal line VGL2, and a second electrode T42r2D of the sixth pull-down maintenance sub-transistor T42r2 is electrically connected to a first electrode T42r1S of the fifth pull-down maintenance sub-transistor T42r1 at the third internal node N3[n]. A gate T42r1G of the fifth pull-down maintenance sub-transistor T42r1 is electrically connected to the third pull-down node Qb3[n], and a second electrode T42r1D of the fifth pull-down maintenance sub-transistor T42r1 is electrically connected to the third pull-up node Q3[n].

The fifth pull-down maintenance sub-transistor T42r1 and the sixth pull-down maintenance sub-transistor T42r2 are arranged in the second direction. By configuring the third pull-down maintenance transistor T42r to include the fifth pull-down maintenance sub-transistor T42r1 and the sixth pull-down maintenance sub-transistor T42r2, the performance of the third pull-down maintenance transistor T42r can be improved, and the fifth pull-down maintenance sub-transistor T42r1 and the sixth pull-down maintenance sub-transistor T42r2 are arranged in the second direction, so that a horizontal space occupied by the third pull-down maintenance transistor T42r can be reduced, and the frame of the display panel 2 can be narrowed.

In some embodiments, as shown in FIG. 7 and FIG. 36 to FIG. 41, the third anti negative-bias module 336 includes a third anti negative-bias transistor T61r. A gate T61rG of the third anti negative-bias transistor T61r is electrically connected to the third pull-up node Q3[n], a first electrode T61rS of the third anti negative-bias transistor T61r is electrically connected to the first high potential signal line VGH1, and a second electrode T61rD of the third anti negative-bias transistor T61r is electrically connected to a third internal node N3[n].

The third anti negative-bias transistor T61r is arranged on a side of the eighth pull-down transistor T41r away from the seventh pull-up control transistor T11r in the first direction X.

In some embodiments, as shown in FIG. 7 and FIG. 36 to FIG. 41, the third anti negative-bias transistor T61r includes a fifth anti negative-bias sub-transistor T61r1 and a sixth anti negative-bias sub-transistor T61r2. A gate T61r2G of the sixth anti negative-bias sub-transistor T61r2 is electrically connected to the third pull-up node Q3[n], a first electrode T61r2S of the sixth anti negative-bias sub-transistor T61r2 is electrically connected to the first high potential signal line, and a second electrode T61r2D of the sixth anti negative-bias sub-transistor T61r2 is electrically connected to a first electrode of the fifth anti negative-bias sub-transistor T61r1. A gate T61r1G of the fifth anti negative-bias sub-transistor T61r1 is electrically connected to the third pull-up node Q3[n], and a second electrode T61r1D of the fifth anti negative-bias sub-transistor T61r1 is electrically connected to the third internal node N3[n].

The fifth anti negative-bias sub-transistor T61r1 and the sixth anti negative-bias sub-transistor T61r2 are arranged in the second direction. By configuring the third anti negative-bias transistor T61r to include the fifth anti negative-bias sub-transistor T61r1 and the sixth anti negative-bias sub-transistor T61r2, the performance of the third anti negative-bias transistor T61r can be improved, and the fifth anti negative-bias sub-transistor T61r1 and the sixth anti negative-bias sub-transistor T61r2 are arranged in the second direction, so that a horizontal space occupied by the third anti negative-bias transistor T61r can be reduced, and the frame of the display panel 2 can be narrowed.

In some embodiments, as shown in FIG. 7 and FIG. 36 to FIG. 41, the third pull-up module 332 includes a fifth pull-up transistor T21r. A gate T21rG of the fifth pull-up transistor T21r is electrically connected to the third pull-up node Q3[n], a first electrode T21rS of the fifth pull-up transistor T21r is electrically connected to the second high potential signal line VGH2 of the display panel, and a second electrode T21rD of the fifth pull-up transistor T21r is electrically connected to the third signal output terminal REF[n] of the current stage of third type gate driving circuit 22c.

The fifth pull-up transistor T21r and the third anti negative-bias transistor T61r are arranged in the second direction. Thus, a horizontal space occupied by the fifth pull-up transistor T21r and the third anti negative-bias transistor T61r can be reduced, and the frame of the display panel 2 can be narrowed.

In some embodiments, as shown in FIG. 7, the third type gate driving circuit 22c further includes a third capacitor C3. A plate of the third capacitor C3 is electrically connected to the third pull-up node Q3[n], and another plate of the third capacitor C3 is electrically connected to the third signal output terminal REF[n] of the current stage of third type gate driving circuit 22c.

Specifically, the third capacitor C3 includes a first plate C3a of the third capacitor C3 and a second plate C3b of the third capacitor C3, and the first plate C3a of the third capacitor C3 includes a first portion C3a1 of the first plate C3a of the third capacitor C3 and a second portion C3a2 of the first plate C3a of the third capacitor C3.

In some embodiments, as shown in FIG. 7, the third type gate driving circuit 22c further includes a fourth capacitor C4. A plate of the fourth capacitor C4 is electrically connected to the first high potential signal line VGH1, and another plate of the fourth capacitor C4 is electrically connected to the second electrode T51rD of the eleventh inverting transistor T51r.

Specifically, the fourth capacitor C4 includes a first plate C4a of the fourth capacitor C4 and a second plate C4b of the fourth capacitor C4.

In some embodiments, as shown in FIG. 36 and FIG. 37, the display panel 2 includes the light-shielding layer 212. The light-shielding layer 212 includes the first portion C3a1 of the first plate C3a of the third capacitor C3, a first portion C4a1 of the first plate C4a of the fourth capacitor C4, a fourth shielding connection line LS4, a fifth shielding connection line LS5, and the first signal output terminal Gn[n-1] of the first previous-stage of first type gate driving circuit 22a.

The first portion C4a1 of the first plate C4a of the fourth capacitor C4, the fourth shielding connection line LS4, the first signal output terminal Gn[n-1] of the first previous-stage of first type gate driving circuit 22a, and the first portion C3a1 of the first plate C3a of the third capacitor C3 are arranged in the first direction X. The fourth shielding connection line LS4 and the fifth shielding connection line LS5 are arranged in the second direction Y.

In some embodiments, as shown in FIG. 36 and FIG. 38, the display panel 2 includes the active layer 216. The active layer 216 includes an active portion T11rA of the seventh pull-up control transistor T11r, an active portion T12rA of the eighth pull-up control transistor T12r, an active portion T21rA of the fifth pull-up transistor T21r, an active portion T31rA of the seventh pull-down transistor T31r, an active portion T41rA of the eighth pull-down transistor T41r, an active portion T42rA of the third pull-down maintenance transistor T42r, an active portion T51rA of the eleventh inverting transistor T51r, an active portion T52rA of the twelfth inverting transistor T52r, an active portion T53rA of the thirteenth inverting transistor T53r, an active portion T54rA of the fourteenth inverting transistor T54r, an active portion T55rA of the fifteenth inverting transistor T55r, an active portion T56rA of the sixteenth inverting transistor T56r, and an active portion T61rA of the third anti negative-bias transistor T61r.

The active portion T51rA of the eleventh inverting transistor T51r, the active portion T53rA of the thirteenth inverting transistor T53r, the active portion T54rA of the fourteenth inverting transistor T54r, the active portion T11rA of the seventh pull-up control transistor T11r, and the active portion T12rA of the eighth pull-up control transistor T12r are arranged sequentially in the second direction Y.

The active portion T52rA of the twelfth inverting transistor T52r, the active portion T56rA of the sixteenth inverting transistor T56r, the active portion T55rA of the fifteenth inverting transistor T55r, the active portion T42rA of the third pull-down maintenance transistor T42r, and the active portion T41rA of the eighth pull-down transistor T41r are sequentially arranged in the second direction Y.

The active portion T21rA of the fifth pull-up transistor T21r and the active portion T61rA of the third anti negative-bias transistor T61r are sequentially arranged in the second direction Y.

The active portion T51rA of the eleventh inverting transistor T51r, the active portion T53rA of the thirteenth inverting transistor T53r, the active portion T52rA of the twelfth inverting transistor T52r, the active portion T21rA of the fifth pull-up transistor T21r, and the active portion T31rA of the seventh pull-down transistor T31r are sequentially arranged in the first direction X.

Specifically, as shown in FIG. 38, the active portion T41rA of the eighth pull-down transistor T41r includes the active portion T41r1A of the fifth pull-down sub-transistor T41r1 and the active portion T41r2A of the sixth pull-down sub-transistor T41r2. The active portion T41r1 A of the fifth pull-down sub-transistor T41 r1 and the active portion T41r2A of the sixth pull-down sub-transistor T41r2 are arranged in the second direction.

Specifically, as shown in FIG. 38, the active portion of the fifth pull-down maintenance transistor includes the active portion T42r1A of the fifth pull-down maintenance sub-transistor T42r1 and the active portion T42r2A of the sixth pull-down maintenance sub-transistor T42r2, and the active portion T42r1A of the fifth pull-down maintenance sub-transistor T42r1 and the active portion T42r2A of the sixth pull-down maintenance sub-transistor T42r2 are arranged in the second direction.

Specifically, as shown in FIG. 38, the active portion T51rA of the eleventh inverting transistor T51r includes the active portion T51r1A of the fifth inverting sub-transistor T51r1 and the active portion T51r2A of the sixth inverting sub-transistor T5 1r2, and the active portion T51r1A of the fifth inverting sub-transistor T51r1 and the active portion T51r2A of the sixth inverting sub-transistor T51r2 are arranged in the first direction.

Specifically, as shown in FIG. 38, the active portion T52rA of the twelfth inverting transistor T52r includes the active portion T52r1A of the seventh inverting sub-transistor T52r1 and the active portion T52r2A of the eighth inverting sub-transistor T52r2, and the active portion T52r1A of the seventh inverting sub-transistor T52r1 and the active portion T52r2A of the eighth inverting sub-transistor T52r2 are arranged in the first direction.

Specifically, as shown in FIG. 38, the active portion T61rA of the third anti negative-bias transistor T61r includes the active portion T61r1A of the fifth anti negative-bias sub-transistor T61r1 and the active portion T61r2A of the sixth anti negative-bias sub-transistor T61r2, and the active portion T61r1A of the fifth anti negative-bias sub-transistor T61r1 and the active portion T61r2A of the sixth anti negative-bias sub-transistor T61r2 are arranged in the second direction.

In some embodiments, as shown in FIG. 36 and FIG. 39, the display panel 2 includes the first gate layer 218. The first gate layer 218 includes the gate T11rG of the seventh pull-up control transistor T11r, the gate T12rG of the eighth pull-up control transistor T12r, the gate T21rG of the fifth pull-up transistor T21r, the gate T31rG of the seventh pull-down transistor T31r, the gate T41rG of the eighth pull-down transistor T41r, the gate T42rG of the third pull-down maintenance transistor T42r, the gate T51rG of the eleventh inverting transistor T51r, the gate T52rG of the twelfth inverting transistor T52r, the gate T53rG of the thirteenth inverting transistor T53r, the gate T54rG of the fourteenth inverting transistor T54r, the gate T55rG of the fifteenth inverting transistor T55r, the gate T56rG of the sixteenth inverting transistor T56r, the gate T61rG of the third anti negative-bias transistor T61r, the second plate C3b of the third capacitor C3, and the second plate C4b of the fourth capacitor C4.

The gate T51rG of the eleventh inverting transistor T51r, the gate T53rG of the thirteenth inverting transistor T53r are sequentially arranged in the second direction Y with the gate T54rG of the fourteenth inverting transistor T54r, the gate T11rG of the seventh pull-up control transistor T11r, and the gate T12rG of the eighth pull-up control transistor T12r.

The gate T52rG of the twelfth inverting transistor T52r, the gate T56rG of the sixteenth inverting transistor T56r, the gate T55rG of the fifteenth inverting transistor T55r, the gate T42rG of the third pull-down maintenance transistor T42r, and the gate T41rG of the eighth pull-down transistor T41r are sequentially arranged in the second direction Y.

The gate T21rG of the fifth pull-up transistor T21r, the gate T61rG of the third anti negative-bias transistor T61r, and a part of the second plate C3b of the third capacitor C3 are arranged sequentially in the second direction Y.

The gate T53rG of the thirteenth inverting transistor T53r and the second plate C4b of the fourth capacitor C4 are sequentially arranged in the second direction Y.

The gate T31rG of the seventh pull-down transistor T31r and a part of the second plate C3b of the third capacitor C3 are arranged sequentially in the second direction Y.

The gate T51rG of the eleventh inverting transistor T51r, the gate T53rG of the thirteenth inverting transistor T53r, the gate T52rG of the twelfth inverting transistor T52r, the gate T21rG of the fifth pull-up transistor T21r, and the gate T31rG of the seventh pull-down transistor T31r are arranged sequentially in the first direction X.

Specifically, as shown in FIG. 39, the gate T41rG of the eighth pull-down transistor T41r includes the gate T41r1G of the fifth pull-down sub-transistor T41r1 and the gate T41r2G of the sixth pull-down sub-transistor T41r2, and the gate T41r1G of the fifth pull-down sub-transistor T41r1 and the gate T41r2G of the sixth pull-down sub-transistor T41r2 are arranged in the second direction.

Specifically, as shown in FIG. 39, the gate of the fifth pull-down maintenance transistor includes the gate T42r1G of the fifth pull-down maintenance sub-transistor T42r1 and the gate T42r2G of the sixth pull-down maintenance sub-transistor T42r2, and the gate T42r1G of the fifth pull-down maintenance sub-transistor T42r1 and the gate T42r2G of the sixth pull-down maintenance sub-transistor T42r2 are arranged in the second direction.

Specifically, as shown in FIG. 39, the gate T51rG of the eleventh inverting transistor T51r includes the gate T51r1G of the fifth inverting sub-transistor T51r1 and the gate T51r2G of the sixth inverting sub-transistor T51r2, and the gate T51r1G of the fifth inverting sub-transistor T51r1 and the gate T51r2G of the sixth inverting sub-transistor T51r2 are arranged in the first direction.

Specifically, as shown in FIG. 39, the gate T52rG of the twelfth inverting transistor T52r includes the gate T52r1G of the seventh inverting sub-transistor T52r1 and the gate T52r2G of the eighth inverting sub-transistor T52r2, and the gate T52r1G of the seventh inverting sub-transistor T52r1 and the gate T52r2G of the eighth inverting sub-transistor T52r2 are arranged in the first direction.

Specifically, as shown in FIG. 39, the gate T61rG of the third anti negative-bias transistor T61r includes the gate T61r1G of the fifth anti negative-bias sub-transistor T61r1 and the gate T61r2G of the sixth anti negative-bias sub-transistor T61r2, and the gate T61r1G of the fifth anti negative-bias sub-transistor T61r1 and the gate T61r2G of the sixth anti negative-bias sub-transistor T61r2 are arranged in the first direction.

In some embodiments, as shown in FIG. 36 and FIG. 40, the display panel 2 includes the first source and drain layer 221. The first source and drain layer 221 includes the first electrode T11rS of the seventh pull-up control transistor T11r, the first electrode T12rS of the eighth pull-up control transistor T12r, the first electrode T21rS of the fifth pull-up transistor T21r, the first electrode T31rS of the seventh pull-down transistor T31r, the first electrode T41rS of the eighth pull-down transistor T41r, the first electrode T42rS of the third pull-down maintenance transistor T42r, the first electrode T51rS of the eleventh inverting transistor T51r, the first electrode T52rS of the twelfth inverting transistor T52r, the first electrode T53rS of the thirteenth inverting transistor T53r, the first electrode T54rS of the fourteenth inverting transistor T54r, the first electrode T55rS of the fifteenth inverting transistor T55r, the first electrode T56rS of the sixteenth inverting transistor T56r, the first electrode T61rS of the third anti negative-bias transistor T61r, the second electrode T11rD of the seventh pull-up control transistor T11r, the second electrode T12rD of the eighth pull-up control transistor T12r, the second electrode T21rD of the fifth pull-up transistor T21r, the second electrode T31rD of the seventh pull-down transistor T31r, the second electrode T41rD of the eighth pull-down transistor T41r, the second electrode T42rD of the third pull-down maintenance transistor T42r, the second electrode T51rD of the eleventh inverting transistor T51r, the second electrode TS2rD of the twelfth inverting transistor T52r, the second electrode T53rD of the thirteenth inverting transistor T53r, the second electrode T54rD of the fourteenth inverting transistor T54r, the second electrode T55rD of the fifteenth inverting transistor T55r, the second electrode T56rD of the sixteenth inverting transistor T56r, the second electrode T61rD of the third anti negative-bias transistor T61r, the second portion C3a2 of the first plate C3a of the third capacitor C3, the second portion C4a2 of the first plate C4a of the fourth capacitor C4, and a ninth source connection line LD9.

The first electrode T51rS of the eleventh inverting transistor T51r and the first electrode T53rS of the thirteenth inverting transistor T53r are sequentially arranged in the second direction Y with the first electrode T54rS of the fourteenth inverting transistor T54r, the first electrode T11rS of the seventh pull-up control transistor T11r, and the first electrode T12rS of the eighth pull-up control transistor T12r .

The first electrode T52rS of the twelfth inverting transistor T52r, the first electrode T56rS of the sixteenth inverting transistor T56r, the first electrode T55rS of the fifteenth inverting transistor T55r, the first electrode T42rS of the third pull-down maintenance transistor T42r, and the first electrode T41rS of the eighth pull-down transistor T41r are sequentially arranged in the second direction Y.

The first electrode T21rS of the fifth pull-up transistor T21r and the first electrode T61rS of the third anti negative-bias transistor T61r are sequentially arranged in the second direction Y.

The first electrode T51rS of the eleventh inverting transistor T51r, the first electrode T53rS of the thirteenth inverting transistor T53r, the first electrode T52rS of the twelfth inverting transistor T52r, the first electrode T21rS of the fifth pull-up transistor T21r, and the first electrode T31rS of the seventh pull-down transistor T31r are sequentially arranged in the first direction X.

The fourth shielding connection line LS4 connects the first electrode T41rS of the eighth pull-down transistor T41r and the first electrode T55rS of the fifteenth inverting transistor T55r. The fifth shielding connection line LSS connects the first electrode T11rS of the seventh pull-up control transistor T11r and the first electrode T61rS of the third anti negative-bias transistor T61r. The ninth source connection line LD9 connects the gate T41rG of the eighth pull-down transistor T41r and the first signal output terminal Gn[n-1] of the first previous-stage of first type gate driving circuit 22a.

Specifically, in the circuit diagram in the embodiments of the present application, in order to explain the connection relationship of each transistor, each transistor includes a gate, a first electrode, and a second electrode. However, during the actual design process, to reduce the space occupied by the transistors, electrodes of some transistors may be formed using the same structure, and it can be understood that this structure can be regarded as the electrodes of two transistors. Similarly, structures of the electrodes of other transistors can be determined.

Specifically, as shown in FIG. 36 to FIG. 41, the first portion C3a1 of the first plate C3a of the third capacitor C3 is connected to the second portion C3a2 of the first plate C3a of the third capacitor C3.

Specifically, as shown in FIGS. 36 to 41, a first portion C4a1 of the first plate C4a of the fourth capacitor C4 is connected to a second portion C4a2 of the first plate C4a of the fourth capacitor C4.

Specifically, as shown in FIG. 40, the first source and drain layer 221 includes the first electrode T41r1S of the fifth pull-down sub-transistor T41r1, the second electrode T41r1D of the fifth pull-down sub-transistor T41r1, the first electrode of the sixth pull-down sub-transistor T41r2, and the second electrode T41r2D of the sixth pull-down sub-transistor T41r2. The first electrode T41r1S of the fifth pull-down sub-transistor T41r1, the second electrode T41r1D of the fifth pull-down sub-transistor T41r1, and the second electrode T41r2D of the sixth pull-down sub-transistor T41r2 are arranged sequentially in the second direction.

Specifically, as shown in FIG. 40, the first source and drain layer 221 includes the first electrode of the fifth pull-down maintenance sub-transistor T42r1, the second electrode T42r1D of the fifth pull-down maintenance sub-transistor T42r1, the first electrode T42r2S of the sixth pull-down maintenance sub-transistor T42r2, and the second electrode T42r2D of the sixth pull-down maintenance sub-transistor T42r2. The first electrode T42r2S of the sixth pull-down maintenance sub-transistor T42r2, the second electrode T42r2D of the sixth pull-down maintenance sub-transistor T42r2, and the second electrode T42r1D of the fifth pull-down maintenance sub-transistor T42r1 are arranged sequentially in the second direction.

Specifically, as shown in FIG. 40, the first source and drain layer 221 includes the first electrode T51r1S of the fifth inverting sub-transistor T51r1, the second electrode T51r1D of the fifth inverting sub-transistor T51r1, the first electrode of the sixth inverting sub-transistor T51r2, and the second electrode T51r2D of the sixth inverting sub-transistor T51r2. The first electrode T51r1S of the fifth inverting sub-transistor T51r1, the second electrode T51r1D of the fifth inverting sub-transistor T51r1, and the second electrode T51r2D of the sixth inverting sub-transistor T51r2 are sequentially arranged in the first direction.

Specifically, as shown in FIG. 40, the first source and drain layer 221 includes the first electrode T52r1S of the seventh inverting sub-transistor T52r1, the second electrode T52r1D of the seventh inverting sub-transistor T52r1, the first electrode of the eighth inverting sub-transistor T52r2, and the second electrode T52r2D of the eighth inverting sub-transistor T52r2. The first electrode T52r1S of the seventh inverting sub-transistor T52r1, the second electrode T52r1D of the seventh inverting sub-transistor T52r1, and the second electrode T52r2D of the eighth inverting sub-transistor T52r2 are sequentially arranged in the first direction.

Specifically, as shown in FIG. 40, the first source and drain layer 221 includes the first electrode of the fifth anti negative-bias sub-transistor T61r1, the second electrode T61r1D of the fifth anti negative-bias sub-transistor T61r1, the first electrode T61r2S of the sixth anti negative-bias sub-transistor T61r2, and the second electrode T61r2D of the sixth anti negative-bias sub-transistor T61r2. The second electrode T61r1D of the fifth anti negative-bias sub-transistor T61r1, the second electrode T61r2D of the sixth anti negative-bias sub-transistor T61r2, and the first electrode T61r2S of the sixth anti negative-bias sub-transistor T61r2 are sequentially arranged in the second direction.

In some embodiments, as shown in FIG. 36 and FIG. 41, the display panel 2 includes the second source and drain layer 223. The second source and drain layer 223 includes the first high potential signal line VGH1, the third clock signal line CKC, the second high potential signal line VGH2, and the third low potential signal line VGL3, which are sequentially arranged in the first direction X.

Specifically, signals output by the first low potential signal line VGL 1, the second low potential signal line VGL2, and the third low potential signal line VGL 3 may be different.

Specifically, signals output by the first high potential signal line VGH1 and the second high potential signal line VGH2 may be different.

Specifically, in the embodiments of the present application, the first signal output terminal Gn[m] of another stage of first type gate driving circuit 22a may be a first signal output terminal of one of subsequent stages of the first type gate driving circuits 22a. For example, the first signal output terminal Gn[m] of another stage of first type gate driving circuit 22a may be a first signal output terminal of a first subsequent-stage of first type gate driving circuit 22a, taking that n is 3 as an example, m may be 4. The embodiments of the present application are not limited thereto, and the first signal output terminal Gn[m] of another stage of first type gate driving circuit 22a may be a first signal output terminal of a second subsequent-stage of first type gate driving circuit 22a or a first signal output terminal of one of other stages of the first type gate driving circuits 22a.

Specifically, in the above-described embodiments, that some transistors each includes two subtransistors is taken as an example, but the embodiments of the present application are not limited thereto, and each transistor may include only one sub-transistor.

Specifically, as shown in FIG. 4, FIG. 4 provides the pixel driving circuit 21 of the display panel 2. The pixel driving circuit 21 includes a driving transistor T1, a switching transistor T2, a reset transistor T3, and an initialization transistor T4. The driving transistor T1, the switching transistor T2, and the reset transistor T3 are connected to a first pixel node g, and the driving transistor T1 and the initialization transistor T4 are connected to a second pixel node s.

A gate of the switching transistor T2 is electrically connected to the first signal output terminal Gn[n] of the current stage of first type gate driving circuit 22a. A gate of the initialization transistor T4 is electrically connected to the second signal output terminal INI[n] of the current stage of second type gate driving circuit 22b. A gate of the reset transistor T3 is electrically connected to the third signal output terminal REF[n] of the current stage of third type gate driving circuit 22c. By electrically connecting the gate of the switching transistor, the gate of the initialization transistor, and the gate of the reset transistor to the first signal output terminal Gn[n] of the current stage of first type gate driving circuit 22a, the second signal output terminal INI[n] of the current stage of second type gate driving circuit 22b, and the third signal output terminal REF[n] of the current stage of third type gate driving circuit 22c, respectively, a signal can be input to the pixel driving circuit 21 through the gate driving circuit 22, and the pixel driving circuit 21 can be normally operated.

Specifically, as shown in FIG. 2, the display panel 2 further includes light-emitting devices LED. A gate of the driving transistor T1 is connected to the first node g, a first electrode of the driving transistor T1 is connected to a high potential power supply line VDD, and a second electrode of the driving transistor T1 is connected to the second node s. A first electrode of the switching transistor T2 is connected to a data line Vdata, and a second electrode of the switching transistor T2 is connected to the first node g. A first electrode of the reset transistor T3 is connected to a reference line Vref, and a second electrode of the reset transistor T3 is connected to the first node g. A first electrode of the initialization transistor T4 is connected to an initialization signal line Vini, and a second electrode of the initialization transistor T4 is connected to a positive electrode of the light-emitting device LED, and a negative electrode of the light-emitting device LED is connected to a low potential power supply line VSS.

Specifically, it can be understood that the display panel 2 includes a plurality of rows of subpixels. Correspondingly, a plurality of rows of pixel driving circuits 21 are provided to drive each sub-pixel. Correspondingly, multistage gate driving circuits 22 are provided, and each stage of gate driving circuit 22 may be connected to the corresponding one or two rows of pixel driving circuits 21.

Specifically, a type of each transistor in the gate driving circuits 22 in the embodiments of the present application may be an N-type transistor or a P-type transistor. The type of each transistor in the pixel driving circuits 21 in the embodiments of the present application may be an N-type transistor or a P-type transistor.

Specifically, the active portion of each transistor in the gate driving circuits 22 according to the embodiments of the present application may be formed by the active layer 216. The active portion of each transistor in the pixel driving circuits 21 according to the embodiments of the present application may be formed by the semiconductor layer 214, or may be formed partially by the semiconductor layer 214 and partially by the active layer 216.

Specifically, the first electrode may be a source and the second electrode may be a drain; or the first electrode is the drain and the second electrode is the source.

Specifically, the above-described embodiments have described the display panel 2 in detail from the aspects of circuit, timing, transistor design, and the like of the display panel 2, and it is understood that when there is no conflict between the embodiments, the embodiments may be combined. For example, the first reset control line is arranged in the second source and drain layer and the low frequency signal line is arranged in the second source and drain layer.

At the same time, embodiments of the present application provide a display device. The display device includes the display panel as described in any of the above embodiments.

In the description of embodiments of the present application, the terms "first" and "second" are for descriptive purposes only, and cannot be understood as indicating or implying relative importance or implicitly indicating the number of technical features indicated. Thus, a feature defined as "first" or "second" may explicitly or implicitly include one or more of the features. In the description of the present application, "plurality" means two or more, unless expressly and specifically defined otherwise.

In the above mentioned embodiments, the description of each embodiment has its own emphasis, and parts not described in detail in a certain embodiment may be referred to the related description of other embodiments.

The embodiments, implementations and related technical features of the present application can be combined and replaced with each other without conflict.

The above embodiments are merely preferred embodiments of the present application, and do not limit the present application in any form, but any simple modifications, equivalent changes, and modifications made to the above embodiments according to the technical essence of the present application without departing from the technical proposals of the present application still fall within the scope of the technical proposals of the present application.

## Claims

1. A display panel (2), comprising:
a plurality of rows of pixels (23), wherein the pixels (23) comprise light-emitting devices (LED) and pixel driving circuits (21); and
multistage gate driving circuits (22) electrically connected to corresponding ones of the pixel driving circuits (21), respectively, wherein each stage of gate driving circuit (22) comprises a first type gate driving circuit (22a), a second type gate driving circuit (22b), and a third type gate driving circuit (22c) disposed in a first direction (X): the first type gate driving circuit (22a) is electrically connected to at least a first clock signal line (CKA), a second clock signal line (CKB), a first high potential signal line (VGH1), a first low potential signal line (VGL1), a second low potential signal line (VGL2), a first reset control line (VST1), and a low frequency signal line (LC); the second type gate driving circuit (22b) is electrically connected to at least the first high potential signal line (VGH1), the second low potential signal line (VGL2), a third clock signal line (CKC) of the display panel (2), and a second reset control line (VST2) of the display panel (2); the third type gate driving circuit (22c) is electrically connected to at least the first high potential signal line (VGH1), a second high potential signal line (VGH2), the second low potential signal line (VGL2), and a third low potential signal line (VGL3);
the display panel (2) further comprises a substrate (211), an active layer (216), a first gate layer (218), a first source and drain layer (221), and a second source and drain layer (223) arranged sequentially; and at least one of the first clock signal line (CKA), the second clock signal line (CKB), the third clock signal line (CKC), the first high potential signal line (VGH1), the second high potential signal line (VGH2), the first low potential signal line (VGL1), the second low potential signal line (VGL2), the third low potential signal line (VGL3), the first reset control line (VST1), the second reset control line (VST2), and the low frequency signal line (LC) is arranged in the second source and drain layer (223).

2. The display panel (2) according to claim 1, wherein at least one of the first reset control line (VST1), the low frequency signal line (LC), the first clock signal line (CKA), the second clock signal line (CKB), the first low potential signal line (VGL1), and the second low potential signal line (VGL2) is arranged in the second source and drain layer (223);
wherein the first reset control line (VST1) is provided in the second source and drain layer (223);
the first type gate driving circuit (22a) comprises a first reset module (317), and the first reset module (317) is electrically connected to the first reset control line (VST1);
the first source and drain layer (221) comprises a first source connection line (LD1), a projection of the first reset control line (VST1) on the substrate (211) and a projection of the first reset module (317) on the substrate (211) are spaced apart, and the first reset control line (VST1) is connected to the first reset module (317) through the first source connection line (LD1).

3. The display panel (2) according to claim 1, wherein at least one of the first reset control line (VST1), the low frequency signal line (LC), the first clock signal line (CKA), the second clock signal line (CKB), the first low potential signal line (VGL1), and the second low potential signal line (VGL2) is arranged in the second source and drain layer (223);
wherein the low frequency signal line (LC) is arranged in the second source and drain layer (223);
the first type gate driving circuit (22a) comprises a first inverting module (315), the low frequency signal line (LC) is electrically connected to the first inverting module (315), and a projection of the low frequency signal line (LC) on the substrate (211) overlaps with a projection of the first inverting module (315) on the substrate (211).

4. The display panel (2) according to claim 1, wherein at least one of the first reset control line (VST1), the low frequency signal line (LC), the first clock signal line (CKA), the second clock signal line (CKB), the first low potential signal line (VGL1), and the second low potential signal line (VGL2) is arranged in the second source and drain layer (223);
wherein the first clock signal line (CKA) is arranged in the second source and drain layer (223);
the first type gate driving circuit (22a) comprises a first pull-up control module (311), and a projection of the first clock signal line (CKA) on the substrate (211) overlaps with a projection of the first pull-up control module (311) on the substrate (211).

5. The display panel (2) according to claim 1, wherein at least one of the first reset control line (VST1), the low frequency signal line (LC), the first clock signal line (CKA), the second clock signal line (CKB), the first low potential signal line (VGL1), and the second low potential signal line (VGL2) is arranged in the second source and drain layer (223);
wherein the second clock signal line (CKB) is arranged in the second source and drain layer (223);
the first type gate driving circuit (22a) comprises a first pull-up module (312), and a projection of the second clock signal line (CKB) on the substrate (211) overlaps with a projection of the first pull-up module (312) on the substrate (211).

6. The display panel (2) according to claim 1, wherein at least one of the first reset control line (VST1), the low frequency signal line (LC), the first clock signal line (CKA), the second clock signal line (CKB), the first low potential signal line (VGL1), and the second low potential signal line (VGL2) is arranged in the second source and drain layer (223);
wherein the first low potential signal line (VGL1) is arranged in the second source and drain layer (223);
the first type gate driving circuit (22a) comprises a first inverting module (315) and a first pull-up module (312), the first inverting module (315) and the first pull-up module (312) are electrically connected to a first pull-up node (Q1[n]), and a projection of the first low potential signal line (VGL1) on the substrate (211) is located between a projection of the first inverting module (315) on the substrate (211) and a projection of the first pull-up module (312) on the substrate (211).

7. The display panel (2) according to claim 1, wherein at least one of the first reset control line (VST1), the low frequency signal line (LC), the first clock signal line (CKA), the second clock signal line (CKB), the first low potential signal line (VGL1), and the second low potential signal line (VGL2) is arranged in the second source and drain layer (223);
wherein the second low potential signal line (VGL2) is arranged in the second source and drain layer (223);
the first type gate driving circuit (22a) comprises a first pull-up module (312), and a projection of the second low potential signal line (VGL2) on the substrate (211) overlaps with a projection of the first pull-up module (312) on the substrate (211).

8. The display panel (2) according to claim 1, wherein the second reset control line (VST2) is arranged in the second source and drain layer (223);
the second type gate driving circuit (22b) comprises a second reset module (327), the second reset module (327) is electrically connected to the second reset control line (VST2), a projection of the second reset control line (VST2) on the substrate (211) is located between a projection of the first type gate driving circuit (22a) on the substrate (211) and a projection of the second reset module (327) on the substrate (211).

9. The display panel (2) according to claim 1, wherein at least one of the third clock signal line (CKC), the first high potential signal line (VGH1), the second high potential signal line (VGH2), and the third low potential signal line (VGL3) is arranged in the second source and drain layer (223).

10. The display panel (2) according to claim 9, wherein the first high potential signal line (VGH1) is arranged in the second source and drain layer (223);
the third type gate driving circuit (22c) comprises a third pull-up control module (331), and a projection of the first high potential signal line (VGH1) on the substrate (211) overlaps with a projection of the third pull-up control module (331) on the substrate (211).

11. The display panel (2) according to claim 9, wherein the third clock signal line (CKC) is arranged in the second source and drain layer (223);
the third type gate driving circuit (22c) comprises a third pull-up control module (331), and a projection of the third clock signal line (CKC) on the substrate (211) overlaps with a projection of the third pull-up control module (331) on the substrate (211).

12. The display panel (2) according to claim 9, wherein the second high potential signal line (VGH2) is arranged in the second source and drain layer (223);
the third type gate driving circuit (22c) comprises a third pull-up module (332), the third pull-up module (332) is electrically connected to the second high potential signal line (VGH2), and a projection of the second high potential signal line (VGH2) on the substrate (211) overlaps with a projection of the third pull-up module (332) on the substrate (211).

13. The display panel (2) according to claim 9, wherein the third low potential signal line (VGL3) is arranged in the second source and drain layer (223);
the third type gate driving circuit (22c) comprises a third pull-down module (333), the third pull-down module (333) is electrically connected to the third low potential signal line (VGL3), and a projection of the third low potential signal line (VGL3) on the substrate (211) overlaps with a projection of the third pull-down module (333) on the substrate (211).

14. The display panel (2) according to any one of claim 1 to claim 13, wherein the gate driving circuits (22) comprise a plurality of transistors, the pixel driving circuits (21) comprise a plurality of transistors, and a mobility of at least one of the transistors of the gate driving circuits (22) is greater than a mobility of each of the transistors of the pixel driving circuits (21).

15. A display device, comprising a display panel (2) of any one of claim 1 to claim 14.
